# EUROPEAN PATENT APPLICATION

(11) **EP 4 531 384 A1**
(43) Date of publication of application: **02.04.2025**
(21) Application number: 23862382.1
(22) Date of filing: 05.09.2023
(51) Int. Cl.: H04M 1/02

(54) **FOLDING ASSEMBLY AND ELECTRONIC APPARATUS**

(30) Priority: 06.09.2022 CN 202211096853; 31.01.2023 CN 202310117311
(71) Applicant: Huawei Technologies Co., Ltd., Shenzhen, Guangdong 518129 (CN)
(72) Inventor: LIAO, Changliang, Shenzhen, Guangdong 518129 (CN); XU, Zhengyi, Shenzhen, Guangdong 518129 (CN); WANG, Gangchao, Shenzhen, Guangdong 518129 (CN)
(74) Representative: MERH-IP Matias Erny Reichl Hoffmann Patentanwälte PartG mbB
(86) International application number: PCT/CN2023/117004
(87) International publication number: WO 2024/051688

(57) **Abstract**

A foldable assembly (3) and an electronic device (100) are provided. The electronic device (100) includes a foldable apparatus (10) and a flexible display (20). The flexible display (20) is mounted on the foldable apparatus (10), and the foldable apparatus (10) includes a first housing (1), a second housing (2), and the foldable assembly (3) connected between the first housing (1) and the second housing (2). The foldable assembly (3) includes a main shaft (31), a rotation arm (321), a mounting bracket (322), a first connection arm (323), and a second connection arm (324). The first housing (1) is rotatably connected to the main shaft (31) via the rotation arm (321), the mounting bracket (322) is fastened to the second housing (2), and the mounting bracket (322) is movably connected to the main shaft (31) via the first connection arm (323) and the second connection arm (324). The foldable assembly (3) has a small quantity of parts, simple composition, and low costs.

## Description

This application claims priority to Chinese Patent Application No. 202211096853.0, filed with the China National Intellectual Property Administration on September 6, 2022 and entitled "FOLDABLE ASSEMBLY AND ELECTRONIC DEVICE", which is incorporated herein by reference in its entirety. This application claims priority to Chinese Patent Application No. 202310117311.5, filed with the China National Intellectual Property Administration on January 31, 2023 and entitled "FOLDABLE ASSEMBLY AND ELECTRONIC DEVICE", which is incorporated herein by reference in its entirety.

### TECHNICAL FIELD

This application relates to the technical field of foldable electronic products, and in particular, to a foldable assembly and an electronic device.

### BACKGROUND

In recent years, flexible displays are widely used in various foldable electronic devices because of characteristics such as lightness, thinness, and non-fragileness. The foldable electronic device further includes a foldable apparatus configured to bear the flexible display. The foldable apparatus generally includes two housings and a foldable assembly connected between the two housings. The two housings are folded relative to each other or unfolded relative to each other through deformation of the foldable assembly, and drive the flexible display to be folded or unfolded. However, the current foldable assembly usually has a large quantity of parts and complex composition, resulting in high costs.

### SUMMARY

This application provides a foldable assembly and an electronic device. The foldable assembly has a small quantity of parts, simple composition, and low costs.

According to a first aspect, an embodiment of this application provides an electronic device. The electronic device includes a foldable apparatus and a flexible display. The foldable apparatus includes a first housing, a second housing, and a foldable assembly, and the foldable assembly is connected to the first housing and the second housing. A part that is of the flexible display and that corresponds to the first housing is fastened to the first housing, and a part that is of the flexible display and that corresponds to the second housing is fastened to the second housing. In a process in which the first housing and the second housing are unfolded relative to each other or folded relative to each other, a part that is of the flexible display and that corresponds to the foldable assembly deforms. The foldable assembly includes a main shaft, a mounting bracket, a rotation arm, a first connection arm, and a second connection arm. A first end of the rotation arm is rotatably connected to the main shaft, and a second end of the rotation arm is fastened to the first housing. The mounting bracket is fastened to the second housing. A first end of the first connection arm is rotatably connected to the main shaft, and a second end of the first connection arm is slidably connected to the mounting bracket. A first end of the second connection arm is rotatably connected to the main shaft, a rotation center of the first end of the second connection arm does not coincide with a rotation center of the first end of the first connection arm, and a second end of the second connection arm is slidably connected or rotatably connected to the mounting bracket.

In this embodiment of this application, the foldable assembly of the foldable apparatus is of an asymmetric structure. The first housing is rotatably connected to the main shaft via the rotation arm, and the second housing is movably connected to the main shaft via the first connection arm, the second connection arm, and the mounting bracket, to implement relative movement between the first housing and the second housing. The foldable assembly has a small quantity of parts, simple composition, and low costs.

In addition, through cooperation of a double-link-sliding block mechanism or cooperation between a link-sliding block mechanism and a link mechanism, connection between the second housing and the main shaft can be implemented, and the second housing can move relative to the main shaft. A quantity of components is small, a cooperation relationship and a cooperation position are simple, and the components are easy to manufacture and assemble. This facilitates mass production, to reduce costs of the foldable apparatus. In addition, because the main shaft links the mounting bracket via the first connection arm and the second connection arm, a movement path of the second housing is accurate. This helps implement accurate control of a movement form of the foldable apparatus. In addition, the foldable apparatus has a good mechanism tensile resistance capability and a good mechanism extrusion resistance capability.

In addition, the first housing is rotatably connected to the main shaft via the rotation arm. After the first housing rotates relative to the main shaft to a folded state, no concave space used to accommodate the flexible display is reserved at a joint between the first housing and the main shaft. The second housing is connected to the main shaft via the first connection arm and the second connection arm, for example, connected to the main shaft via the double-link-sliding block mechanism or a cooperation mechanism of the link-sliding block mechanism and the link mechanism. After the second housing rotates relative to the main shaft to the folded state, a concave space used to accommodate the flexible display is reserved at a joint between the second housing and the main shaft. Therefore, when the first housing and the second housing are folded relative to each other to the folded state, an accommodation space offset toward the second housing is formed between the first housing and the second housing and inside the foldable assembly. Based on a shape of the accommodation space offset toward one side, compared with a symmetric space of the conventional foldable electronic device, the accommodation space can reduce bending positions of a part of the flexible display accommodated in the accommodation space. This helps reduce a risk of damaging the flexible display, improves reliability of the flexible display, and prolongs a service life of the flexible display.

In some possible implementations, the foldable assembly further includes a synchronization assembly, and the synchronization assembly is engaged with the first end of the rotation arm and the first end of the first connection arm. In this embodiment of this application, a rotation action of the rotation arm relative to the main shaft and a rotation action of the first connection arm relative to the main shaft are synchronized via the synchronization assembly, to improve mechanism operation experience of a user.

In some possible implementations, the first end of the rotation arm is provided with a connection gear, the synchronization assembly includes a first synchronization gear and a second synchronization gear, and the first synchronization gear is engaged with the connection gear. In a thickness direction of the main shaft, the first synchronization gear is located on a side that is of the connection gear and that is opposite to the flexible display, and the second synchronization gear is engaged with the first synchronization gear and the first end of the first connection arm.

In this embodiment of this application, a thickness space of the main shaft can be fully used through top-bottom arrangement of the connection gear and the first synchronization gear, and the first synchronization gear and the connection gear reuse a part of a width space of the main shaft. This helps reduce a width size of the main shaft, and miniaturize the main shaft.

A pitch diameter of the second synchronization gear may be different from a pitch diameter of the first synchronization gear, to better adapt to a position of the first synchronization gear and a position of the first end of the first connection arm, and realize engaging transmission. In addition, the second synchronization gear is an incomplete gear, and a tooth part position and a toothless area position of the second synchronization gear may be adjusted, to reduce a movement space requirement of the second synchronization gear during movement as much as possible while ensuring that an engaging connection requirement is implemented, so as to reduce a space requirement for the main shaft, for example, a space requirement for the thickness direction of the main shaft. This facilitates thinning of the main shaft.

In some possible implementations, the connection gear is an incomplete gear, and the connection gear includes a support surface and a tooth part that are disposed opposite to each other. When the first housing and the second housing are unfolded relative to each other to an unfolded state, the tooth part of the connection gear faces the first synchronization gear and is located in the main shaft, and the support surface of the connection gear is flush with a support surface of the main shaft. In this case, the connection gear and the main shaft can be jointly configured to support the flexible display, to improve integrity and flatness of a support environment of the flexible display. In addition, the connection gear is an incomplete gear, so that a volume of the connection gear is reduced when a connection relationship is met. This helps reduce the thickness of the main shaft configured to mount the connection gear, and facilitate thinning of the main shaft.

When the first housing and the second housing are folded relative to each other to the folded state, the connection gear rotates relative to the main shaft, a part of the tooth part of the connection gear rotates out of the main shaft, and the support surface of the connection gear faces the flexible display. In this case, the connection gear may move by using a space above the main shaft, so that the main shaft reserves only a partial space used to allow the connection gear to move. This helps reduce the thickness of the main shaft, and miniaturize the main shaft.

In some possible implementations, in a width direction of the main shaft, a rotation center of the first synchronization gear is away from the second synchronization gear relative to a rotation center of the connection gear, and the width direction of the main shaft is perpendicular to the thickness direction of the main shaft and is perpendicular to an extension direction of the main shaft. In this embodiment of this application, positions of the rotation center of the first synchronization gear and the rotation center of the connection gear are set, so that the first synchronization gear and the connection gear are always in an engaged state. This avoids idle rotation, to improve mechanism reliability of the foldable apparatus.

In some possible implementations, the first end of the rotation arm is further provided with an arc-shaped arm. The arc-shaped arm is fastened to a side of the connection gear, and a central axis of the arc-shaped arm is collinear with a central axis of the connection gear. The arc-shaped arm is mounted in an arc-shaped groove of the main shaft, to rotatably connect the main shaft. In this embodiment of this application, the arc-shaped arm at the first end of the rotation arm cooperates with the arc-shaped groove of the main shaft, so that the first end of the rotation arm is rotatably connected to the main shaft through a virtual shaft.

In some possible implementations, the rotation center of the first end of the second connection arm is closer to the flexible display than the rotation center of the first end of the first connection arm. In this case, the rotation center of the first end of the first connection arm may be disposed at a position to meet linkage between the second connection arm and another structure, and positions of the rotation center of the first end of the second connection arm and the rotation center of the first end of the first connection arm may be set, to meet a position change of the mounting bracket relative to the main shaft.

In some possible implementations, when the second end of the second connection arm is slidably connected to the mounting bracket, a sliding direction of the second end of the second connection arm relative to the mounting bracket is not parallel to a sliding direction of the second end of the first connection arm relative to the mounting bracket.

In this embodiment of this application, the sliding direction of the second end of the second connection arm and the sliding direction of the second end of the first connection arm relative to the mounting bracket are appropriately designed, so that angles at which the first connection arm and the second connection arm rotate relative to the main shaft is not greater than 90°. Compared with the conventional solution, this solution can effectively reduce a rotation angle of the second connection arm. In this way, a wall thickness of a local structure of the second connection arm may be large, and a wall thickness design meets a structural strength requirement, so that structural reliability of the second connection arm is improved. In addition, because rotation angles of the first connection arm and the second connection arm are small, a thinning design performed on some components in the electronic device because rotation of the first connection arm and the second connection arm needs to be avoided can be effectively avoided. This improves reliability of an overall structure of the electronic device.

In some possible implementations, the mounting bracket has a first surface, a second surface, a third surface, and a fourth surface. The first surface is disposed opposite to the second surface, and the first surface is located between the flexible display and the second surface. The third surface is disposed opposite to the fourth surface, and the third surface is located between the main shaft and the fourth surface. The mounting bracket includes a first sliding slot and a second sliding slot. An extension direction of the second sliding slot is not parallel to an extension direction of the first sliding slot, openings at two ends of the first sliding slot are respectively located on the first surface and the second surface, and openings at two ends of the second sliding slot are respectively located on the third surface and the fourth surface. A sliding block at the second end of the first connection arm is mounted in the first sliding slot and can slide relative to the mounting bracket in the extension direction of the first sliding slot. A sliding block at the second end of the second connection arm is mounted in the second sliding slot and can slide relative to the mounting bracket in the extension direction of the second sliding slot.

In this embodiment of this application, the extension direction of the first sliding slot and the extension direction of the second sliding slot of the mounting bracket are set, to control the sliding direction of the second end of the first connection arm relative to the mounting bracket and the sliding direction of the second end of the second connection arm relative to the mounting bracket. This helps control a movement path of the mounting bracket relative to the main shaft, so that the electronic device obtains an ideal accommodation space.

In some possible implementations, the foldable assembly further includes a connection rod, one end of the connection rod is rotatably connected to the first connection arm, and the other end of the connection rod is rotatably connected to the second connection arm. In this way, the first connection arm, the connection rod, the second connection arm, and the main shaft may form a four-link mechanism, so that in a process in which the first housing rotates relative to the second housing, movement actions of the first connection arm and the second connection arm are prevented from being stuck, to improve reliability of the mechanism.

In some possible implementations, the foldable assembly further includes a support plate, the support plate is connected to the mounting bracket, and the support plate is further connected to the first connection arm or the second connection arm. When the first housing and the second housing are unfolded relative to each other to the unfolded state, the first housing, the main shaft, the support plate, and the second housing jointly support the flexible display. The support plate includes a first end close to the main shaft and a second end away from the main shaft. When the first housing and the second housing are folded relative to each other to the folded state, a distance between the first end of the support plate and the first housing is greater than a distance between the second end of the support plate and the first housing, to form an accommodation space between the support plate and the first housing, and the flexible display is at least partially accommodated in the accommodation space. The accommodation space is an upper-narrow lower-wide space that is offset toward the second housing.

In this embodiment of this application, because the support plate is rotatably connected to the mounting bracket and is slidably connected to the second connection arm, in a process in which the first housing and the second housing move relative to each other, the support plate moves under driving of the mounting bracket and the second connection arm, and a movement path is accurate, to meet support requirements of the foldable apparatus for the flexible display in different forms.

In some possible implementations, the mounting bracket has a first surface, and the first surface is disposed facing the support plate. When the first housing and the second housing are unfolded relative to each other to the unfolded state, a first included angle is formed between the first surface and the support plate, and a distance between the support plate and an end that is of the first surface and that is close to the main shaft is greater than a distance between the support plate and an end that is of the first surface and that is away from the main shaft. When the first housing and the second housing are folded relative to each other to the folded state, the support plate rotates relative to the mounting bracket and approaches the first surface, a second included angle is formed between the first surface and the support plate, and the second included angle is less than the first included angle. In other words, in a process of folding the electronic device, the support plate rotates relative to the mounting bracket and approaches the mounting bracket, to avoid forming the accommodation space.

In some possible implementations, the mounting bracket further has a first rotation groove, and the first rotation groove is an arc-shaped groove and extends from the first surface to an inner side of the mounting bracket. The support plate includes a plate body and a first rotation block. The plate body is configured to support the flexible display when the first housing and the second housing are unfolded relative to each other to the unfolded state. The first rotation block is fastened to a side that is of the plate body and that faces the flexible display, and the arc-shaped arm of the first rotation block extends from the plate body in a direction away from the main shaft. The arc-shaped arm of the first rotation block is mounted in the first rotation groove. In a process in which the first housing and the second housing are unfolded relative to each other, a part of the arc-shaped arm of the first rotation block rotates out of the first rotation groove. In a process in which the first housing and the second housing are folded relative to each other, a part of the arc-shaped arm of the first rotation block rotates into the first rotation groove.

In some possible implementations, the flexible display includes a first part, a second part, and a third part. The third part is connected between the first part and the second part, the first part is fastened to the first housing, and the second part is fastened to the second housing. When the first housing and the second housing are folded relative to each other to the folded state, the third part is at least partially accommodated in the accommodation space, and a middle part of the third part is offset in a direction toward the second housing.

In this embodiment of this application, because the accommodation space is offset toward the second housing, the flexible display deforms with the accommodation space, and the third part of the flexible display is offset toward the second housing. In comparison with a symmetric deformation of the conventional flexible display, bending positions of the third part of the flexible display in this application are few. This helps reduce a risk of damaging the flexible display, improves reliability of the flexible display, and prolongs the service life of the flexible display.

In some possible implementations, the third part includes a first segment, a second segment, a third segment, and a fourth segment that are sequentially connected. The first segment is connected to the first part, and the fourth segment is connected to the second part. When the first housing and the second housing are folded relative to each other to the folded state, the second segment and the fourth segment are curved segments, and the second segment and the third segment are offset in the direction toward the second housing. In this case, bending positions of the flexible display are located in the second segment and the fourth segment.

In some possible implementations, the flexible display includes a flexible display panel and a bearing plate. The bearing plate is fastened to a non-display side of the flexible display panel, and stiffness of the bearing plate is greater than stiffness of the flexible display panel. The bearing plate is configured to provide rigid support for the flexible display panel and can be bent, to improve support strength of the flexible display.

The bearing plate includes a first plate part located on the first segment, a second plate part located on the second segment, a third plate part located on the third segment, and a fourth plate part located on the fourth segment, and stiffness of the first plate part and the third plate part is greater than stiffness of the second plate part and the fourth plate part. In this case, the second plate part and the fourth plate part have weak stiffness, and can be easily bent when supporting the flexible display panel.

In some possible implementations, the stiffness of the second plate part and the fourth plate part can be reduced by providing a through hole and a groove, reducing a thickness, splicing a soft rubber part, or the like, to achieve good bending performance and tensile performance. In some possible implementations, the second plate part is provided with at least one groove or at least one through hole, or a thickness of the second plate part is less than a thickness of the first plate part.

In some possible implementations, the first segment is fastened to the first housing, the second segment is not fastened to the main shaft, and the third segment is fastened to the support plate. In this case, in a process in which the electronic device switches from the unfolded state to the folded state, the flexible display can be bent into an expected shape. This reduces a risk of arching the flexible display, improves reliability, and prolongs a service life of the flexible display.

In some possible implementations, the main shaft includes an outer surface facing the flexible display. When the first housing and the second housing are unfolded relative to each other to the unfolded state, the first housing and the second housing are spliced and jointly shield the outer surface of the main shaft. When the first housing and the second housing are folded relative to each other to the folded state, a part of the outer surface of the main shaft is exposed relative to the first housing and the second housing, and edges on two sides of the outer surface of the main shaft are shielded by the first housing and the second housing.

In this embodiment of this application, when the first housing and the second housing are in the unfolded state, the two housings are spliced with each other and jointly shield the main shaft, so that the electronic device has no obvious broken structure or gap at a joint between the two housings, and appearance integrity of the electronic device is good. When the first housing and the second housing are in the folded state, the two housings surround edges on two sides of the main shaft, so that there is no obvious section structure or gap at joints between the two housings and the main shaft, and appearance integrity of the electronic device is good. Therefore, when the electronic device is in the unfolded state or the folded state, the electronic device has good appearance integrity, and external sundries are difficult to enter the inner side of the foldable assembly. This helps improve reliability of the electronic device.

In some possible implementations, the first housing includes a first end surface close to the main shaft, and the second housing includes a second end surface close to the main shaft. When the first housing and the second housing are unfolded relative to each other to the unfolded state, the first end surface faces the second end surface. When the first housing and the second housing are folded relative to each other to the folded state, orientations of the first end surface and the second end surface are the same. In the thickness direction of the main shaft, a distance between the first end surface and the outer surface of the main shaft is greater than a distance between the second end surface and the outer surface of the main shaft.

When the first housing and the second housing are in the unfolded state, the first end surface and the second end surface may be disposed obliquely relative to the thickness direction of the main shaft, and when the first housing and the second housing are in the folded state, the first end surface and the second end surface may be disposed to be flush with each other, to improve appearance experience and a holding feel of the electronic device.

In some possible implementations, the electronic device further includes a third housing and a second foldable assembly. The second foldable assembly is connected to a side that is of the first housing and that is away from the second housing, and the second foldable assembly is further connected to the third housing. When the electronic device is in the folded state, the first housing is located between the third housing and the second housing. A part that is of the flexible display and that corresponds to the third housing is fastened to the third housing. A part that is of the flexible display and that corresponds to the second foldable assembly deforms in a process in which the first housing and the third housing are unfolded relative to each other or folded relative to each other. When the electronic device is in the unfolded state, the flexible display is located on a same side of the first housing, the second housing, and the third housing, and the first housing, the second housing, and the third housing jointly support the flexible display. When the electronic device is in the folded state, in a direction from the third housing to the second housing, the part that is of the flexible display and that corresponds to the third housing, the third housing, the first housing, the part that is of the flexible display and that corresponds to the first housing, the part that is of the flexible display and that corresponds to the second housing, and the second housing are sequentially stacked.

According to a second aspect, an embodiment of this application further provides a foldable assembly. The foldable assembly is used in a foldable electronic device, the foldable assembly is configured to connect a first housing and a second housing of the electronic device, and the foldable assembly includes a main shaft, a mounting bracket, a rotation arm, a first connection arm, and a second connection arm. A first end of the rotation arm is rotatably connected to the main shaft, and a second end of the rotation arm is fastened to the first housing. The mounting bracket is configured to be fastened to the second housing. A first end of the first connection arm is rotatably connected to the main shaft around a first axis, and a second end of the first connection arm is slidably connected to the mounting bracket. A first end of the second connection arm is rotatably connected to the main shaft around a second axis, and the second end of the second connection arm is rotatably or slidably connected to the mounting bracket. The second axis does not overlap the first axis.

In this embodiment of this application, the foldable assembly is of an asymmetric structure. The first housing is rotatably connected to the main shaft via the rotation arm, and the second housing is movably connected to the main shaft via the first connection arm, the second connection arm, and the mounting bracket, to implement relative movement between the first housing and the second housing. The foldable assembly has a small quantity of parts, simple composition, and low costs.

In addition, through cooperation of a double-link-sliding block mechanism or cooperation between a link-sliding block mechanism and a link mechanism, connection between the second housing and the main shaft can be implemented, and the second housing can move relative to the main shaft. A quantity of components is small, a cooperation relationship and a cooperation position are simple, and the components are easy to manufacture and assemble. This facilitates mass production, to reduce costs of the foldable apparatus. In addition, because the main shaft links the mounting bracket via the first connection arm and the second connection arm, a movement path of the second housing is accurate. This helps implement accurate control of a movement form of the foldable apparatus. In addition, the foldable apparatus has a good mechanism tensile resistance capability and a good mechanism extrusion resistance capability.

In addition, the first housing is rotatably connected to the main shaft via the rotation arm. After the first housing rotates relative to the main shaft to a folded state, no concave space used to accommodate the flexible display is reserved at a joint between the first housing and the main shaft. The second housing is connected to the main shaft via the first connection arm and the second connection arm, for example, connected to the main shaft via the double-link-sliding block mechanism or a cooperation mechanism of the link-sliding block mechanism and the link mechanism. After the second housing rotates relative to the main shaft to the folded state, a concave space used to accommodate the flexible display is reserved at a joint between the second housing and the main shaft. Therefore, when the first housing and the second housing are folded relative to each other to the folded state, an accommodation space offset toward the second housing is formed between the first housing and the second housing and inside the foldable assembly. Based on a shape of the accommodation space offset toward one side, compared with a symmetric space of the conventional foldable electronic device, the accommodation space can reduce bending positions of a part of the flexible display accommodated in the accommodation space. This helps reduce a risk of damaging the flexible display, improves reliability of the flexible display, and prolongs a service life of the flexible display.

In some possible implementations, the foldable assembly further includes a synchronization assembly, and the synchronization assembly is engaged with the first end of the rotation arm and the first end of the first connection arm. In this embodiment of this application, a rotation action of the rotation arm relative to the main shaft and a rotation action of the first connection arm relative to the main shaft are synchronized via the synchronization assembly, to improve mechanism operation experience of a user.

In some possible implementations, the first end of the rotation arm is provided with a connection gear, the synchronization assembly includes a first synchronization gear and a second synchronization gear, and the first synchronization gear is engaged with the connection gear. In a thickness direction of the main shaft, the first synchronization gear is located on a side that is of the connection gear and that is opposite to a support surface of the main shaft, and the second synchronization gear is engaged with the first synchronization gear and the first end of the first connection arm.

In this embodiment of this application, a thickness space of the main shaft can be fully used through top-bottom arrangement of the connection gear and the first synchronization gear, and the first synchronization gear and the connection gear reuse a part of a width space of the main shaft. This helps reduce a width size of the main shaft, and miniaturize the main shaft.

A pitch diameter of the second synchronization gear may be different from a pitch diameter of the first synchronization gear, to better adapt to a position of the first synchronization gear and a position of the first end of the first connection arm, and realize engaging transmission. In addition, the second synchronization gear is an incomplete gear, and a tooth part position and a toothless area position of the second synchronization gear may be adjusted, to reduce a movement space requirement of the second synchronization gear during movement as much as possible while ensuring that an engaging connection requirement is implemented, so as to reduce a space requirement for the main shaft, for example, a space requirement for the thickness direction of the main shaft. This facilitates thinning of the main shaft.

In some possible implementations, the connection gear is an incomplete gear, and the connection gear includes a support surface and a tooth part that are disposed opposite to each other. When the first housing and the second housing are unfolded relative to each other to an unfolded state, the tooth part of the connection gear faces the first synchronization gear and is located in the main shaft, and the support surface of the connection gear is flush with the support surface of the main shaft. In this case, the connection gear and the main shaft can be jointly configured to support the flexible display, to improve integrity and flatness of a support environment of the flexible display. In addition, the connection gear is an incomplete gear, so that a volume of the connection gear is reduced when a connection relationship is met. This helps reduce the thickness of the main shaft configured to mount the connection gear, and facilitate thinning of the main shaft.

When the first housing and the second housing are folded relative to each other to a folded state, the connection gear rotates relative to the main shaft, and a part of the tooth part of the connection gear rotates out of the main shaft. In this case, the connection gear may move by using a space above the main shaft, so that the main shaft reserves only a partial space used to allow the connection gear to move. This helps reduce the thickness of the main shaft, and miniaturize the main shaft.

In some possible implementations, in a width direction of the main shaft, a rotation center of the first synchronization gear is away from the second synchronization gear relative to a rotation center of the connection gear, and the width direction of the main shaft is perpendicular to the thickness direction of the main shaft and is perpendicular to an extension direction of the main shaft. In this embodiment of this application, positions of the rotation center of the first synchronization gear and the rotation center of the connection gear are set, so that the first synchronization gear and the connection gear are always in an engaged state. This avoids idle rotation, to improve mechanism reliability of the foldable apparatus.

In some possible implementations, the first end of the rotation arm is further provided with an arc-shaped arm. The arc-shaped arm is fastened to a side of the connection gear, and a central axis of the arc-shaped arm is collinear with a central axis of the connection gear. The arc-shaped arm is mounted in an arc-shaped groove of the main shaft, to rotatably connect the main shaft. In this embodiment of this application, the arc-shaped arm at the first end of the rotation arm cooperates with the arc-shaped groove of the main shaft, so that the first end of the rotation arm is rotatably connected to the main shaft through a virtual shaft.

In some possible implementations, a rotation center of the first end of the second connection arm is closer to the flexible display than a rotation center of the first end of the first connection arm. In this case, the rotation center of the first end of the first connection arm may be disposed at a position to meet linkage between the second connection arm and another structure, and positions of the rotation center of the first end of the second connection arm and the rotation center of the first end of the first connection arm may be set, to meet a position change of the mounting bracket relative to the main shaft.

In some possible implementations, when the second end of the second connection arm is slidably connected to the mounting bracket, a sliding direction of the second end of the second connection arm relative to the mounting bracket is not parallel to a sliding direction of the second end of the first connection arm relative to the mounting bracket. In this embodiment of this application, the sliding direction of the second end of the second connection arm and the sliding direction of the second end of the first connection arm relative to the mounting bracket are appropriately designed, so that angles at which the first connection arm and the second connection arm rotate relative to the main shaft is not greater than 90°. Compared with the conventional solution, this solution can effectively reduce a rotation angle of the second connection arm. In this way, a wall thickness of a local structure of the second connection arm may be large, and a wall thickness design meets a structural strength requirement, so that structural reliability of the second connection arm is improved. In addition, because rotation angles of the first connection arm and the second connection arm are small, a thinning design performed on some components in the electronic device because rotation of the first connection arm and the second connection arm needs to be avoided can be effectively avoided. This improves reliability of an overall structure of the electronic device.

In some possible implementations, the mounting bracket has a first surface, a second surface, a third surface, and a fourth surface. The first surface is disposed opposite to the second surface, and the first surface is located between the flexible display and the second surface. The third surface is disposed opposite to the fourth surface, and the third surface is located between the main shaft and the fourth surface. The mounting bracket includes a first sliding slot and a second sliding slot, an extension direction of the second sliding slot is not parallel to an extension direction of the first sliding slot, openings at two ends of the first sliding slot are respectively located on the first surface and the second surface, and openings at two ends of the second sliding slot are respectively located on the third surface and the fourth surface. A sliding block at the second end of the first connection arm is mounted in the first sliding slot and can slide relative to the mounting bracket in the extension direction of the first sliding slot. A sliding block at the second end of the second connection arm is mounted in the second sliding slot and can slide relative to the mounting bracket in the extension direction of the second sliding slot.

In this embodiment of this application, the extension direction of the first sliding slot and the extension direction of the second sliding slot of the mounting bracket are set, to control the sliding direction of the second end of the first connection arm relative to the mounting bracket and the sliding direction of the second end of the second connection arm relative to the mounting bracket. This helps control a movement path of the mounting bracket relative to the main shaft, so that the electronic device obtains an ideal accommodation space.

In some possible implementations, the foldable assembly further includes a connection rod, one end of the connection rod is rotatably connected to the first connection arm, and the other end of the connection rod is rotatably connected to the second connection arm. In this way, the first connection arm, the connection rod, the second connection arm, and the main shaft may form a four-link mechanism, so that in a process in which the first housing rotates relative to the second housing, movement actions of the first connection arm and the second connection arm are prevented from being stuck, to improve reliability of the mechanism.

In some possible implementations, the foldable assembly further includes a support plate, the support plate is connected to the mounting bracket, and the support plate is further connected to the first connection arm or the second connection arm. When the first housing and the second housing are unfolded relative to each other to the unfolded state, the first housing, the main shaft, the support plate, and the second housing are configured to jointly support the flexible display of the electronic device. The support plate includes a first end close to the main shaft and a second end away from the main shaft. When the first housing and the second housing are folded relative to each other to the folded state, a distance between the first end of the support plate and the first housing is greater than a distance between the second end of the support plate and the first housing, to form an accommodation space between the support plate and the first housing, and the flexible display of the electronic device is at least partially accommodated in the accommodation space. The accommodation space is an upper-narrow lower-wide space that is offset toward the second housing.

In this embodiment of this application, because the support plate is rotatably connected to the mounting bracket and is slidably connected to the second connection arm, in a process in which the first housing and the second housing move relative to each other, the support plate moves under driving of the mounting bracket and the second connection arm, and a movement path is accurate, to meet support requirements of the foldable apparatus for the flexible display in different forms.

In addition, because the accommodation space is offset toward the second housing, the flexible display deforms with the accommodation space, and the part that is of the flexible display and that is accommodated in the accommodation space is offset toward the second housing. In comparison with a symmetric deformation of the conventional flexible display, bending positions of the flexible display in this application are few. This helps reduce a risk of damaging the flexible display, improves reliability of the flexible display, and prolongs the service life of the flexible display.

In some possible implementations, the mounting bracket has a first surface, and the first surface is disposed facing the support plate. When the first housing and the second housing are unfolded relative to each other to the unfolded state, a first included angle is formed between the first surface and the support plate, and a distance between the support plate and an end that is of the first surface and that is close to the main shaft is greater than a distance between the support plate and an end that is of the first surface and that is away from the main shaft. When the first housing and the second housing are folded relative to each other to the folded state, the support plate rotates relative to the mounting bracket and approaches the first surface, a second included angle is formed between the first surface and the support plate, and the second included angle is less than the first included angle. In other words, in a process of folding the electronic device, the support plate rotates relative to the mounting bracket and approaches the mounting bracket, to avoid forming the accommodation space.

In some possible implementations, the mounting bracket further has a first rotation groove, and the first rotation groove is an arc-shaped groove and extends from the first surface to an inner side of the mounting bracket. The support plate includes a plate body and a first rotation block. The plate body is configured to support the flexible display when the first housing and the second housing are unfolded relative to each other to the unfolded state. The first rotation block is fastened to a side that is of the plate body and that faces the flexible display, and the arc-shaped arm of the first rotation block extends from the plate body in a direction away from the main shaft. The arc-shaped arm of the first rotation block is mounted in the first rotation groove. In a process in which the first housing and the second housing are unfolded relative to each other, a part of the arc-shaped arm of the first rotation block rotates out of the first rotation groove. In a process in which the first housing and the second housing are folded relative to each other, a part of the arc-shaped arm of the first rotation block rotates into the first rotation groove.

### BRIEF DESCRIPTION OF DRAWINGS

FIG. 1 is a diagram of a structure of an electronic device in an unfolded state according to an embodiment of this application;
FIG. 2 is a diagram of a structure of the electronic device shown in FIG. 1 in a folded state;
FIG. 3 is a diagram of a partial exploded structure of the electronic device shown in FIG. 1;
FIG. 4 is a diagram of a partial exploded structure of a foldable apparatus shown in FIG. 3;
FIG. 5 is a diagram of a partial exploded structure of a foldable assembly shown in FIG. 4;
FIG. 6 is a diagram of an exploded structure of a main shaft shown in FIG. 5;
FIG. 7 is a diagram of a partial structure of a main shaft shown in FIG. 5;
FIG. 8A is a diagram of a cross-sectional structure of the main shaft shown in FIG. 7 cut along A-A;
FIG. 8B is a diagram of a cross-sectional structure of the main shaft shown in FIG. 7 cut along B-B;
FIG. 8C is a diagram of a cross-sectional structure of the main shaft shown in FIG. 7 cut along C-C;
FIG. 8D is a diagram of a cross-sectional structure of the main shaft shown in FIG. 7 cut along D-D;
FIG. 9 is a diagram of a structure of a bottom connection assembly shown in FIG. 5;
FIG. 10 is a diagram of a partial exploded structure of the bottom connection assembly shown in FIG. 9;
FIG. 11A is a diagram of a structure of a rotation arm shown in FIG. 10;
FIG. 11B is a diagram of a structure of the rotation arm shown in FIG. 11A from another angle;
FIG. 12 is a diagram of a structure of a first connection arm shown in FIG. 10;
FIG. 13A is a diagram of a structure of a synchronization assembly shown in FIG. 10;
FIG. 13B is a diagram of a structure of the synchronization assembly shown in FIG. 13A from another angle;
FIG. 14 is a diagram of a structure of a damping assembly shown in FIG. 10;
FIG. 15 is a diagram of an exploded structure of the damping assembly shown in FIG. 14;
FIG. 16 is a diagram of an exploded structure of the bottom connection assembly shown in FIG. 9;
FIG. 17 is a diagram of a structure of a second connection arm shown in FIG. 10;
FIG. 18 is a diagram of an assembly structure of the main shaft shown in FIG. 7 and a partial structure of the bottom connection assembly shown in FIG. 9;
FIG. 19 is a diagram of a partial structure of the structure shown in FIG. 18;
FIG. 20 is a diagram of a structure of a mounting bracket shown in FIG. 10;
FIG. 21 is a diagram of a partial structure of a foldable apparatus shown in FIG. 3;
FIG. 22A is a diagram of a cross-sectional structure of the structure shown in FIG. 21 cut along E-E;
FIG. 22B is a diagram of a cross-sectional structure of the structure shown in FIG. 22A in another use state;
FIG. 23A is a diagram of a cross-sectional structure of the structure shown in FIG. 21 cut along F-F;
FIG. 23B is a diagram of a cross-sectional structure of the structure shown in FIG. 23A in another use state;
FIG. 24A is a diagram of a cross-sectional structure of the structure shown in FIG. 21 cut along G-G;
FIG. 24B is a diagram of a cross-sectional structure of the structure shown in FIG. 24A in another use state;
FIG. 25 is a diagram of a mechanism in a case in which a first connection arm, a second connection arm, and a mounting bracket shown in FIG. 21 move relative to each other;
FIG. 26 is a diagram of a position relationship between a first housing, a second housing, and a main shaft shown in FIG. 21;
FIG. 27 is a diagram of a structure of a support plate shown in FIG. 5 from another angle;
FIG. 28 is a diagram of a structure of a foldable apparatus shown in FIG. 3 from another angle;
FIG. 29A is a diagram of a cross-sectional structure of the foldable apparatus shown in FIG. 28 cut along H-H;
FIG. 29B is a diagram of a cross-sectional structure of the structure shown in FIG. 29A in another use state;
FIG. 30A is a diagram of a cross-sectional structure of the foldable apparatus shown in FIG. 28 cut along I-I;
FIG. 30B is a diagram of a cross-sectional structure of the structure shown in FIG. 30A in another use state;
FIG. 31A is a diagram of an internal structure of the electronic device shown in FIG. 2;
FIG. 31B is a diagram of a structure of a fastening solution of a flexible display and a foldable apparatus of the electronic device shown in FIG. 1 in some embodiments;
FIG. 32 is a diagram of an exploded structure of the flexible display shown in FIG. 31B;
FIG. 33 is a diagram of a brief structure of a partial structure of a foldable assembly shown in FIG. 4 in some other embodiments;
FIG. 34A is a diagram of a moving mechanism of a partial structure of a foldable assembly shown in FIG. 4 in some other embodiments;
FIG. 34B is a diagram of a brief structure of a partial structure of the moving mechanism shown in FIG. 34A in some implementations;
FIG. 34C is a diagram of a brief structure of a partial structure of the moving mechanism shown in FIG. 34A in some other implementations; and
FIG. 35 is a diagram of a structure of an electronic device in some other embodiments according to an embodiment of this application.

### DESCRIPTION OF EMBODIMENTS

The following describes technical solutions of embodiments in this application with reference to the accompanying drawings.

In descriptions of embodiments of this application, unless otherwise explicitly specified and limited, the term "and/or" in this specification describes only an association relationship for describing associated objects and represents that three relationships may exist. For example, A and/or B may represent the following three cases: only A exists, both A and B exist, and only B exists. "First", "second", and the like are used only for description purposes, and cannot be understood as implying or implying relative importance or implicitly indicating a quantity of technical features. Therefore, a feature limited by "first" or "second" may explicitly or implicitly include one or more features. "A plurality of" refers to two or more than two.

For example, "mounting" and "connection" should be understood broadly. For example, "connection" may be a non-detachable connection or may be a direct connection or an indirect connection through an intermediate. "Fixed connection" means that two parts are connected to each other and a relative position relationship remains unchanged after the two parts are connected. "Rotatable connection" means that two parties are connected to each other and can rotate relative to each other after the two parties are connected to each other. "Slidable connection" means that two parties are connected to each other and can slide relative to each other after the two parties are connected to each other. An "integral structural member" means that in a process of forming one part of the mechanical part, the part is connected to another part of the mechanical part, and does not need to be connected to the another part through reprocessing (such as bonding, welding, or clamping).

The orientation terms mentioned in embodiments of this application, for example, "up", "down", "left", "right", "inside", and "outside", are merely directions based on the accompanying drawings. Therefore, the orientation terms are used to better and more clearly describe and understand embodiments of this application, instead of indicating or implying that a specified apparatus or element should have a specific orientation and be constructed and operated in a specific orientation. Therefore, this cannot be understood as a limitation on embodiments of this application.

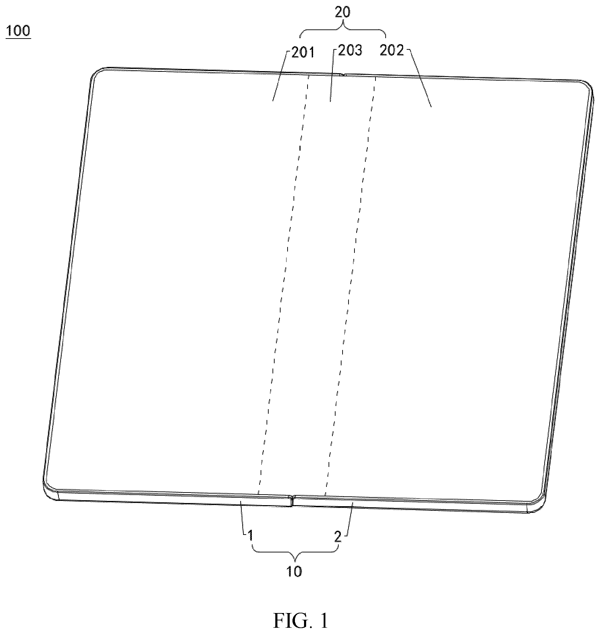

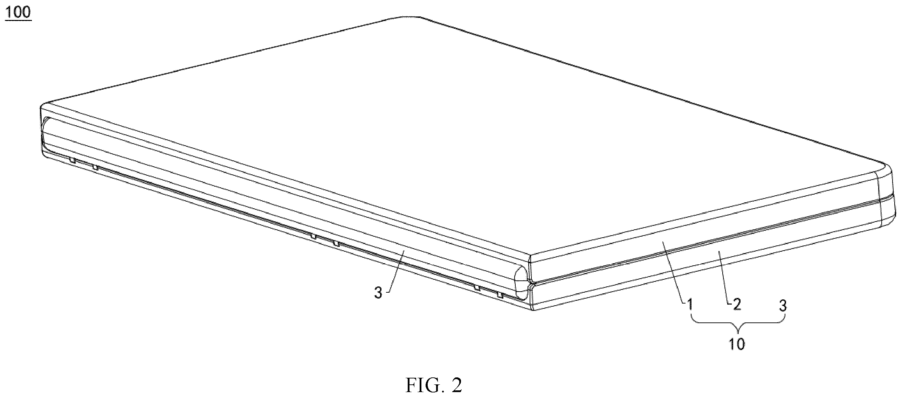

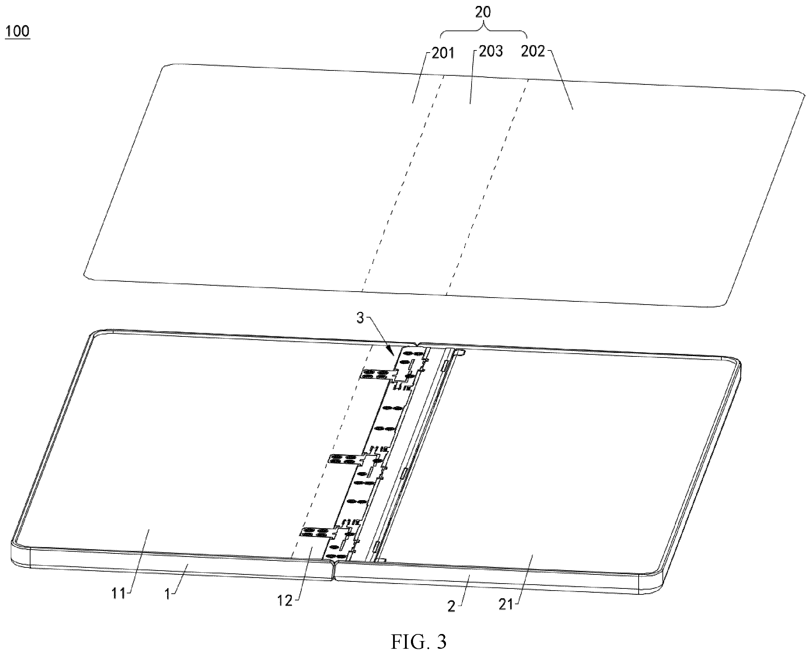

Refer to FIG. 1 to FIG. 3. FIG. 1 is a diagram of a structure of an electronic device 100 in an unfolded state according to an embodiment of this application. FIG. 2 is a diagram of a structure of the electronic device 100 shown in FIG. 1 in a folded state. FIG. 3 is a diagram of a partial exploded structure of the electronic device 100 shown in FIG. 1. The electronic device 100 may be a foldable electronic product, for example, a mobile phone, a tablet, a notebook computer, or a wearable device, and the wearable device may be a smart watch, a smart band, or the like. In embodiments of this application, descriptions are provided by using an example in which the electronic device 100 is a mobile phone.

In some embodiments, the electronic device 100 may include a foldable apparatus 10 and a flexible display 20, and the flexible display 20 is mounted on the foldable apparatus 10. The flexible display 20 is configured to display an image. For example, the foldable apparatus 10 may include a first housing 1, a second housing 2, and a foldable assembly 3. The foldable assembly 3 is connected to the first housing 1 and the second housing 2, and through movement of the foldable assembly 3, the first housing 1 and the second housing 2 are capable of being unfolded relative to each other to an unfolded state or folded relative to each other to a folded state.

As shown in FIG. 1, the first housing 1 and the second housing 2 may be unfolded relative to each other to the unfolded state, so that the foldable assembly 3, the foldable apparatus 10, and the electronic device 100 are all in the unfolded state. The flexible display 20 is unfolded along with the foldable apparatus 10. For example, when the foldable apparatus 10 is in the unfolded state, an included angle between the first housing 1 and the second housing 2 is 120°, 150°, 165°, 180°, or the like. In this embodiment of this application, an example in which the included angle between the first housing 1 and the second housing 2 is 180° is used for description. In this case, the flexible display 20 is in an unfolded state.

As shown in FIG. 2, the first housing 1 and the second housing 2 may be folded relative to each other to the folded state, so that the foldable assembly 3, the foldable apparatus 10, and the electronic device 100 are all in the folded state. The flexible display 20 is folded along with the foldable apparatus 10. For example, when the foldable apparatus 10 is in the folded state, the flexible display 20 may be located between the first housing 1 and the second housing 2. In other words, the flexible display 20 may be located on an inner side of the foldable apparatus 10 and wrapped by the foldable apparatus 10. It may be understood that, when the first housing 1 and the second housing 2 are in the folded state, the included angle between the first housing 1 and the second housing 2 may be approximately 0°.

The first housing 1 and the second housing 2 may alternatively be unfolded relative to each other or folded relative to each other to an intermediate state, so that the foldable assembly 3, the foldable apparatus 10, and the electronic device 100 are all in the intermediate state. The intermediate state may be any state between the unfolded state and the folded state, and the flexible display 20 also changes accordingly.

In this embodiment, the flexible display 20 can be unfolded or folded along with the foldable apparatus 10. When the electronic device 100 is in the unfolded state, the flexible display 20 is in the unfolded state, and the flexible display 20 can perform full-screen display, so that the electronic device 100 has a large display area, to improve viewing experience and operation experience of a user. When the electronic device 100 is in the folded state, a plane size of the electronic device 100 is small, so that it is convenient for the user to carry and store the electronic device 100. When the electronic device 100 is in the intermediate state, the flexible display 20 is in a bent state, so that viewing requirements of the user for different angles of view can be met.

In some embodiments, the first housing 1 includes a first support surface 11 configured to bear the flexible display 20, and the second housing 2 includes a second support surface 21 configured to bear the flexible display 20. It should be noted that, in this application, an included angle between the first support surface 11 and the second support surface 21 is the included angle between the first housing 1 and the second housing 2. When the electronic device 100 is in the unfolded state, the included angle between the first support surface 11 and the second support surface 21 may be 180°. Specific shapes of the first support surface 11 and the second support surface 21 are not strictly limited in embodiments of this application. For example, the first support surface 11 may be provided with one or more structures such as a notch, a recess, and a protrusion, and the second support surface 21 is provided with one or more structures such as a notch, a recess, and a protrusion.

In some embodiments, the flexible display 20 may further be integrated with a display function and a touch sensing function. The display function of the flexible display 20 is used to display a text, an image, a video, and the like, and the touch sensing function of the flexible display 20 is used to detect a touch action of the user, to implement information exchange between a human and a machine. The flexible display 20 may be a liquid crystal display (liquid crystal display, LCD), an organic light-emitting diode (organic light-emitting diode, OLED) display, an active-matrix organic light-emitting diode (active-matrix organic light-emitting diode, AMOLED) display, a mini organic light-emitting diode (mini organic light-emitting diode) display, a micro light-emitting diode (micro light-emitting diode) display, a micro organic light-emitting diode (micro organic light-emitting diode) display, a quantum dot light emitting diode (quantum dot light emitting diode, QLED) display, or the like.

In this embodiment, as shown in FIG. 1 and FIG. 3, the flexible display 20 may include a first part 201, a second part 202, and a third part 203. The third part 203 is connected between the first part 201 and the second part 202. In other words, the first part 201, the third part 203, and the second part 202 are sequentially arranged. A part that is of the flexible display 20 and that corresponds to the first housing 1 is the first part 201, and the first part 201 may be fastened to the first housing 1. A part that is of the flexible display 20 and that corresponds to the second housing 2 is the second part 202, and the second part 202 may be fastened to the second housing 2. A part that is of the flexible display 20 and that corresponds to the foldable assembly 3 is the third part 203. In a process in which the first housing 1 and the second housing 2 are unfolded relative to each other or folded relative to each other, the first housing 1 drives the first part 201 to move, the second housing 2 drives the second part 202 to move, and the third part 203 deforms under driving of the first part 201, the second part 202, and the foldable apparatus 10. When the flexible display 20 is in the unfolded state, the first part 201, the third part 203, and the second part 202 are all located on a same plane. When the flexible display 20 is in the folded state, the first part 201 and the second part 202 are disposed opposite to each other. The first part 201 and the second part 202 may partially abut against each other, completely abut against each other, or have a small gap, and the third part 203 is in the bent state.

In some embodiments, the electronic device 100 may further include a plurality of components (not shown in the figure). The plurality of components are mainly accommodated inside the first housing 1 and the second housing 2, and some components may alternatively be at least partially mounted on the foldable assembly 3. This is not strictly limited in embodiments of this application. The plurality of components of the electronic device 100 may include but are not limited to a processor, an internal processor, an external storage interface, a universal serial bus (universal serial bus, USB) interface, a charging management module, a power management module, a battery, an antenna, a communication module, a camera module, an audio module, a speaker, a receiver, a microphone, a headset jack, a sensor module, a subscriber identity module (subscriber identity module, SIM) card interface, and one or more hard circuit boards or flexible circuit boards. The electronic device 100 may have more or fewer components than those described above, may combine two or more components, or may have different component configurations. A quantity, types, and locations of modules of the electronic device 100 are not limited in embodiments of this application.

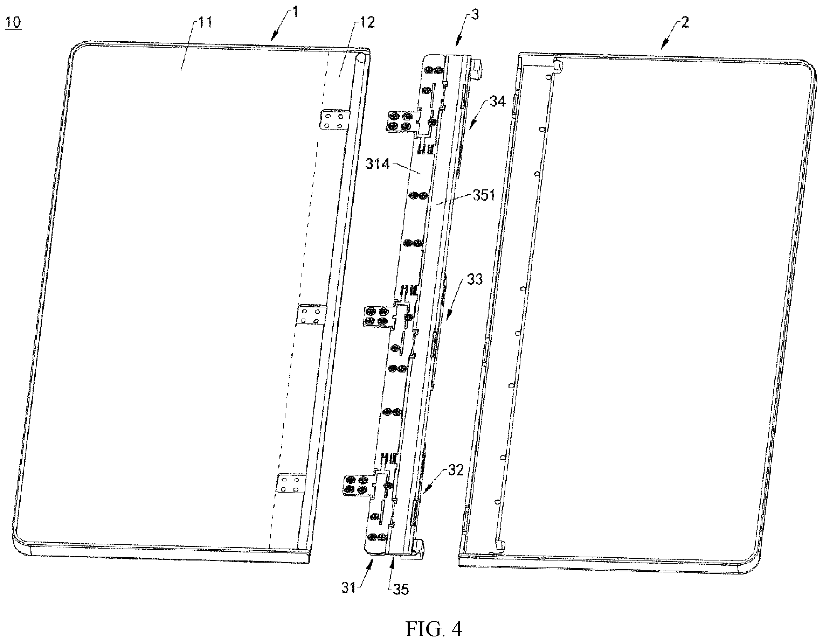

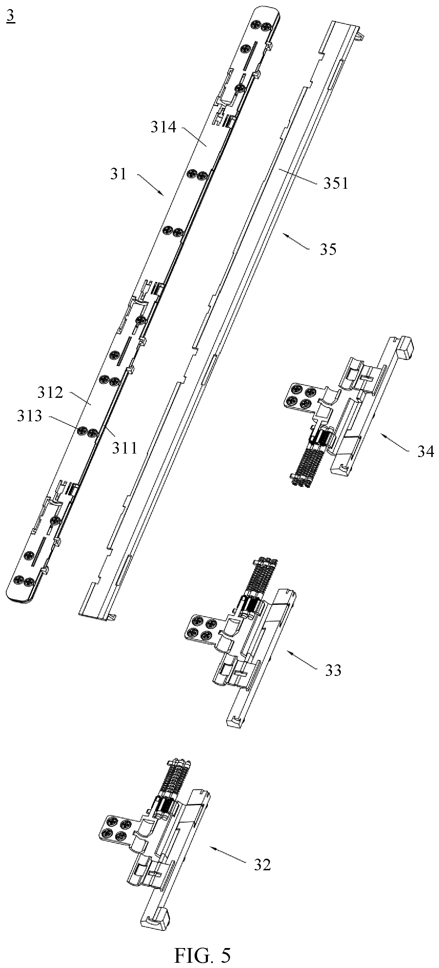

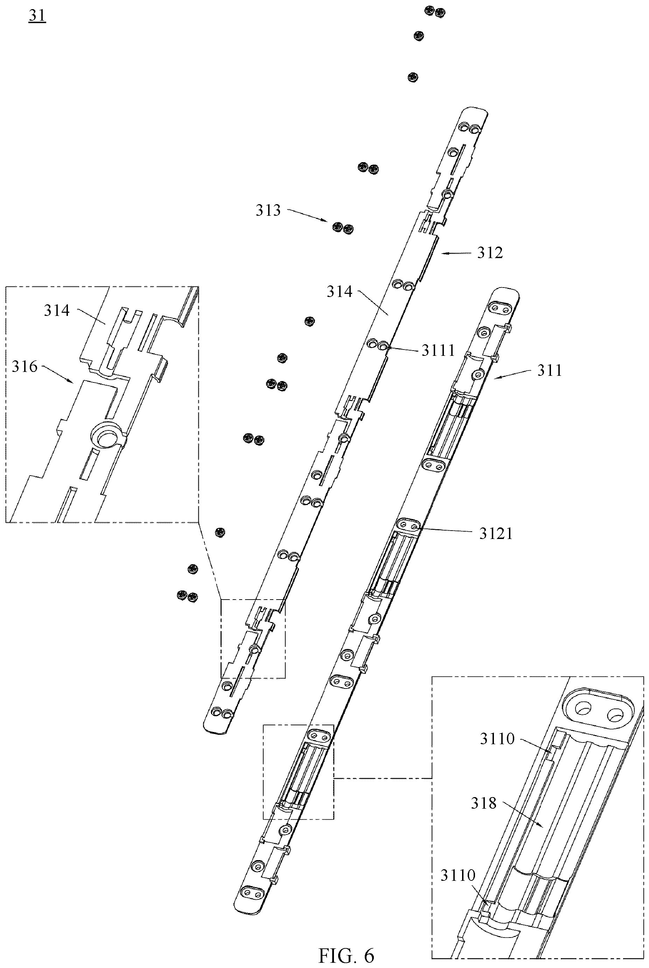

Refer to FIG. 4 to FIG. 6. FIG. 4 is a diagram of a partial exploded structure of the foldable apparatus 10 shown in FIG. 3, FIG. 5 is a diagram of a partial exploded structure of the foldable assembly 3 shown in FIG. 4, and FIG. 6 is a diagram of an exploded structure of a main shaft 31 shown in FIG. 5.

In some embodiments, the foldable assembly 3 includes the main shaft 31, a plurality of connection assemblies (32, 33, and 34), and a support plate 35. For example, the plurality of connection assemblies (32, 33, and 34) are all connected to the main shaft 31, and the plurality of connection assemblies (32, 33, and 34) can move, to be unfolded or folded relative to the main shaft 31. The plurality of connection assemblies (32, 33, and 34) are further connected between the first housing 1 and the second housing 2. When the plurality of connection assemblies (32, 33, and 34) move relative to the main shaft 31, the first housing 1 and the second housing 2 move relative to the main shaft 31, to be unfolded or folded relative to each other. For example, the plurality of connection assemblies (32, 33, and 34) may include a bottom connection assembly 32, a middle connection assembly 33, and a top connection assembly 34. The top connection assembly 34, the middle connection assembly 33, and the bottom connection assembly 32 are spaced apart in an extension direction of the main shaft 31. The extension direction of the main shaft 31 is a direction from the top of the main shaft 31 to the bottom of the main shaft 31.

In this embodiment, collaborative movement of the top connection assembly 34, the middle connection assembly 33, and the bottom connection assembly 32 makes movement of the first housing 1 and the second housing 2 more stable and reliable when the first housing 1 and the second housing 2 rotate relative to the main shaft 31.

The top connection assembly 34 and the bottom connection assembly 32 may be of a same structure, a mirror-surface symmetric structure, or other different structures. In this embodiment of this application, an example in which the top connection assembly 34 and the bottom connection assembly 32 are of the mirror-surface symmetric structure is used for description. The following mainly describes the bottom connection assembly 32. A structure of the middle connection assembly 33 may be the same as, partially the same as, or completely different from a structure of the bottom connection assembly 32. This is not strictly limited in embodiments of this application. In some other embodiments, the foldable assembly 3 may be provided with no middle connection assembly 33, or may be provided with a plurality of middle connection assemblies 33. This is not strictly limited in embodiments of this application.

For example, the main shaft 31 includes a main outer shaft 311, a main inner shaft 312, and a plurality of fasteners 313. The main inner shaft 312 is located above the main outer shaft 311, the plurality of fasteners 313 are configured to fasten the main inner shaft 312 and the main outer shaft 311, the main inner shaft 312 and the main outer shaft 311 can cooperate to form a plurality of spaces, and the plurality of spaces are used to mount the plurality of connection assemblies (32, 33, and 34) and provide movable spaces for the plurality of connection assemblies (32, 33, and 34). The main outer shaft 311 is provided with a plurality of fastening holes 3111, and the plurality of fastening holes 3111 are arranged on the top, the middle, and the bottom of the main outer shaft 311. The main inner shaft 312 is provided with a plurality of fastening holes 3121, and the plurality of fastening holes 3121 of the main inner shaft 312 and the plurality of fastening holes 3111 of the main outer shaft 311 are provided in a one-to-one correspondence. The fastener 313 passes through the fastening hole 3121 of the main inner shaft 312 and extends into the corresponding fastening hole 3111 of the main outer shaft 311, to implement fastening between the main inner shaft 312 and the main outer shaft 311.

For example, the support plate 35 is located on a side that is of the main inner shaft 312 and that faces the second housing 2, and the support plate 35 is connected to the top connection assembly 34, the middle connection assembly 33, and the bottom connection assembly 32, to move along with the top connection assembly 34, the middle connection assembly 33, and the bottom connection assembly 32 in a movement process of the foldable assembly 3. When the electronic device 100 is in the unfolded state, the main shaft 31 and the support plate 35 can jointly support the third part 203 of the flexible display 20, to improve reliability of the third part 203 of the flexible display 20.

The main shaft 31 has a support surface 314, and the support surface 314 of the main shaft 31 may be located on a side that is of the main inner shaft 312 and that is opposite to the main outer shaft 311. The support plate 35 is provided with a support surface 351, and the support surface 351 of the support plate 35 is disposed opposite to the plurality of connection assemblies (32, 33, and 34). When the electronic device 100 is in the unfolded state, the support surface 314 of the main shaft 31 and the support surface 351 of the support plate 35 may be spliced, and disposed facing the flexible display 20, to jointly provide a flat support environment for the third part 203 of the flexible display 20, so as to improve reliability of the flexible display 20. It may be understood that, in this embodiment of this application, when two surfaces are spliced, a solution in which the two surfaces are connected may be included, or a solution in which there is a small gap between the two surfaces but splicing effect is presented as a whole may be included.

As shown in FIG. 3 and FIG. 4, the first housing 1 may further include a third support surface 12, the third support surface 12 is located on a side that is of the first support surface 11 and that is close to the foldable assembly 3, and the third support surface 12 and the first support surface 11 may be disposed on a same plane. The plurality of connection assemblies (32, 33, and 34) of the foldable assembly 3 may be partially embedded into the third support surface 12. When the electronic device 100 is in the unfolded state, the third support surface 12 of the first housing 1, the main shaft 31, and the support plate 35 can jointly support the third part 203 of the flexible display 20, to improve reliability of the third part 203 of the flexible display 20.

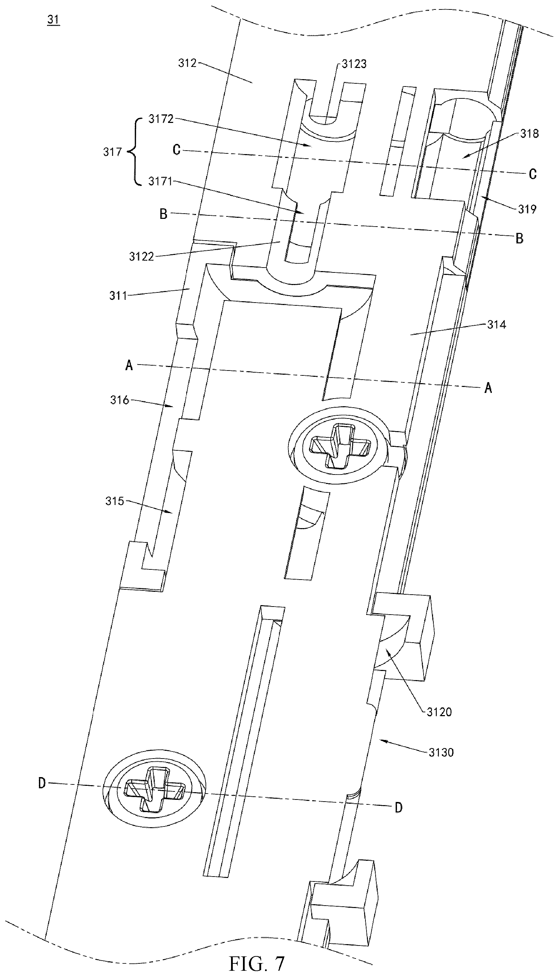

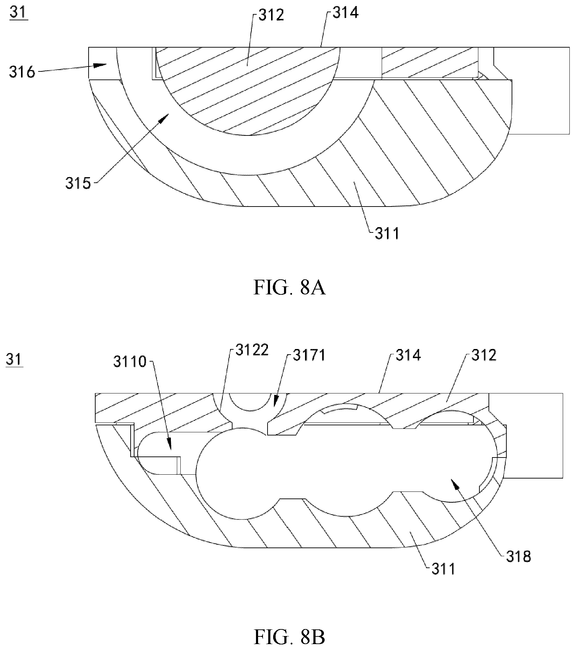

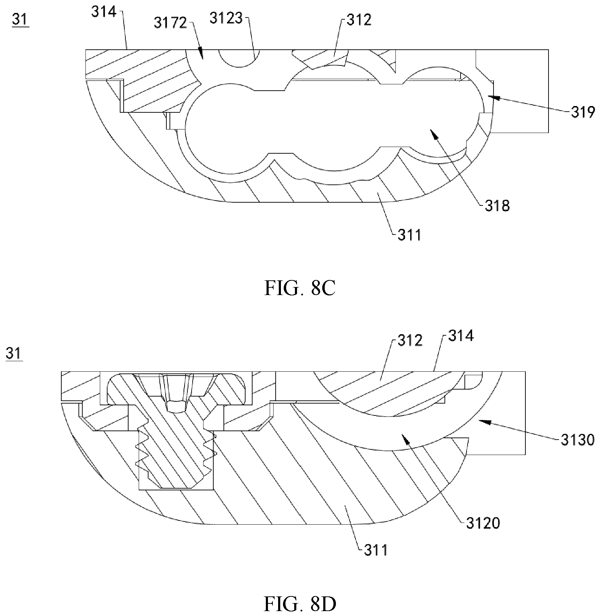

Refer to FIG. 6 to FIG. 8D. FIG. 7 is a diagram of a partial structure of the main shaft 31 shown in FIG. 5. FIG. 8A is a diagram of a cross-sectional structure of the main shaft 31 shown in FIG. 7 cut along A-A. FIG. 8B is a diagram of a cross-sectional structure of the main shaft 31 shown in FIG. 7 cut along B-B. FIG. 8C is a diagram of a cross-sectional structure of the main shaft 31 shown in FIG. 7 cut along C-C. FIG. 8D is a diagram of a cross-sectional structure of the main shaft 31 shown in FIG. 7 cut along D-D.

In some embodiments, the main shaft 31 has a first arc-shaped groove 315, and the first arc-shaped groove 315 may be formed by disposing an arc-shaped surface on the main inner shaft 312 opposite to an arc-shaped surface on the main outer shaft 311. Both sides of the first arc-shaped groove 315 may extend to the support surface 314 of the main shaft 31, and some notches on the support surface 314 of the main shaft 31 are a part of the first arc-shaped groove 315. In this case, the first arc-shaped groove 315 may be arranged by using a space of the main shaft 31 as much as possible. This helps improve space utilization of the main shaft 31 and reduce a thickness of the main shaft 31. The thickness of the main shaft 31 is a size of the main shaft 31 in a thickness direction of the main shaft 31, and the thickness direction of the main shaft 31 is perpendicular to the support surface 314 of the main shaft 31 and the extension direction of the main shaft 31. The main shaft 31 may be further provided with a first notch 316, the first notch 316 is located on a side edge of the main shaft 31, and the first notch 316 connects the first arc-shaped groove 315 to an external space of the main shaft 31. The first notch 316 may be formed on the main inner shaft 312 and/or the main outer shaft 3 11.

In some embodiments, the main shaft 31 may further have a mounting groove 317. The mounting groove 317 is located on the main inner shaft 312, and the mounting groove 317 includes a first part 3171 and a second part 3172 connected to the first part 3171. The first part 3171 of the mounting groove 317 and the second part 3172 of the mounting groove 317 are arranged in the extension direction of the main shaft 31, the first part 3171 of the mounting groove 317 is located between the first arc-shaped groove 315 and the second part 3172 of the mounting groove 317, and the first part 3171 of the mounting groove 317 is connected to the first arc-shaped groove 315.

The main inner shaft 312 includes a first arc surface 3122 and a second arc surface 3123. The first arc surface 3122 forms a groove wall or a part of the groove wall of the first part 3171 of the mounting groove 317, and the first arc surface 3122 is disposed facing the support surface 314 of the main shaft 31. The second arc surface 3123 forms a part of a groove wall of the second part 3172 of the mounting groove 317, and the second arc surface 3123 is disposed opposite to the support surface 314 of the main shaft 31. A central axis of the second arc surface 3123 is collinear with a central axis of the first arc surface 3122. The second arc surface 3123 and the first arc surface 3122 are disposed, so that the mounting groove 317 includes an equivalent arc-shaped groove, and a central axis of the arc-shaped groove is collinear with a central axis of the first arc-shaped groove 315.

In some embodiments, the main shaft 31 may further have a mounting space 318, and the mounting space 318 may be jointly formed by the main inner shaft 312 and the main outer shaft 311. The mounting space 318 is approximately located on a side that is of the mounting groove 317 and that is opposite to the support surface 314 of the main shaft 31, and the mounting space 318 is connected to the mounting groove 317. An opening is provided on the groove bottom of the second part 3172 of the mounting groove 317, so that the mounting space 318 is connected to the second part 3172 of the mounting groove 317. The first arc surface 3122 may be provided with a notch, so that an opening is provided on the groove bottom of the first part 3171 of the mounting groove 317, and the mounting space 318 is connected to the first part 3171 of the mounting groove 317. A length extension direction of the mounting space 318 is parallel to the extension direction of the main shaft 31. The main shaft 31 may be further provided with a second notch 319, the second notch 319 is located on a side that is of the main shaft 31 and that is away from the first notch 316, and the second notch 319 connects the mounting space 318 to the external space of the main shaft 31. The second notch 319 may be formed on the main inner shaft 312 and/or the main outer shaft 311.

For example, the main shaft 31 further has a positioning slot 3110, at least one positioning slot 3110 is connected to the mounting space 318, and the positioning slot 3110 is formed by jointly limiting the main inner shaft 312 and the main outer shaft 311. There are one or more positioning slots 3110. When there are a plurality of positioning slots 3110, the plurality of positioning slots 3110 are spaced apart. For example, there may be two positioning slots 3110, and the two positioning slots 3110 may be arranged at two ends of the mounting space 318.

In some embodiments, the main shaft 31 may further have a second arc-shaped groove 3120, and the second arc-shaped groove 3120 may be formed by disposing the arc-shaped surface on the main inner shaft 312 opposite to the arc-shaped surface on the main outer shaft 311. Both sides of the second arc-shaped groove 3120 may extend to the support surface 314 of the main shaft 31, and some notches on the support surface 314 of the main shaft 31 are a part of the second arc-shaped groove 3120. In this case, the first arc-shaped groove 315 may be arranged by using the space of the main shaft 31 as much as possible. This helps improve space utilization of the main shaft 31 and reduce a thickness of the main shaft 31. The main inner shaft 312 is further provided with a third notch 3130, the third notch 3130 penetrates a side edge that is of the main inner shaft 312 and that is away from the first notch 316, and the third notch 3130 connects the second arc-shaped groove 3120 to the external space of the main shaft 31.

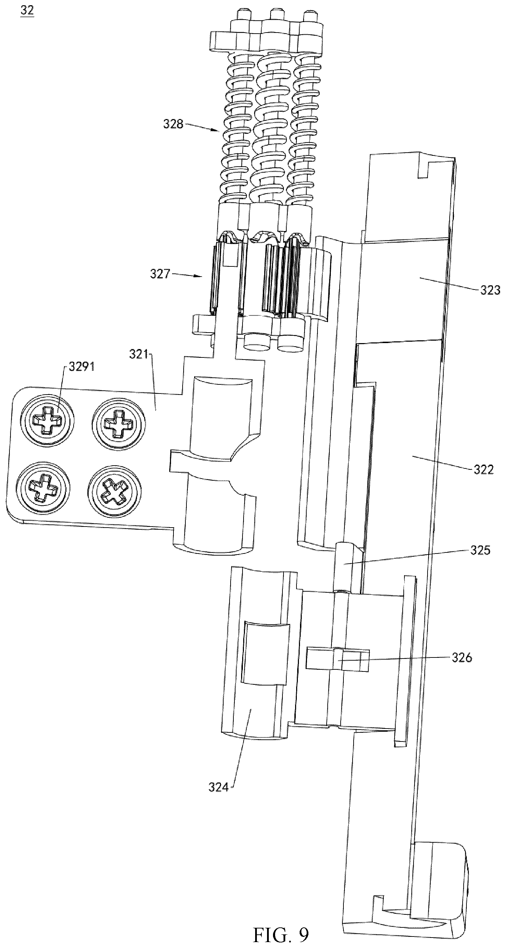

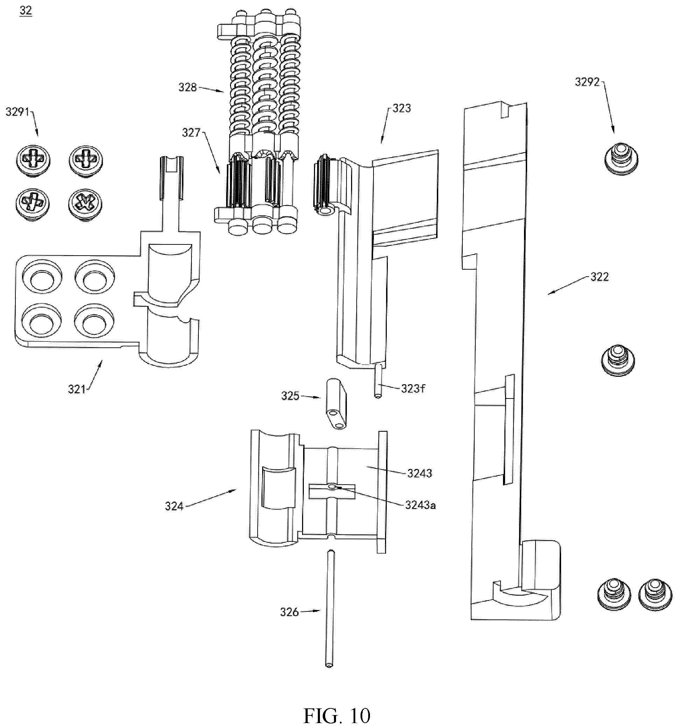

Refer to FIG. 9 and FIG. 10. FIG. 9 is a diagram of a structure of the bottom connection assembly 32 shown in FIG. 5. FIG. 10 is a diagram of a partial exploded structure of the bottom connection assembly 32 shown in FIG. 9.

In some embodiments, the bottom connection assembly 32 includes a rotation arm 321, a mounting bracket 322, a first connection arm 323, a second connection arm 324, a connection rod 325, a connection shaft 326, a synchronization assembly 327, a damping assembly 328, a first group of connectors 3291, and a second group of connectors 3292.

The rotation arm 321 may be connected to the first housing 1 via the first group of connectors 3291, and the first group of connectors 3291 may include one or more fasteners. The mounting bracket 322 may be connected to the second housing 2 via the second group of connectors 3292, and the second group of connectors 3292 may include one or more fasteners. Both the first connection arm 323 and the second connection arm 324 are connected to the mounting bracket 322, and the connection rod 325 may be connected to the first connection arm 323 and the second connection arm 324 via the connection shaft 326. The synchronization assembly 327 is connected to the rotation arm 321 and the first connection arm 323, and the damping assembly 328 is also connected to the rotation arm 321 and the first connection arm 323.

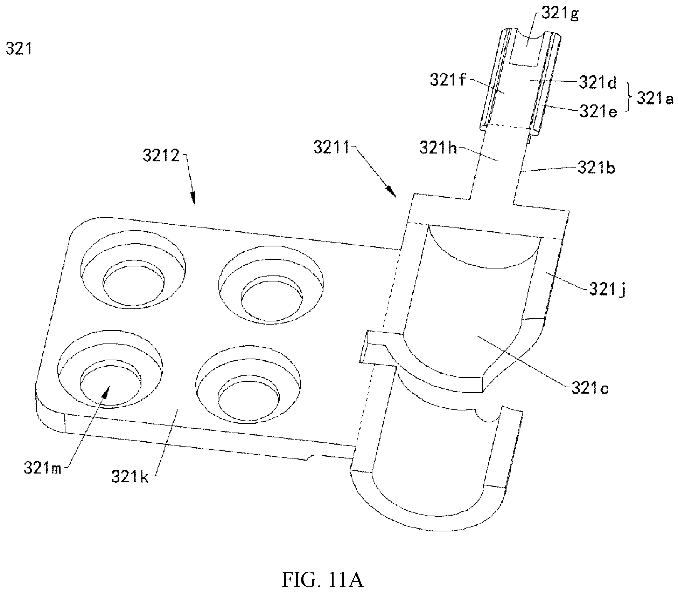

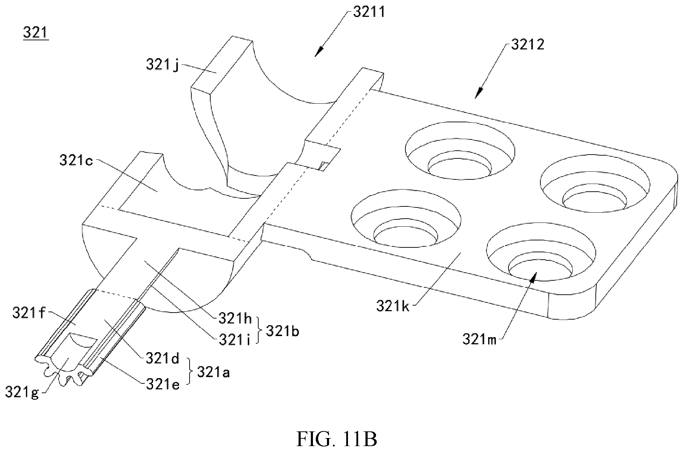

Refer to FIG. 11A and FIG. 11B. FIG. 11A is a diagram of a structure of the rotation arm 321 shown in FIG. 10. FIG. 11B is a diagram of a structure of the rotation arm 321 shown in FIG. 11A from another angle.

In some embodiments, the rotation arm 321 includes a first end 3211 and a second end 3212 connected to the first end 3211. The first end 3211 of the rotation arm 321 may be provided with a connection gear 321a, a connection rod 321b, and an arc-shaped arm 321c. The connection gear 321a may be an incomplete gear. The connection gear 321a includes a shaft part 321d and a tooth part 321e. The shaft part 321d of the connection gear 321a may be an incomplete shaft body, and the shaft part 321d of the connection gear 321a has a support surface 321f. The tooth part 321e of the connection gear 321a may be an incomplete tooth part, and the tooth part 321e of the connection gear 321a is disposed opposite to the support surface 321f of the connection gear 321a and disposed around the shaft part 321d. The shaft part 321d of the connection gear 321a further has a first arc-shaped surface 321g, two sides of the first arc-shaped surface 321g are connected to the support surface 321f of the connection gear 321a, and a middle part of the first arc-shaped surface 321g recesses in a direction toward the tooth part 321e of the connection gear 321a relative to the support surface 321f of the connection gear 321a. A central axis (not shown in the figure) of the first arc-shaped surface 321g is collinear with a central axis (not shown in the figure) of the connection gear 321a.

For example, one end of the connection rod 321b is fastened to the connection gear 321a, and the other end of the connection rod 321b is fastened to the arc-shaped arm 321c. The connection rod 321b has a support surface 321h and a second arc-shaped surface 321i. The support surface 321h of the connection rod 321b and the support surface 321f of the connection gear 321a may be disposed on a same plane. The second arc-shaped surface 321i of the connection rod 321b is disposed opposite to the support surface 321h of the connection rod 321b, and a central axis of the second arc-shaped surface 321i is collinear with the central axis of the first arc-shaped surface 321g. In this case, the second arc-shaped surface 321i of the connection rod 321b cooperates with the first arc-shaped surface 321g of the connection gear 321a, to form an equivalent arc-shaped arm. A central axis (not shown in the figure) of the arc-shaped arm is collinear with the central axis (not shown in the figure) of the connection gear 321a.

End faces of two sides of the arc-shaped arm 321c may be disposed on a same plane, to form a support surface 321j of the arc-shaped arm 321c, and the support surface 321j of the arc-shaped arm 321c and the support surface 321h of the connection rod 321b may be disposed on a same plane.

In some embodiments, the second end 3212 of the rotation arm 321 may be approximately plate-shaped. The second end 3212 of the rotation arm 321 has a support surface 321k, and the support surface 321k and the support surface 321j of the arc-shaped arm 321c may be disposed on a same plane. The second end 3212 of the rotation arm 321 may be provided with a plurality of connection holes 321m, and the plurality of connection holes 321m may be disposed at intervals from each other. The plurality of connection holes 321m are configured to implement a connection relationship between the second end 3212 of the rotation arm 321 and another structure.

The rotation arm 321 may be an integral structural member, to have high structural strength. For example, the rotation arm 321 may be formed by using a computer numerical control (computer numerical control, CNC) milling process. In some other embodiments, the rotation arm 321 may alternatively be formed by using a metal injection molding process. This is not strictly limited in embodiments of this application.

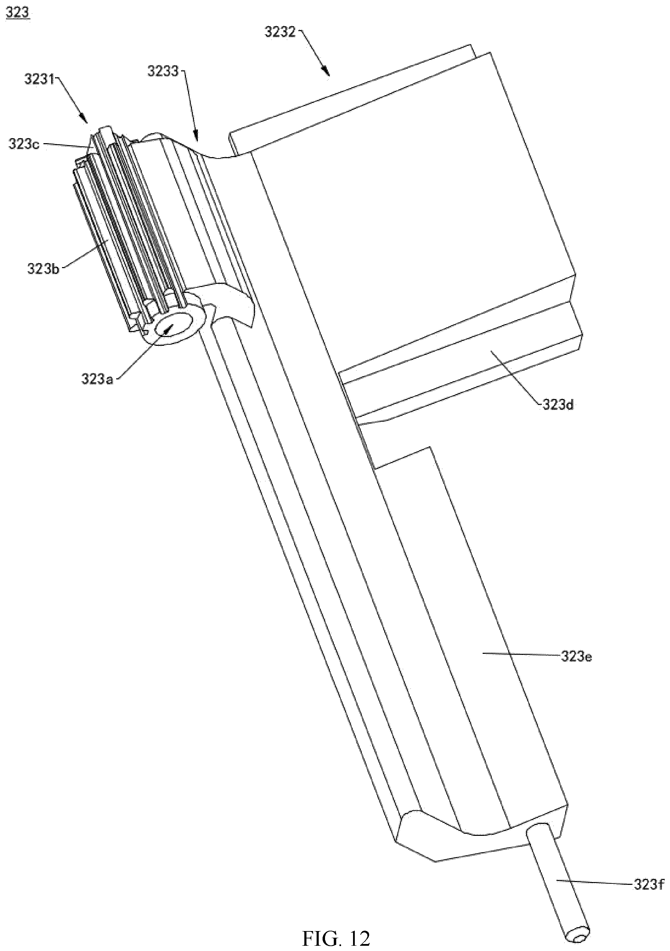

FIG. 12 is a diagram of a structure of the first connection arm 323 shown in FIG. 10.

In some embodiments, the first connection arm 323 includes a first end 3231 and a second end 3232. For example, the first end 3231 of the first connection arm 323 may be provided with a rotation shaft hole 323a, and the rotation shaft hole 323a penetrates the first end 3231 of the first connection arm 323. The first end 3231 of the first connection arm 323 is further provided with a plurality of engagement teeth 323b and a plurality of protrusions 323c. The plurality of engagement teeth 323b may be located in a middle part of the first end 3231 of the first connection arm 323 and approximately located on a side that is of the first end 3231 of the first connection arm 323 and that is opposite to the second end 3232 of the first connection arm 323, and the plurality of engagement teeth 323b jointly form a teeth part, so that the first end 3231 of the first connection arm 323 forms an incomplete gear. The plurality of protrusions 323c may be located on a side of the first end 3231 of the first connection arm 323, the plurality of protrusions 323c are spaced apart, the plurality of protrusions 323c are disposed around the rotation shaft hole 323a at the first end 3231 of the first connection arm 323, and the plurality of protrusions 323c form a cam surface.

For example, the second end 3232 of the first connection arm 323 may be provided with a sliding block 323d, a connection block 323e, and an insertion shaft 323f. The connection block 323e and the sliding block 323d are in a relatively fixed relationship, movement paths of the connection block 323e and the sliding block 323d are consistent, and an arrangement direction of the connection block 323e and the sliding block 323d may be parallel to an axial direction of the rotation shaft hole 323a at the first end 3231 of the first connection arm 323. The connection block 323e and the sliding block 323d may be disposed at intervals. Alternatively, in some other embodiments, the connection block 323e may be connected to the sliding block 323d. The insertion shaft 323f may be fastened to a side that is of the connection block 323e and that is opposite to the sliding block 323d, and an extension direction of the insertion shaft 323f is parallel to the axial direction of the rotation shaft hole 323a at the first end 3231 of the first connection arm 323.

For example, the first connection arm 323 further includes a connection segment 3233 connected between the first end 3231 and the second end 3232. Disposal of the connection segment 3233 of the first connection arm 323 makes a structure design of the first connection arm 323 more flexible, and can better meet a connection requirement and a shape requirement. The connection segment 3233 of the first connection arm 323 may be approximately strip-shaped, the connection segment 3233 may extend in the axial direction of the rotation shaft hole 323a at the first end 3231 of the first connection arm 323, the sliding block 323d is fastened to the connection segment 3233, and the connection block 323e is fastened to the connection segment 3233. Therefore, the connection block 323e may be fastened relative to the sliding block 323d via the connection segment 3233. In some other embodiments, the connection segment 3233, the sliding block 323d, and the connection block 323e of the first connection arm 323 may alternatively in another position relationship or connection relationship. This is not strictly limited in embodiments of this application.

The first connection arm 323 may be an integral structural member, to have high structural strength. For example, the first connection arm 323 may be formed by using a computer numerical control milling process. In some other embodiments, the first connection arm 323 may alternatively be formed by using a metal injection molding process. This is not strictly limited in embodiments of this application.

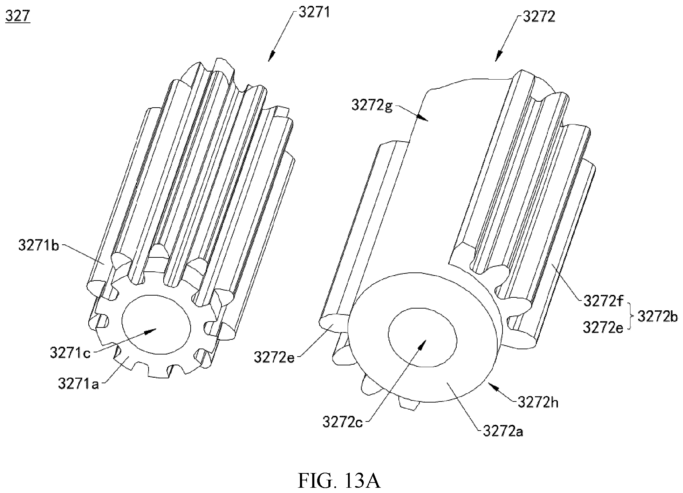

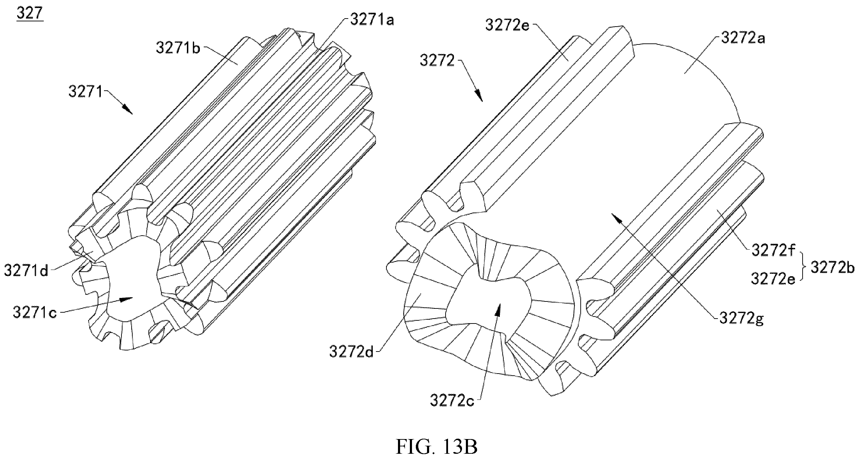

Refer to FIG. 13A and FIG. 13B. FIG. 13A is a diagram of a structure of the synchronization assembly 327 shown in FIG. 10. FIG. 13B is a diagram of a structure of the synchronization assembly 327 shown in FIG. 13A from another angle.

In some embodiments, the synchronization assembly 327 may include a plurality of synchronization gears. For example, the synchronization assembly 327 may include a first synchronization gear 3271 and a second synchronization gear 3272. The first synchronization gear 3271 may include a shaft part 3271a and a tooth part 3271b. The shaft part 3271a of the first synchronization gear 3271 is provided with a rotation shaft hole 3271c, an end surface of one side of the shaft part 3271a may be a plane, and an end surface of the other side of the shaft part 3271a may be a cam surface 3271d. The tooth part 3271b of the first synchronization gear 3271 is fastened around the shaft part 3271a, and the tooth part 3271b includes a plurality of engagement teeth. The first synchronization gear 3271 may be a complete gear, and the tooth part 3271b of the first synchronization gear 3271 is a complete tooth part.

The second synchronization gear 3272 may include a shaft part 3272a and a tooth part 3272b. The shaft part 3272a of the second synchronization gear 3272 is provided with a rotation shaft hole 3272c, an end surface of one side of the shaft part 3272a may be a plane, and an end surface of the other side of the shaft part 3272a may be a cam surface 3272d. The tooth part 3272b of the second synchronization gear 3272 is fastened around the shaft part 3272a, and the tooth part 3272b includes a plurality of engagement teeth. The second synchronization gear 3272 may be an incomplete gear, and the tooth part 3272b of the second synchronization gear 3272 may be an incomplete tooth part. For example, the tooth part 3272b may include a first tooth part 3272e and a second tooth part 3272f, and the first tooth part 3272e and the second tooth part 3272f are disposed at intervals. A first toothless area 3272g is formed between one side of the first tooth part 3272e and one side of the second tooth part 3272f, and a second toothless area 3272h is formed between the other side of the first tooth part 3272e and the other side of the second tooth part 3272f. In embodiments of this application, the incomplete gear is a gear including a tooth part area and a toothless area in an encircling direction of the gear. For example, as shown in FIG. 12, in an encircling direction of the engagement teeth 323b, an area in which the engagement teeth 323b exist is a tooth part area, and an area in which the engagement teeth 323b do not exist is a toothless area. For another example, as shown in FIG. 11B, the connection gear 321a is also an incomplete gear. In an encircling direction of the engagement teeth 321e, an area in which the engagement teeth 321e exist is a tooth part area, and an area in which the engagement teeth 321e do not exist, for example, an area of the support surface 321f, is a toothless area.

A pitch diameter of the second synchronization gear 3272 may be the same as or different from a pitch diameter of the first synchronization gear 3271. For example, the pitch diameter of the second synchronization gear 3272 is greater than the pitch diameter of the first synchronization gear 3271.

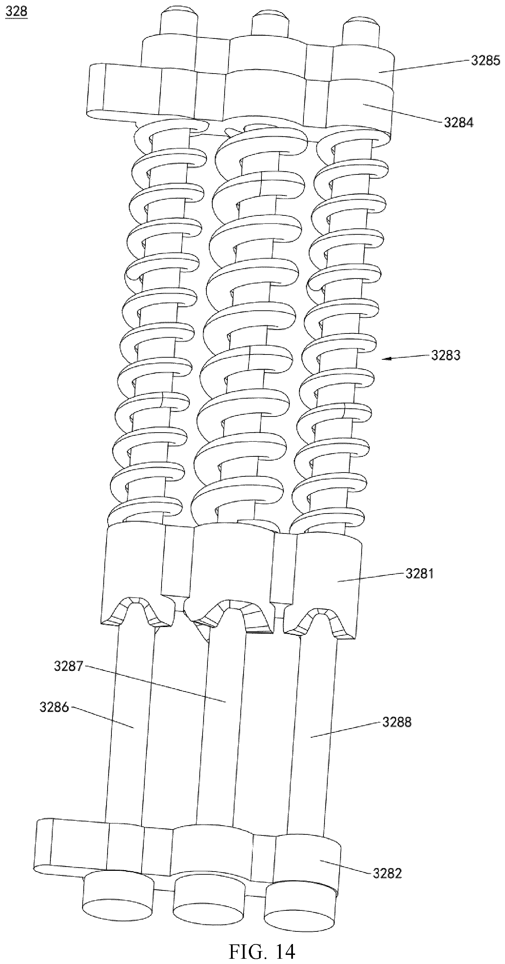

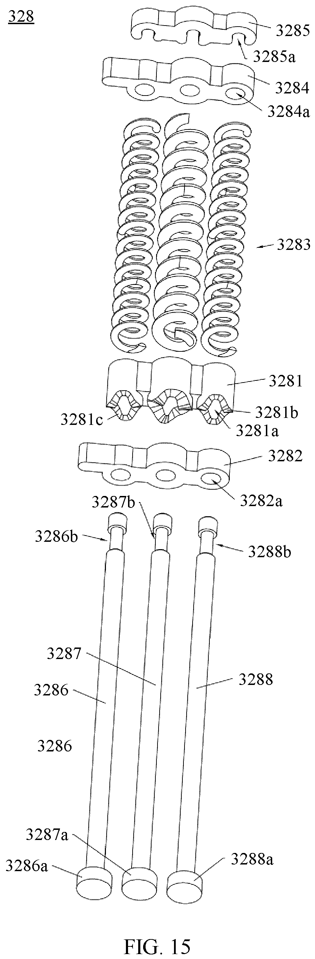

Refer to FIG. 14 and FIG. 15. FIG. 14 is a diagram of a structure of the damping assembly 328 shown in FIG. 10. FIG. 15 is a diagram of an exploded structure of the damping assembly 328 shown in FIG. 14.

In some embodiments, the damping assembly 328 includes a clamping member 3281, a first fastener 3282, an elastic member 3283, a second fastener 3284, a limiting member 3285, a first rotation shaft 3286, a second rotation shaft 3287, and a third rotation shaft 3288.

For example, the clamping member 3281 has three first through holes 3281a, and the three first through holes 3281a are provided at intervals. The clamping member 3281 includes three bump groups 3281b, the three bump groups 3281b are located on a same side on the clamping member 3281, and the three bump groups 3281b and the three first through holes 3281a are provided in a one-to-one correspondence. Each bump group 3281b includes a plurality of bumps, and the plurality of bumps are disposed at intervals around the corresponding first through hole 3281a, to form a cam surface 3281c on a side of the first through hole 3281a.

For example, the first fastener 3282 is located on a side of the clamping member 3281. The first fastener 3282 may be approximately plate-shaped. The first fastener 3282 has three second through holes 3282a, and the three second through holes 3282a are provided at intervals.

For example, the second fastener 3284 is located on a side that is of the clamping member 3281 and that is away from the first fastener 3282. The second fastener 3284 may be approximately plate-shaped. The second fastener 3284 has three third through holes 3284a, and the three third through holes 3284a are provided at intervals.

For example, the limiting member 3285 is located on a side that is of the second fastener 3284 and that is away from the clamping member 3281. The limiting member 3285 may be approximately plate-shaped. The limiting member 3285 has three clamping grooves 3285a provided at intervals, and each clamping groove 3285a extends to a side of the limiting member 3285. Arrangement shapes and arrangement spacings of the three clamping grooves 3285a, the three third through holes 3284a, the three second through holes 3282a, and the three first through holes 3281a may be the same or similar.

For example, the elastic member 3283 is located between the second fastener 3284 and the clamping member 3281. The elastic member 3283 includes three springs. In some other embodiments, the elastic member 3283 may alternatively be made of an elastic material like an elastic rubber. This is not strictly limited in this application.

For example, a limiting flange 3286a is disposed at one end of the first rotation shaft 3286, and a limiting clamping groove 3286b is provided at the other end of the first rotation shaft 3286. The first rotation shaft 3286 is inserted into the first fastener 3282, the clamping member 3281, the elastic member 3283, the second fastener 3284, and the limiting member 3285. The first rotation shaft 3286 passes through one second through hole 3282a of the first fastener 3282, one first through hole 3281a of the clamping member 3281, an inner space of one spring of the elastic member 3283, one third through hole 3284a of the second fastener 3284, and one clamping groove 3285a of the limiting member 3285. The limiting flange 3286a of the first rotation shaft 3286 is located on a side that is of the first fastener 3282 and that is opposite to the clamping member 3281, and the limiting flange 3286a of the first rotation shaft 3286 is configured to limit the first fastener 3282. The limiting member 3285 is clamped into the limiting clamping groove 3286b of the first rotation shaft 3286, and the limiting clamping groove 3286b of the first rotation shaft 3286 is used to limit the limiting member 3285, to limit the second fastener 3284 via the limiting member 3285. In some other embodiments, the first rotation shaft 3286 may alternatively limit the second fastener 3284 through welding, bonding, or in another manner.

A limiting flange 3287a is disposed at one end of the second rotation shaft 3287, and a limiting clamping groove 3287b is provided at the other end of the second rotation shaft 3287. The second rotation shaft 3287 is inserted into the first fastener 3282, the clamping member 3281, the elastic member 3283, the second fastener 3284, and the limiting member 3285. The second rotation shaft 3287 passes through another second through hole 3282a of the first fastener 3282, another first through hole 3281a of the clamping member 3281, an inner space of another spring of the elastic member 3283, another third through hole 3284a of the second fastener 3284, and another clamping groove 3285a of the limiting member 3285. The limiting flange 3287a of the second rotation shaft 3287 is located on a side that is of the first fastener 3282 and that is opposite to the clamping member 3281, and the limiting flange 3287a of the second rotation shaft 3287 is configured to limit the first fastener 3282. The limiting member 3285 is clamped into the limiting clamping groove 3287b of the second rotation shaft 3287, and the limiting clamping groove 3287b of the second rotation shaft 3287 is used to limit the limiting member 3285, to limit the second fastener 3284 via the limiting member 3285. In some other embodiments, the second rotation shaft 3287 may alternatively limit the second fastener 3284 through welding, bonding, or in another manner.

A limiting flange 3288a is disposed at one end of the third rotation shaft 3288, and a limiting clamping groove 3288b is provided at the other end of the third rotation shaft 3288. The third rotation shaft 3288 is inserted into the first fastener 3282, the clamping member 3281, the elastic member 3283, the second fastener 3284, and the limiting member 3285. The third rotation shaft 3288 passes through another second through hole 3282a of the first fastener 3282, another first through hole 3281a of the clamping member 3281, an inner space of another spring of the elastic member 3283, another third through hole 3284a of the second fastener 3284, and another clamping groove 3285a of the limiting member 3285. The limiting flange 3288a of the third rotation shaft 3288 is located on a side that is of the first fastener 3282 and that is opposite to the clamping member 3281, and the limiting flange 3288a of the third rotation shaft 3288 is configured to limit the first fastener 3282. The limiting member 3285 is clamped into the limiting clamping groove 3288b of the third rotation shaft 3288, and the limiting clamping groove 3288b of the third rotation shaft 3288 is used to limit the limiting member 3285, to limit the second fastener 3284 via the limiting member 3285. In some other embodiments, the third rotation shaft 3288 may alternatively limit the second fastener 3284 through welding, bonding, or in another manner.

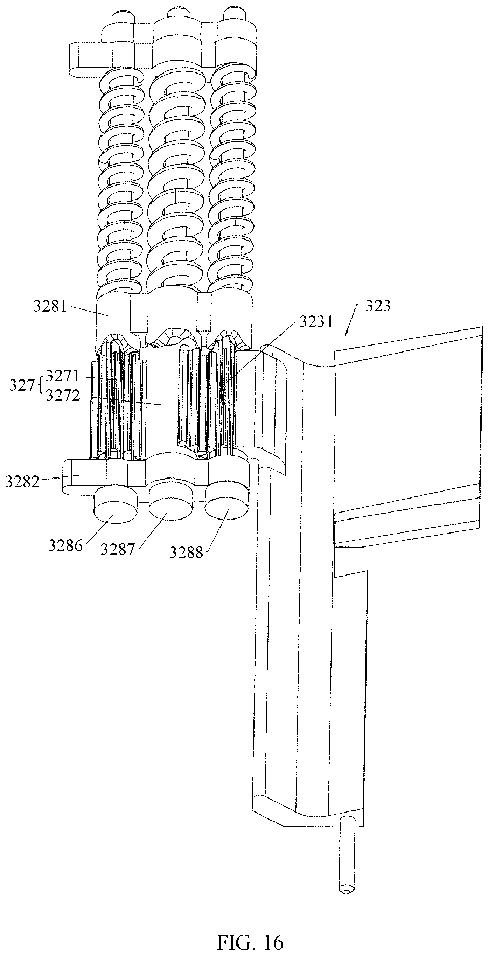

Refer to FIG. 12, FIG. 13B, FIG. 15, and FIG. 16. FIG. 16 is a diagram of a partial structure of the bottom connection assembly 32 shown in FIG. 9.

In some embodiments, the first synchronization gear 3271 of the synchronization assembly 327 is located between the clamping member 3281 and the first fastener 3282. The first rotation shaft 3286 passes through the rotation shaft hole 3271c of the first synchronization gear 3271, the cam surface 3271d of the first synchronization gear 3271 faces the cam surface 3281c of the clamping member 3281, and the cam surface 3271d and the cam surface 3281c cooperate with each other. The second synchronization gear 3272 of the synchronization assembly 327 is located between the clamping member 3281 and the first fastener 3282 and is engaged with the first synchronization gear 3271. The second rotation shaft 3287 passes through the rotation shaft hole 3272c of the second synchronization gear 3272, the cam surface 3272d of the second synchronization gear 3272 faces the cam surface 3281c of the clamping member 3281, and the cam surface 3272d and the cam surface 3281c o cooperate with each other. The first end 3231 of the first connection arm 323 is located between the clamping member 3281 and the first fastener 3282 and is engaged with the second synchronization gear 3272. The third rotation shaft 3288 passes through the rotation shaft hole 323a at the first end 3231 of the first connection arm 323, the cam surface of the first end 3231 of the first connection arm 323 faces the cam surface 3281c of the clamping member 3281, and the cam surface of the first end 3231 of the first connection arm 323 and the cam surface 3281c cooperate with each other.

After the synchronization assembly 327, the first connection arm 323, and the damping assembly 328 are assembled, the elastic member 3283 of the damping assembly 328 is in a compressed state. The first fastener 3282 is limited by limiting flanges of a plurality of rotation shafts (3286, 3287, and 3288), the limiting member 3285 is limited by limiting clamping grooves of a plurality of rotation shafts (3286, 3287, and 3288), and the second fastener 3284 is limited by the limiting member 3285. Therefore, elastic force generated by the elastic member 3283 drives the clamping member 3281 to move in a direction toward the first fastener 3282, or makes the clamping member 3281 to move in a direction toward the first fastener 3282. In this way, the clamping member 3281 abuts against the first synchronization gear 3271, the second synchronization gear 3272, and the first end 3231 of the first connection arm 323.

In some use states, the cam surface 3271d of the first synchronization gear 3271 is clamped to and cooperates with the cam surface 3281c of the clamping member 3281, the cam surface 3272d of the second synchronization gear 3272 is clamped to and cooperates with the cam surface 3281c of the clamping member 3281, the cam surface of the first end 3231 of the first connection arm 323 is clamped to and cooperates with the cam surface 3281c of the clamping member 3281, and the first synchronization gear 3271, the second synchronization gear 3272, the first end 3231 of the first connection arm 323, and the clamping member 3281 form a clamping structure. In some other use states, in comparison with the foregoing use states, the first synchronization gear 3271, the second synchronization gear 3272, and the first end 3231 of the first connection arm 323 rotate relative to the clamping member 3281, and the first synchronization gear 3271, the second synchronization gear 3272, the first end 3231 of the first connection arm 323, and the clamping member 3281 are gradually separated from the initial clamping structure and then gradually form another clamping structure. In a process of gradually detaching from the initial clamping structure, the elastic force of the elastic member 3283 forms damping force for preventing the first synchronization gear 3271, the second synchronization gear 3272, and the first end 3231 of the first connection arm 323 from rotating. In a process of gradually forming the another clamping structure, the elastic force of the elastic member 3283 can alternatively form force for helping drive the first synchronization gear 3271, the second synchronization gear 3272, and the first end 3231 of the first connection arm 323 to rotate.

It may be understood that, in embodiments of this application, when the rotation shaft of the damping assembly 328 is a through-type rotation shaft, that is, the rotation shaft penetrates the entire damping assembly 328, a quantity of rotation shafts of the damping assembly 328 may be equal to a quantity of synchronization gears of the synchronization assembly 327 plus one. For example, when the quantity of synchronization gears is two, the quantity of rotation shafts of the damping assembly 328 is three. When the quantity of synchronization gears is four, the quantity of rotation shafts of the damping assembly 328 is five. A quantity of first through holes 3281a, a quantity of second through holes 3282a, a quantity of third through holes 3284a, a quantity of clamping grooves 3285a, and a quantity of springs may be the same as a quantity of the rotation shafts. In some embodiments, the quantity of springs may alternatively be less than the quantity of rotation shafts.

In some other embodiments, the rotation shaft of the damping assembly 328 may alternatively be a split rotation shaft, that is, at least a part of the rotation shaft does not penetrate through the entire damping assembly 328, but is used in some areas of the damping assembly 328. For example, the damping assembly 328 may include two areas, and different quantities of rotation shafts may be disposed in the two areas. For example, three rotation shafts may be disposed in one area, two rotation shafts may be disposed in the other area, and the elastic member 3283 may be disposed in one of the two areas. A quantity of springs of the elastic member 3283 may be the same as or different from a quantity of rotation shafts in the corresponding area, provided that the elastic force generated by the elastic member 3283 can drive the clamping member 3281 to move.

In some other embodiments, the first synchronization gear 3271 and the second synchronization gear 3272 may alternatively be of a structure in which end surfaces on both sides are provided as cam surfaces. Correspondingly, a surface on a side that is of the first fastener 3282 and that faces the first synchronization gear 3271 and the second synchronization gear 3272 may be provided as a cam surface. Correspondingly, end surfaces on both sides of the first end 3231 of the first connection arm 323 may be provided as cam surfaces.

It can be learned from the foregoing that the damping assembly 328 in embodiments of this application may be implemented in a plurality of manners, provided that the damping assembly 328 can provide damping force in a rotation process of the first connection arm 323. A specific implementation structure of the damping assembly 328 is not strictly limited in embodiments of this application.

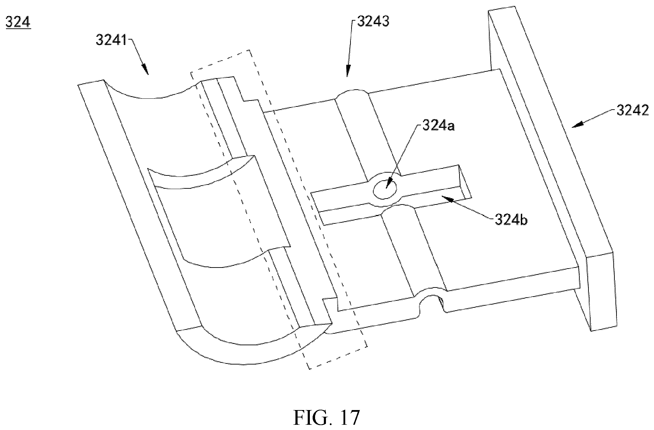

FIG. 17 is a diagram of a structure of the second connection arm 324 shown in FIG. 10.

In some embodiments, the second connection arm 324 includes a first end 3241 and a second end 3242. The first end 3241 of the second connection arm 324 may be a rotation end, and the first end 3241 of the second connection arm 324 may be provided with an arc-shaped arm. The second end 3242 of the second connection arm 324 may be a sliding end, and the second end 3242 of the second connection arm 324 may be provided with a sliding block. The second connection arm 324 may further include a connection segment 3243, and the connection segment 3243 of the second connection arm 324 is connected to the first end 3241 and the second end 3242. The connection segment 3243 of the second connection arm 324 may have a rotation shaft hole 324a. The connection segment 3243 of the second connection arm 324 may further have an avoidance space 324b, and the avoidance space 324b is connected to the rotation shaft hole 324a.

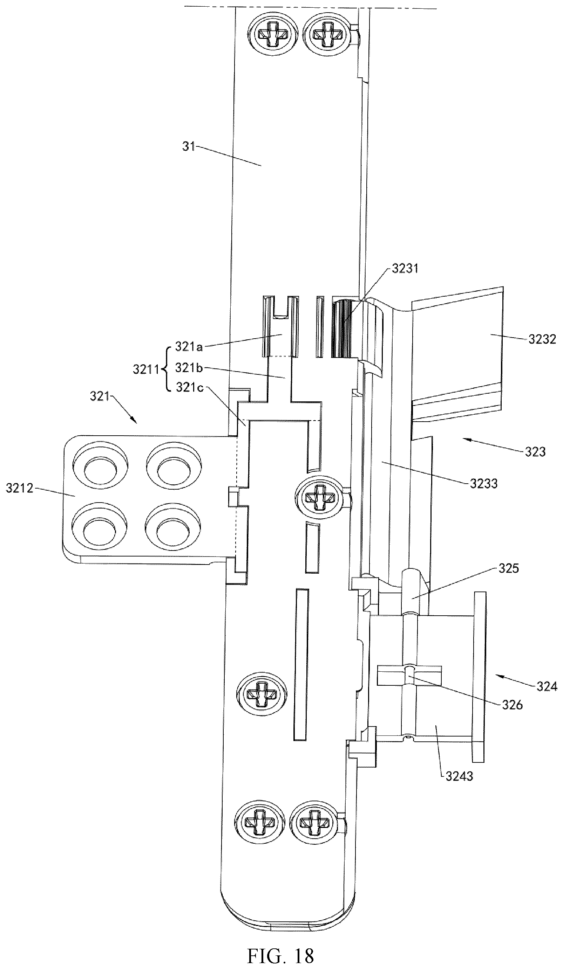

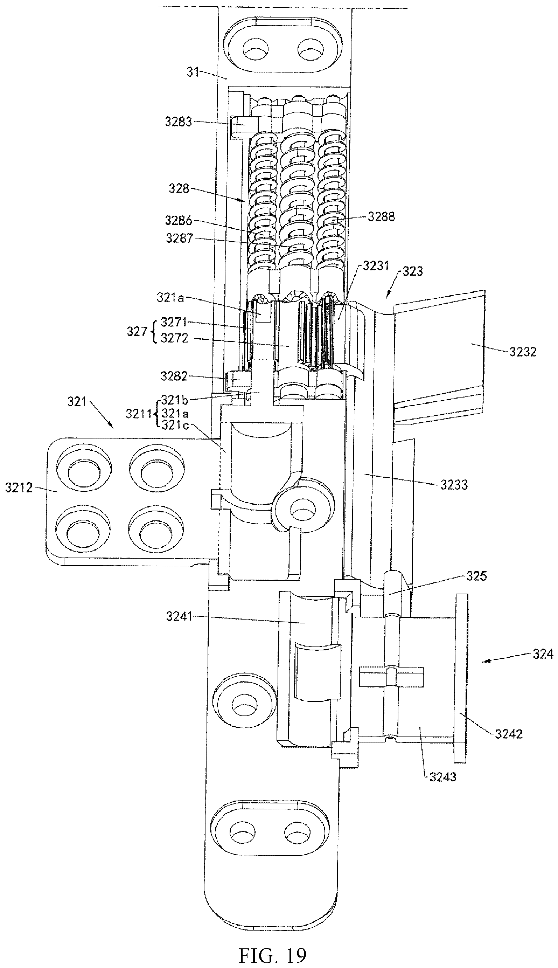

Refer to FIG. 7, FIG. 18, and FIG. 19. FIG. 18 is a diagram of an assembly structure of the main shaft 31 shown in FIG. 7 and a partial structure of the bottom connection assembly 32 shown in FIG. 9. FIG. 19 is a diagram of a partial structure of the structure shown in FIG. 18.

In some embodiments, the damping assembly 328, the synchronization assembly 327, and the first end 3231 of the first connection arm 323 are mounted in the mounting space 318 of the main shaft 31, and the second end 3232 of the first connection arm 323 and the connection segment 3233 of the first connection arm 323 are located in the external space of the main shaft 31 through the second notch 319. An overall position of the damping assembly 328 may be fastened relative to the main shaft 31. For example, the first fastener 3282 and the second fastener 3284 of the damping assembly 328 may be clamped to the positioning slot 3110 of the main shaft 31, to be fastened or substantially fastened relative to the main shaft 31. In this case, because the first synchronization gear 3271 is sleeved on the first rotation shaft 3286 of the damping assembly 328, the first synchronization gear 3271 is rotatably connected to the main shaft 31. Because the second synchronization gear 3272 is sleeved on the second rotation shaft 3287 of the damping assembly 328, the second synchronization gear 3272 is rotatably connected to the main shaft 31. Because the first end 3231 of the first connection arm 323 is sleeved on the third rotation shaft 3288 of the damping assembly 328, the first end 3231 of the first connection arm 323 is rotatably connected to the main shaft 31.

In this embodiment, the damping assembly 328, the synchronization assembly 327, and the first connection arm 323 are assembled into a modular structure. This improves integration of components, simplifies a mounting process of the foldable assembly 3, and reduces costs. In addition, through a modular structure design, the damping assembly 328 can provide damping force for the synchronization assembly 327 and the first connection arm 323. In addition, after the damping assembly 328 is mounted on the main shaft 31, the synchronization assembly 327 and the first connection arm 323 are rotatably connected to the main shaft 31 via the rotation shaft of the damping assembly 328, and there is no need to additionally dispose a rotation structure (for example, a fitting structure between the rotation shaft and the rotation groove) configured to implement rotatable connection between the synchronization assembly 327 and the first connection arm 323, and the main shaft 31. This simplifies a structure of the foldable assembly 3, and reduces costs of the foldable assembly 3.

It may be understood that, in some other embodiments, the synchronization assembly 327, the first connection arm 323, and the damping assembly 328 may not form a modular structure, and the damping assembly 328 still provides damping force for the synchronization assembly 327 and/or the first connection arm 323. The synchronization assembly 327 and the first connection arm 323 implement rotatable connection to the main shaft 31 via another structure, for example, by disposing rotation shafts by the synchronization assembly 327 and the first connection arm 323, or by inserting an external rotation shaft. This is not strictly limited in embodiments of this application.

In some embodiments, the first end 3211 of the rotation arm 321 is mounted on the main shaft 31. For example, the arc-shaped arm 321c at the first end 3211 of the rotation arm 321 is mounted in the first arc-shaped groove 315 of the main shaft 31, the connection rod 321b at the first end 3211 of the rotation arm 321 is mounted on the first part 3171 of the mounting groove 317 of the main shaft 31, and the connection gear 321a at the first end 3211 of the rotation arm 321 is mounted on the second part 3172 of the mounting groove 317 of the main shaft 31. The second end 3212 of the rotation arm 321 is located outside the main shaft 31 through the first notch 316.

The arc-shaped arm 321c at the first end 3211 of the rotation arm 321 cooperates with the first arc-shaped groove 315 of the main shaft 31, so that the first end 3211 of the rotation arm 321 is rotatably connected to the main shaft 31 through a virtual shaft. In some other embodiments, the first end 3211 of the rotation arm 321 may alternatively be rotatably connected to the main shaft 31 through a solid shaft.

Cooperation between the connection rod 321b at the first end 3211 of the rotation arm 321, the connection gear 321a, and the mounting groove 317 of the main shaft 31 makes the connection rod 321b and the connection gear 321a at the first end 3211 of the rotation arm 321 to better rotate relative to the main shaft 31, and can prevent the connection gear 321a from tilting, to improve reliability of connection between the first end 3211 of the rotation arm 321 and the main shaft 31.

The connection gear 321a at the first end 3211 of the rotation arm 321 is engaged with the first synchronization gear 3271 of the synchronization assembly 327. In this case, the first end 3211 of the rotation arm 321 is engaged with the first end 3231 of the first connection arm 323 via the first synchronization gear 3271 and the second synchronization gear 3272 of the synchronization assembly 327, so that a rotation action of the rotation arm 321 relative to the main shaft 31 and a rotation action of the first connection arm 323 relative to the main shaft 31 are synchronized, that is, the rotation arm 321 and first connection arm 323 are synchronously close to each other or away from each other. In addition, the damping assembly 328 can further provide damping force for the rotation arm 321 via the first synchronization gear 3271, so that structure integration of the foldable assembly 3 is high.

It may be understood that, in some other embodiments, when the synchronization assembly 327 and the damping assembly 328 are not assembled into a modular structure, that is, when the synchronization assembly 327 and the damping assembly 328 are separated, the connection gear 321a at the first end 3211 of the rotation arm 321 may still be connected to the damping assembly 328 via a gear with a cam surface, so that the damping assembly 328 can provide damping force for the rotation arm 321.

In some embodiments, the first end 3241 of the second connection arm 324 is mounted in the second arc-shaped groove 3120 of the main shaft 31, and the connection segment 3243 of the second connection arm 324 and the second end 3242 of the second connection arm 324 are located in the external space of the main shaft 31. The first end 3241 of the second connection arm 324 cooperates with the second arc-shaped groove 3120 of the main shaft 31, so that the first end 3241 of the second connection arm 324 is rotatably connected to the main shaft 31 through a virtual shaft. In some other embodiments, the first end 3241 of the second connection arm 324 may alternatively be rotatably connected to the main shaft 31 through a solid shaft.

In some embodiments, as shown in FIG. 10 and FIG. 18, the insertion shaft 323f of the first connection arm 323 is inserted into one end of the connection rod 325, to rotatably connect the connection rod 325. The connection shaft 326 is inserted into the rotation shaft hole 3243a of the connection segment 3243 of the second connection arm 324, the connection shaft 326 is further inserted into the other end of the connection rod 325, and the second connection arm 324 is rotatably connected to the connection rod 325.

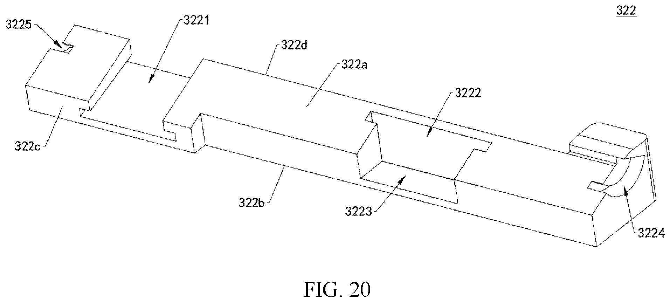

FIG. 20 is a diagram of a structure of the mounting bracket 322 shown in FIG. 10.

In some embodiments, the mounting bracket 322 may have a first surface 322a, a second surface 322b, a third surface 322c, and a fourth surface 322d. The first surface 322a and the second surface 322b are disposed opposite to each other, the third surface 322c and the fourth surface 322d are disposed opposite to each other. The mounting bracket 322 may include a first sliding slot 3221, a second sliding slot 3222, an avoidance groove 3223, a first rotation groove 3224, and a second rotation groove 3225. An extension direction of the first sliding slot 3221 is not parallel to an extension direction of the second sliding slot 3222. Openings that are at two ends of the first sliding slot 3221 and that are arranged in the extension direction of the first sliding slot 3221 may be respectively located on the first surface 322a and the second surface 322b. Openings that are at two ends of the second sliding slot 3222 and that are arranged in the extension direction of the second sliding slot 3222 may be respectively located on the third surface 322c and the fourth surface 322d.

When a structure like a sliding block is mounted in the first sliding slot 3221, the sliding block may slide relative to the mounting bracket 322 in the extension direction of the first sliding slot 3221. When a structure like a sliding block is mounted in the second sliding slot 3222, the sliding block may slide relative to the mounting bracket 322 in the extension direction of the second sliding slot 3222. When projection is performed in a direction from one end of the mounting bracket 322 to the other end, the extension direction of the first sliding slot 3221 intersects the extension direction of the second sliding slot 3222. The first sliding slot 3221 may penetrate two sides of the mounting bracket 322. The second sliding slot 3222 may be disposed close to one side of the mounting bracket 322, and the avoidance groove 3223 is connected to the second sliding slot 3222 and penetrates the other side of the mounting bracket 322.

The first rotation groove 3224 and the second rotation groove 3225 may be respectively located at the two ends of the mounting bracket 322. Both the first rotation groove 3224 and the second rotation groove 3225 are arc-shaped grooves, and center lines of the first rotation groove 3224 and the second rotation groove 3225 coincide. The first rotation groove 3224 may extend from the first surface 322a to the inside of the mounting bracket 322.

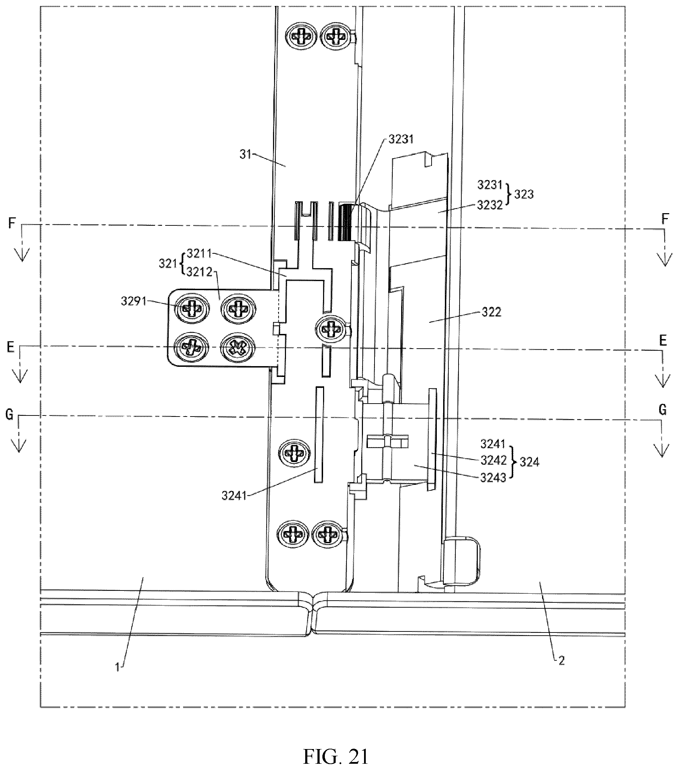

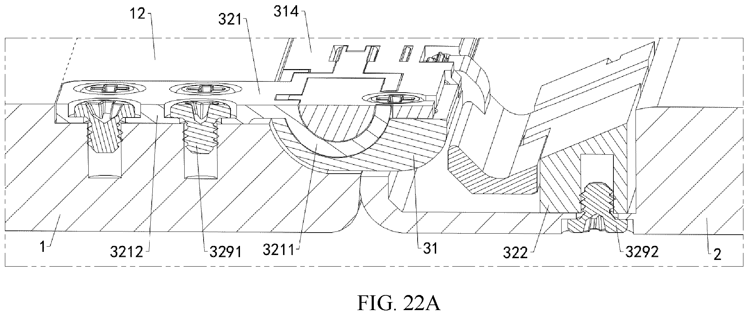

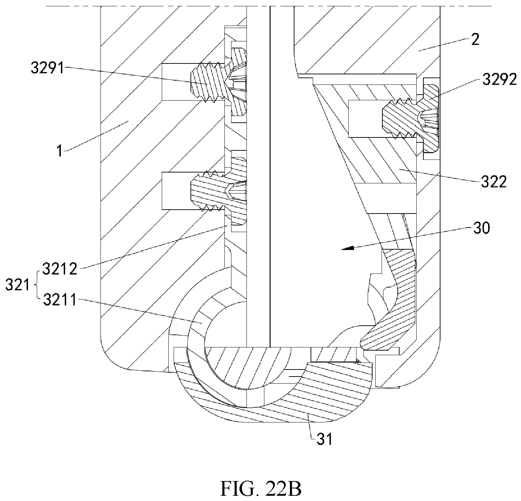

Refer to FIG. 21, FIG. 22A, and FIG. 22B. FIG. 21 is a diagram of a partial structure of the foldable apparatus 10 shown in FIG. 3. FIG. 22A is a diagram of a cross-sectional structure of the structure shown in FIG. 21 cut along E-E. FIG. 22B is a diagram of a cross-sectional structure of the structure shown in FIG. 22A in another use state.

In some embodiments, the first end 3211 of the rotation arm 321 is rotatably connected to the main shaft 31, the second end 3212 of the rotation arm 321 is fastened to the first housing 1, the first housing 1 and the second end 3212 of the rotation arm 321 maintain in a same movement state, and the first housing 1 may rotate relative to the main shaft 31 via the rotation arm 321. That is, the first housing 1 is rotatably connected to the main shaft 31, and a rotation center is a rotation center of rotation of the rotation arm 321 relative to the main shaft 31.

In this embodiment, the foldable apparatus 10 implements connection between the first housing 1 and the main shaft 31 via the rotation arm 321. A connection relationship is simple, a quantity of components is small, and the components are easy to manufacture and assemble. This facilitates mass production, to reduce costs of the foldable apparatus 10. In addition, it is easy to accurately control a movement path of the first housing 1. This helps implement accurate control of a movement form of the foldable apparatus 10.

The second end 3212 of the rotation arm 321 may be fastened to the first housing 1 via the first group of connectors 3291. In some other embodiments, the second end 3212 of the rotation arm 321 may alternatively be fastened to the first housing 1 through clamping, bonding, or another connection manner. This is not strictly limited in this application.

For example, the mounting bracket 322 is fastened to the second housing 2, and the second housing 2 and the mounting bracket 322 maintain in a same movement state. For example, the mounting bracket 322 may be fastened to the second housing 2 via the second group of connectors 3292. In some other embodiments, the mounting bracket 322 may alternatively be fastened to the second housing 2 through clamping, bonding, or another connection manner. This is not strictly limited in this application.

In this embodiment, in a process in which the first housing 1 moves relative to the second housing 2, the rotation arm 321 rotates relative to the main shaft 31, and the mounting bracket 322 moves relative to the main shaft 31.

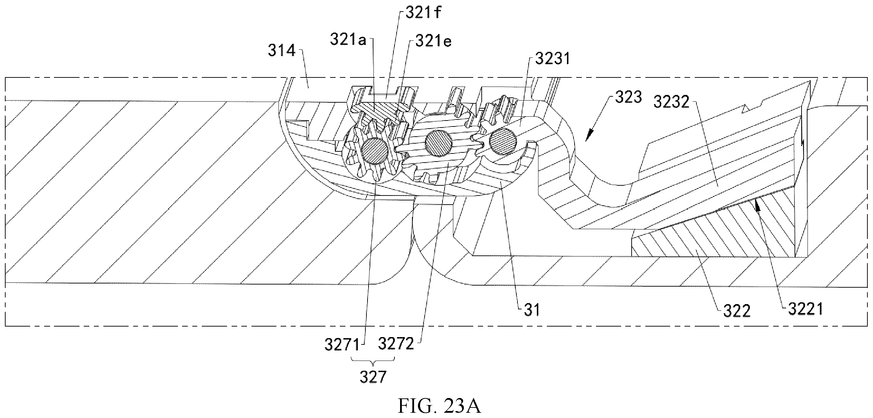

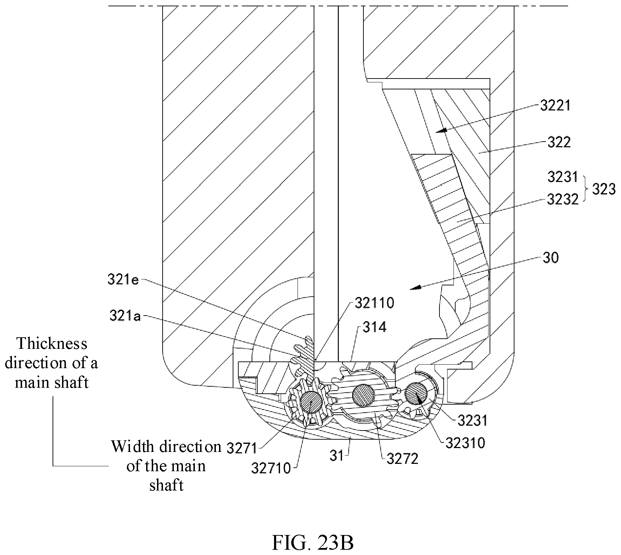

Refer to FIG. 21, FIG. 23A, and FIG. 23B, FIG. 23A is a diagram of a cross-sectional structure of the structure shown in FIG. 21 cut along F-F. FIG. 23B is a diagram of a cross-sectional structure of the structure shown in FIG. 23A in another use state.

In some embodiments, the first end 3231 of the first connection arm 323 is rotatably connected to the main shaft 31, and the second end 3232 of the first connection arm 323 is slidably connected to the mounting bracket 322. The sliding block 323d (referring to FIG. 12) at the second end 3232 of the first connection arm 323 may be mounted in the first sliding slot 3221 of the mounting bracket 322 and can slide relative to the mounting bracket 322 in the extension direction of the first sliding slot 3221. In some other embodiments, a sliding slot may also be provided at the second end 3232 of the first connection arm 323, a sliding block is disposed on the mounting bracket 322, and the sliding slot cooperates with the sliding block, to implement sliding connection between the second end 3232 of the first connection arm 323 and the mounting bracket 322. A specific structure for implementing sliding connection between the second end 3232 of the first connection arm 323 and the mounting bracket 322 is not strictly limited in embodiments of this application.

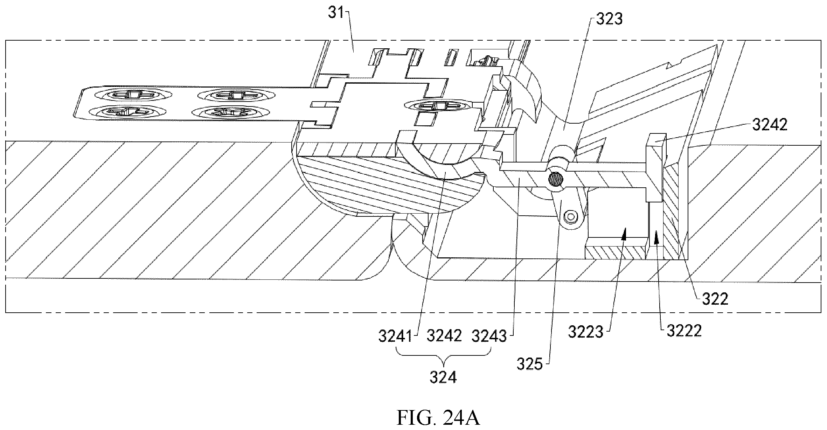

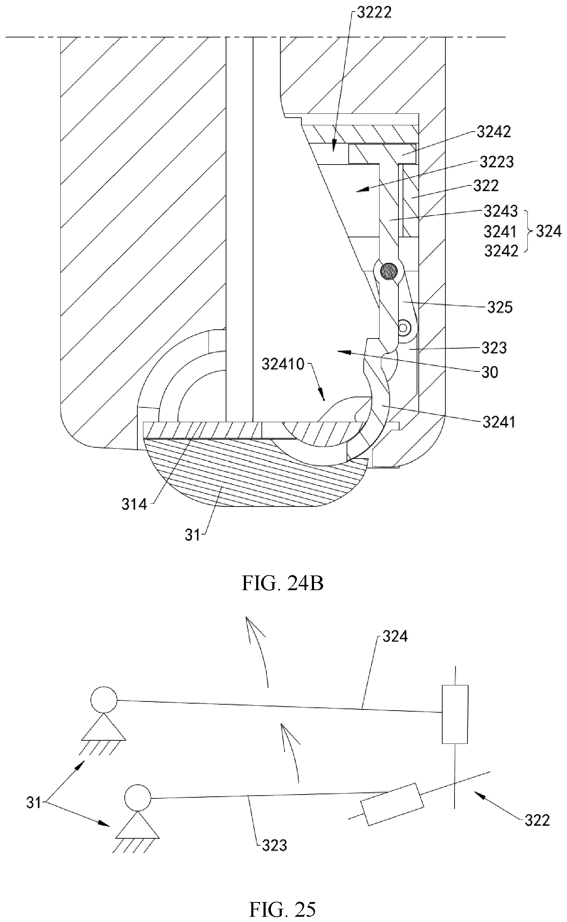

Refer to FIG. 21, FIG. 24A, and FIG. 24B, FIG. 24A is a diagram of a cross-sectional structure of the structure shown in FIG. 21 cut along G-G. FIG. 24B is a diagram of a cross-sectional structure of the structure shown in FIG. 24A in another use state.

In some embodiments, the first end 3241 of the second connection arm 324 is rotatably connected to the main shaft 31, and the second end 3242 of the second connection arm 324 is slidably connected to the mounting bracket 322. The sliding block at the second end 3242 of the second connection arm 324 may be mounted in the second sliding slot 3222 of the mounting bracket 322 and can slide relative to the mounting bracket 322 in the extension direction of the second sliding slot 3222. In some other embodiments, a sliding slot may also be provided at the second end 3242 of the second connection arm 324, a sliding block is disposed on the mounting bracket 322, and the sliding slot cooperates with the sliding block, to implement sliding connection between the second end 3242 of the second connection arm 324 and the mounting bracket 322. A specific structure for implementing sliding connection between the second end 3242 of the second connection arm 324 and the mounting bracket 322 is not strictly limited in embodiments of this application. The connection segment 3243 of the second connection arm 324 may be at least partially located in the avoidance groove 3223 of the mounting bracket 322.

Refer to FIG. 23A to FIG. 24B and FIG. 25. FIG. 25 is a diagram of a mechanism in a case in which the first connection arm 323, the second connection arm 324, and the mounting bracket 322 shown in FIG. 21 move relative to each other.

In this embodiment, the first end 3231 of the first connection arm 323 is rotatably connected to the main shaft 31, and the second end 3232 of the first connection arm 323 is slidably connected to the mounting bracket 322, to form a link-sliding block mechanism. The first end 3241 of the second connection arm 324 is rotatably connected to the main shaft 31, and the second end 3242 of the second connection arm 324 is slidably connected to the mounting bracket 322, to form a link-sliding block mechanism.

In addition, a rotation center 32310 of the first end 3231 of the first connection arm 323 (namely, a rotation center of the first connection arm 323 rotating relative to the main shaft 31) may be located in the main shaft 31, for example, located below the support surface 314 of the main shaft 31. A rotation center 32410 of the first end 3241 of the second connection arm 324 (namely, a rotation center of the second connection arm 324 rotating relative to the main shaft 31) may be located outside the main shaft 31, for example, located above the support surface 314 of the main shaft 31. The rotation center 32410 of the first end 3241 of the second connection arm 324 does not coincide with the rotation center 32310 of the first end 3231 of the first connection arm 323. Because the flexible display 20 is located above the main shaft 31, the rotation center 32410 of the first end 3241 of the second connection arm 324 is closer to the flexible display than the rotation center 32310 of the first end 3231 of the first connection arm 323.

In addition, the extension direction of the first sliding slot 3221 of the mounting bracket 322 is not parallel to the extension direction of the second sliding slot 3222, and a sliding direction of the second end 3232 of the first connection arm 323 relative to the mounting bracket 322 is not parallel to a sliding direction of the second end 3242 of the second connection arm 324 relative to the mounting bracket 322.

Therefore, in this embodiment, through cooperation of the double-link-sliding block mechanism, connection between the second housing 2 and the main shaft 31 can be implemented, and the second housing 2 can move relative to the main shaft 31. A quantity of components is small, a cooperation relationship and a cooperation position are simple, and the components are easy to manufacture and assemble. This facilitates mass production, to reduce costs of the foldable apparatus 10. In addition, because the main shaft 31 links the mounting bracket 322 via the first connection arm 323 and the second connection arm 324, a movement path of the second housing 2 is accurate. This helps implement accurate control of a movement form of the foldable apparatus 10. In addition, the foldable apparatus 10 has a good mechanism tensile resistance capability and a good mechanism extrusion resistance capability.

In addition, in this embodiment, the extension directions of the first sliding slot 3221 and the second sliding slot 3222 are appropriately designed, so that angles at which the first connection arm 323 and the second connection arm 324 rotate relative to the main shaft 31 are not greater than 90°. Compared with the conventional solution, this solution can effectively reduce a rotation angle of the second connection arm 324. In this way, a wall thickness of a local structure (for example, a structure in a dashed box of the second connection arm 324 shown in FIG. 17) of the second connection arm 324 may be large, and a wall thickness design meets a structural strength requirement, so that structural reliability of the second connection arm 324 is improved. In addition, because rotation angles of the first connection arm 323 and the second connection arm 324 are small, a thinning design performed on some components in the electronic device 100 because rotation of the first connection arm 323 and the second connection arm 324 needs to be avoided can be effectively avoided. This improves reliability of an overall structure of the electronic device 100.

With reference to FIG. 22A to FIG. 24B, in this embodiment, the foldable assembly 3 of the foldable apparatus 10 is of an asymmetric structure. The first housing 1 is rotatably connected to the main shaft 31 via the rotation arm 321, and the second housing 2 is movably connected to the main shaft 31 via the first connection arm 323, the second connection arm 324, and the mounting bracket 322, to implement relative movement between the first housing 1 and the second housing 2. The foldable assembly 3 has a small quantity of parts, simple composition, and low costs.

In addition, the first housing 1 is rotatably connected to the main shaft 31 via the rotation arm 321. After the first housing 1 rotates relative to the main shaft 31 to the folded state, no concave space used to accommodate the flexible display 20 is reserved at a joint between the first housing 1 and the main shaft 31. The second housing 2 is connected to the main shaft 31 via the first connection arm 323 and the second connection arm 324, for example, connected to the main shaft 31 via the double-link-sliding block mechanism. After the second housing 2 rotates relative to the main shaft 31 to the folded state, a concave space used to accommodate the flexible display 20 is reserved at a joint between the second housing 2 and the main shaft 31. Therefore, when the first housing 1 and the second housing 2 are folded relative to each other to the folded state, an accommodation space 30 offset toward the second housing 2 is formed between the first housing 1 and the second housing 2 and inside the foldable assembly 3. Based on a shape of the accommodation space 30 offset toward one side, compared with a symmetric space of the conventional foldable electronic device 100, the accommodation space 30 can reduce bending positions of a part of the flexible display 20 accommodated in the accommodation space 30. This helps reduce a risk of damaging the flexible display 20, improves reliability of the flexible display 20, and prolongs a service life of the flexible display 20. For a specific shape change of the flexible display 20 in the unfolded state and the folded state, refer to related descriptions in the following embodiments.

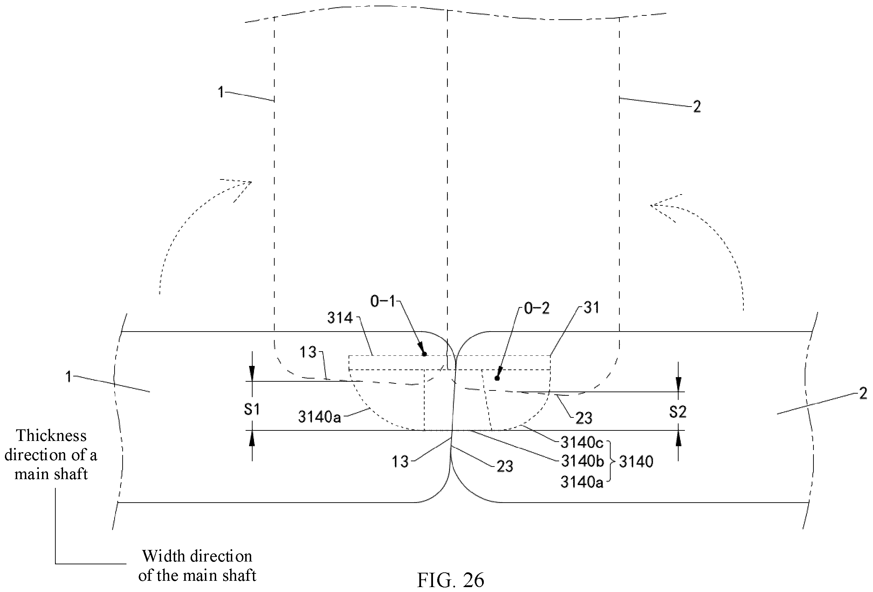

FIG. 26 is a diagram of a position relationship between the first housing 1, the second housing 2, and the main shaft 31 shown in FIG. 21.

With reference to the foregoing descriptions, it can be learned that the foldable assembly 3 is of an asymmetric structure, the first housing 1 is rotatably connected to the main shaft 31, and the second housing 2 is movably connected to the main shaft 31. In a process in which the first housing 1 and the second housing 2 move relative to each other, movement paths of the first housing 1 and the second housing 2 are asymmetric, and movement strokes of the first housing 1 and the second housing 2 relative to the main shaft 31 are asymmetric. The movement path of the first housing 1 relative to the main shaft 31 is in a circular arc shape, and the movement path of the second housing 2 relative to the main shaft 31 is in a spline curve shape.

As shown in FIG. 26, in a process in which the first housing 1 and the second housing 2 move relative to each other, the first housing 1 may rotate around a first rotation center O-1 relative to the main shaft 31, the second housing 2 may rotate approximately around a second rotation center O-2 relative to the main shaft 31, and the second rotation center O-2 is lower than the first rotation center O-1. In a process in which the first housing 1 and the second housing 2 move from the unfolded state (corresponding to a solid line position) to the folded state (corresponding to a dashed line position), a stroke of the first housing 1 for moving to the upper side of the support surface 314 of the main shaft 31 is large, and a stroke of the second housing 2 for moving to the upper side the support surface 314 of the main shaft 31 is small. With reference to FIG. 22B, FIG. 23B, and FIG. 24B, when the second housing 2 is in the folded state, the accommodation space 30 inside the second housing 2 and the foldable assembly 3 is large, to better accommodate the flexible display 20.

For example, as shown in FIG. 26, the main shaft 31 further includes an outer surface 3140, and the outer surface 3140 of the main shaft 31 is disposed opposite to the support surface 314 of the main shaft 31, that is, disposed opposite to the flexible display 20. When the first housing 1 and the second housing 2 are unfolded relative to each other to the unfolded state, the first housing 1 and the second housing 2 are spliced and jointly shield the outer surface 3140 of the main shaft 31. When the first housing 1 and the second housing 2 are folded relative to each other to the folded state, a part of the outer surface 3140 of the main shaft 31 is exposed relative to the first housing 1 and the second housing 2, and edges on two sides of the outer surface 3140 of the main shaft 31 are shielded by the first housing 1 and the second housing 2.

In this embodiment, when the first housing 1 and the second housing 2 are in the unfolded state, the two housings are spliced with each other and jointly shield the main shaft 31, so that the electronic device 100 has no obvious broken structure or gap at a joint between the two housings, and appearance integrity of the electronic device 100 is good. When the first housing 1 and the second housing 2 are in the folded state, the two housings surround edges on two sides of the main shaft 31, so that there is no obvious section structure or gap at joints between the two housings and the main shaft 31, and appearance integrity of the electronic device 100 is good. Therefore, when the electronic device 100 is in the unfolded state or the folded state, the electronic device 100 has good appearance integrity, and external sundries are difficult to enter the inner side of the foldable assembly 3. This helps improve reliability of the electronic device 100.

It should be noted that, with reference to FIG. 1 and FIG. 26, when the first housing 1 and the second housing 2 are in the unfolded state, a case in which the first housing 1 and the second housing 2 are spliced may include a case in which the first housing 1 and the second housing 2 partially or completely abut against each other, or include a case in which there is a small gap between the first housing 1 and the second housing 2. In this embodiment, through splicing of the first housing 1 and the second housing 2, an angle at which the first housing 1 and the second housing 2 are unfolded relative to each other can be limited to some extent, to stop an unfolding action of the first housing 1 and the second housing 2, and prevent the electronic device 100 from being overfolded in an unfolding process. Therefore, it is ensured that the flexible display 20 is in the unfolded state, so that the flexible display 20 can have a maximum width size when being used by the user. In addition, force applied on the flexible display 20 can be further reduced, and reliability of the flexible display 20 and the electronic device 100 can be improved.

With reference to FIG. 2 and FIG. 26, when the first housing 1 and the second housing 2 are in the folded state, the first housing 1 and the second housing 2 can be completely folded. It should be noted that, that the first housing 1 and the second housing 2 are folded may include a case in which the first housing 1 and the second housing 2 partially or completely abut against each other, or may include a case in which there is a small gap between the first housing 1 and the second housing 2. In this embodiment, a space for accommodating the flexible display 20 is reserved only in a middle part between the first housing 1 and the second housing 2, and there is no large gap at an edge, to improve a beautification degree of the housing and the electronic device 100, prevent a foreign body outside the electronic device 100 from entering the electronic device 100 in the folded state, and improve reliability of the electronic device 100.

For example, as shown in FIG. 26, the outer surface 3140 of the main shaft 31 includes a first area 3140a, a second area 3140b, and a third area 3140c. The second area 3140b is connected between the first area 3140a and the third area 3140c, the first area 3140a is disposed close to the first housing 1, and the third area 3140c is disposed close to the second housing 2. The first area 3140a may be a circular-arc-shaped surface, and a center of the circular-arc-shaped surface may coincide with the first rotation center O-1 of the first housing 1, so that a rotation action of the first housing 1 can be avoided in a case of a good appearance. This ensures movement reliability of the mechanism. The third area 3140c may be a curved surface, a cross section of the curved surface in a width direction of the main shaft 31 is a spline curve, and the spline curve may adapt to the movement path of the second housing 2 relative to the main shaft 31, so that a rotation action of the second housing 2 can be avoided in a case of a good appearance. This ensures movement reliability of the mechanism. The second area 3140b may be a plane, transition between the second area 3140b and the first area 3140a is smooth, and transition between the second area 3140b and the third area 3140c is smooth.

In some embodiments, as shown in FIG. 26, the first housing 1 may further include a first end surface 13 close to the main shaft 31, and the second housing 2 may further include a second end surface 23 close to the main shaft 31. For example, when the first housing 1 and the second housing 2 are unfolded relative to each other to the unfolded state, the first end surface 13 faces the second end surface 23. The first end surface 13 is in contact with the second end surface 23. When there is a small gap between the first end surface 13 and the second end surface 23, it is also considered that the first end surface 13 is in contact with the second end surface 23.

For example, when the first housing 1 and the second housing 2 are folded relative to each other to the folded state, orientations of the first end surface 13 and the second end surface 23 are the same, and in the thickness direction of the main shaft 31, a distance between the first end surface 13 and the outer surface 3140 of the main shaft 31 is greater than a distance between the second end surface 23 and the outer surface 3140 of the main shaft 31. The distance between the first end surface 13 and the outer surface 3140 of the main shaft 31 is a maximum distance between a center point of the first end surface 13 and the outer surface 3140 of the main shaft 31 in the thickness direction of the main shaft 31. For example, in this embodiment, the distance may be a distance S1 between the center point of the first end surface 13 and the second area 3140b of the outer surface 3140 of the main shaft 31. The distance between the second end surface 23 and the outer surface 3140 of the main shaft 31 is a maximum distance between a center point of the second end surface 23 and the outer surface 3140 of the main shaft 31 in the thickness direction of the main shaft 31. For example, in this embodiment, the distance may be a distance S2 between the center point of the second end surface 23 and the second area 3140b of the outer surface 3140 of the main shaft 31.

When the first housing 1 and the second housing 2 are in the unfolded state, the first end surface 13 and the second end surface 23 may be disposed obliquely relative to the thickness direction of the main shaft 31, and when the first housing 1 and the second housing 2 are in the folded state, the first end surface 13 and the second end surface 23 may be disposed to be flush with each other, to improve appearance experience and a holding feel of the electronic device 100.

In some embodiments, as shown in FIG. 18, FIG. 24A, and FIG. 24B, one end of the connection rod 325 is rotatably connected to the first connection arm 323, and the other end of the connection rod 325 is rotatably connected to the second connection arm 324. In this way, the first connection arm 323, the connection rod 325, the second connection arm 324, and the main shaft 31 may form a four-link mechanism, so that in a process in which the first housing 1 rotates relative to the second housing 2, movement actions of the first connection arm 323 and the second connection arm 324 are prevented from being stuck, to improve reliability of the mechanism.

Refer to FIG. 22A and FIG. 23A again. In some embodiments, the synchronization assembly 327 is engaged with the first end 3211 of the rotation arm 321 and is engaged with the first end 3231 of the first connection arm 323. The first synchronization gear 3271 is engaged with the connection gear 321a of the rotation arm 321, to engage with the first end 3211 of the rotation arm 321. The second synchronization gear 3272 is engaged with the first synchronization gear 3271 and the first end 3231 of the first connection arm 323. In this embodiment, a rotation action of the rotation arm 321 relative to the main shaft 31 and a rotation action of the first connection arm 323 relative to the main shaft 31 are synchronized via the synchronization assembly 327, to improve mechanism operation experience of the user.

For example, as shown in FIG. 23A and FIG. 23B, in the thickness direction of the main shaft 31, the first synchronization gear 3271 is located below the connection gear 321a. Because the flexible display 20 is located above the main shaft 31, in the thickness direction of the main shaft 31, the first synchronization gear 3271 is located on a side that is of the connection gear 321a and that is opposite to the flexible display 20. In this embodiment, a thickness space of the main shaft 31 can be fully used through top-bottom arrangement of the connection gear 321a and the first synchronization gear 3271, and the first synchronization gear 3271 and the connection gear 321a reuse a part of a width space of the main shaft 31. This helps reduce a width size of the main shaft 31, and miniaturize the main shaft 31.

The pitch diameter of the second synchronization gear 3272 may be different from the pitch diameter of the first synchronization gear 3271, to better adapt to a position of the first synchronization gear 3271 and a position of the first end 3231 of the first connection arm 323, and realize engaging transmission. In addition, the second synchronization gear 3272 is an incomplete gear, and a tooth part position and a toothless area position of the second synchronization gear 3272 may be adjusted, to reduce a movement space requirement of the second synchronization gear 3272 during movement as much as possible while ensuring that an engaging connection requirement is implemented, so as to reduce a space requirement for the main shaft 31, for example, a space requirement for the thickness direction of the main shaft 31. This facilitates thinning of the main shaft 31.

For example, as shown in FIG. 23A, when the first housing 1 and the second housing 2 are unfolded relative to each other to the unfolded state, the tooth part 321e of the connection gear 321a faces the first synchronization gear 3271 and is located in the main shaft 31, and the support surface 321f of the connection gear 321a is flush with the support surface 314 of the main shaft 31. In this case, the connection gear 321a and the main shaft 31 can be jointly configured to support the flexible display 20, to improve integrity and flatness of a support environment of the flexible display 20. In addition, the connection gear 321a is an incomplete gear, so that a volume of the connection gear 321a is reduced when a connection relationship is met. This helps reduce the thickness of the main shaft 31 configured to mount the connection gear 321a, and facilitate thinning of the main shaft 31.

As shown in FIG. 23B, when the first housing 1 and the second housing 2 are folded relative to each other to the folded state, the connection gear 321a rotates relative to the main shaft 31, a part of the tooth part 321e of the connection gear 321a partially rotates out of the main shaft 31, and the support surface 321f of the connection gear 321a faces the accommodation space 30. In this case, the connection gear 321a may move by using a space above the main shaft 31, so that the main shaft 31 reserves only a partial space used to allow the connection gear 321a to move. This helps reduce the thickness of the main shaft 31, and miniaturize the main shaft 31.

For example, as shown in FIG. 23A and FIG. 23B, in the width direction of the main shaft 31, the rotation center 32710 of the first synchronization gear 3271 is away from the second synchronization gear 3272 relative to the rotation center 32110 of the connection gear 321a. In this embodiment, positions of the rotation center 32710 of the first synchronization gear 3271 and the rotation center 32110 of the connection gear 321a are set, so that the first synchronization gear 3271 and the connection gear 321a are always in an engaged state. This avoids idle rotation, to improve mechanism reliability of the foldable apparatus 10. In some embodiments, when the first housing 1 and the second housing 2 are in the unfolded state, a projection of the rotation center 32710 of the first synchronization gear 3271 on the support surface 314 of the main shaft 31 is a first projection, a projection of the rotation center 32110 of the connection gear 321a on the support surface 314 of the main shaft 31 is a second projection, and a projection of the rotation center of the second synchronization gear 3272 on the support surface 314 of the main shaft 31 is a third projection. A distance between the first projection and the third projection is greater than a distance between the second projection and the third projection.

For example, as shown in FIG. 22A, when the first housing 1 and the second housing 2 are unfolded relative to each other to the unfolded state, the support surface of the rotation arm 321 may be flush with the third support surface 12 of the first housing 1 and the support surface 314 of the main shaft 31, to jointly provide a flat support environment for the flexible display 20. Refer to FIG. 11B. The support surface of the rotation arm 321 may include the support surface 321k of the second end 3212 of the rotation arm 321, the support surface 321j of the arc-shaped arm 321c, the support surface 321h of the connection rod 321b, and the support surface 321f of the connection gear 321a. In some other embodiments, a partial area or an entire area of the support surface of the rotation arm 321 may alternatively be not flush with the third support surface 12 of the first housing 1 and the support surface 314 of the main shaft 31, for example, a position may be slightly lower. In this way, the flexible display 20 is not lifted, and specific structural support can be provided.

Refer to FIG. 19 and FIG. 21 again. The damping assembly 328 is connected to the synchronization assembly 327 and the first end 3231 of the first connection arm 323, and the synchronization assembly 327 is connected to the first end 3211 of the rotation arm 321. The second end 3212 of the rotation arm 321 is fastened to the first housing 1, and the second end 3232 of the first connection arm 323 is connected to the second housing 2 via the mounting bracket 322. Therefore, in a process in which the first housing 1 and the second housing 2 are unfolded relative to each other or folded relative to each other, the damping assembly 328 can provide damping force, so that when unfolding or folding the electronic device 100, the user can sense resistance and thrust, thereby obtaining good hand-feeling unfolding or folding experience. This improves mechanism operation experience of the electronic device 100. In addition, in some embodiments, the damping assembly 328 may further make the rotation arm 321 and the first connection arm 323 to stay at some positions, so that the first housing 1 and the second housing 2 can stay at some positions, to improve use experience of the user.

In some other embodiments, when the rotation arm 321 meets a connection relationship with the main shaft 31, the synchronization assembly 327, and the damping assembly 328, the rotation arm 321 may not be provided with the connection rod 321b, and the arc-shaped arm 321c is directly fastened by the connection gear 321a. In this case, the connection gear 321a may be provided with a second arc-shaped surface 321i, the second arc-shaped surface 321i is disposed opposite to the support surface 321f of the connection gear 321a, and the second arc-shaped surface 321i may be located on a side or in a middle part of the tooth part 321e of the connection gear 321a. A specific structure of the rotation arm 321 is not strictly limited in embodiments of this application.

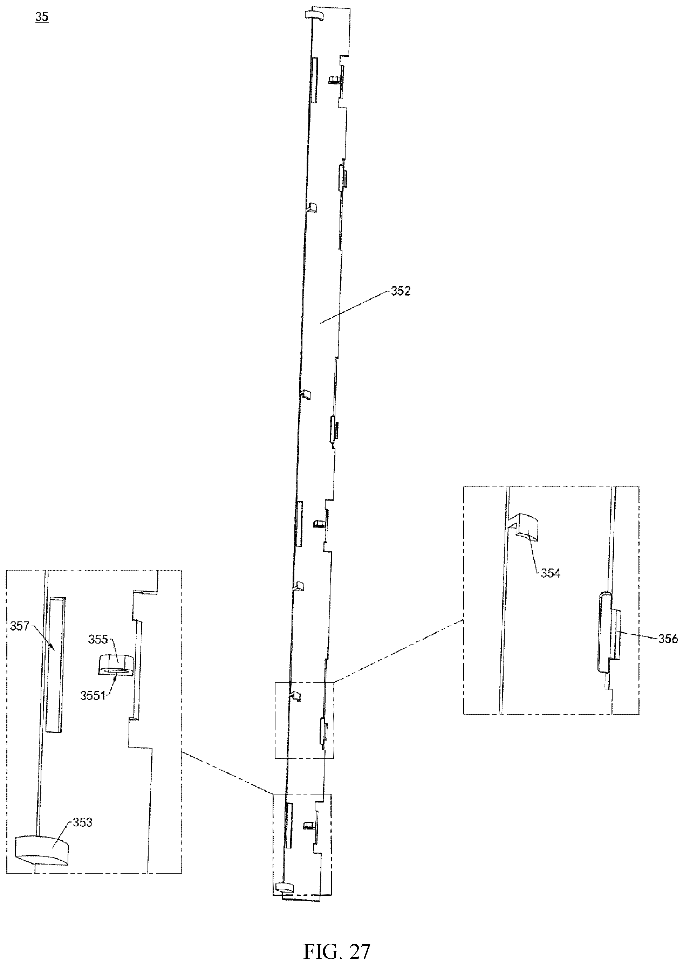

FIG. 27 is a diagram of a structure of the support plate 35 shown in FIG. 5 from another angle.

In some embodiments, the support plate 35 may include a plate body 352 and a plurality of connector assemblies. The plurality of connector assemblies are fastened to a same side plate surface protruding from the plate body 352, and the plurality of connector assemblies are arranged in an extension direction of the plate body 352. A quantity of connector assemblies corresponds to the quantity of connection assemblies (32, 33, and 34) of the foldable assembly 3. The connector assembly may include a first rotation block 353, a second rotation block 354, and a sliding block 355. The first rotation block 353 includes an arc-shaped arm, the second rotation block 354 includes an arc-shaped arm, and a center of the arc-shaped arm of the first rotation block 353 coincides with a center of the arc-shaped arm of the second rotation block 354. The sliding block 355 is provided with a sliding slot 3551. The arc-shaped arm of the first rotation block 353 is fastened to a non-support surface of the plate body 352, the non-support surface of the plate body 352 is disposed opposite to the support surface of the plate body 352, and the support surface of the plate body 352, namely, the support surface of the support plate 35, is configured to support the flexible display 20 when the first housing 1 and the second housing 2 are unfolded relative to each other to the unfolded state. Therefore, the arc-shaped arm of the first rotation block 353 is fastened to a side that is of the plate body 352 and that is opposite to the flexible display 20.

The support plate 35 may be further provided with a plurality of compensation blocks 356, the compensation blocks 356 are protrudingly disposed on a side edge of the plate body 352, and a quantity of compensation blocks 356 corresponds to the quantity of connection assemblies (32, 33, and 34) of the foldable assembly 3.

The plate body 352 may be provided with a plurality of avoidance notches 357, the avoidance notches 357 penetrate a thickness direction of the plate body 352, and a quantity of avoidance notches 357 corresponds to the quantity of connection assemblies (32, 33, and 34) of the foldable assembly 3.

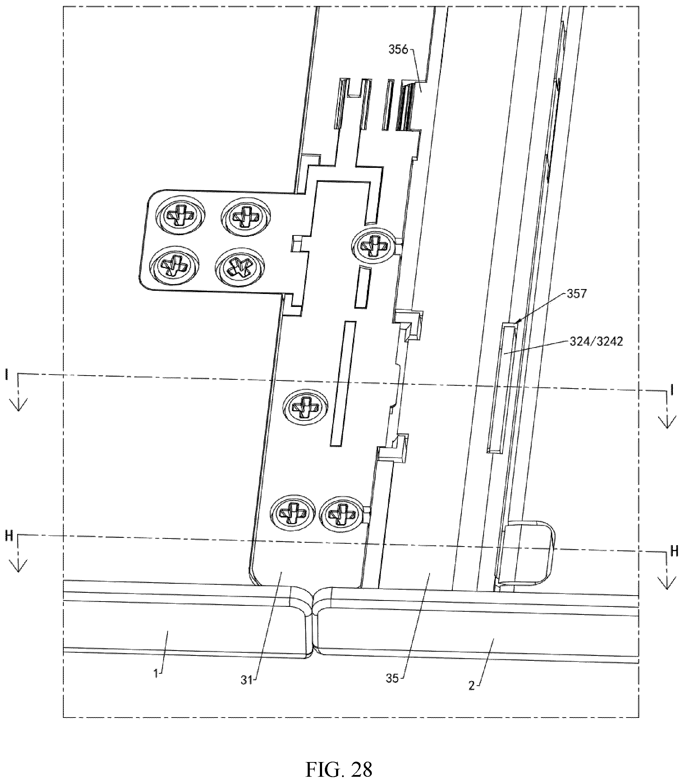

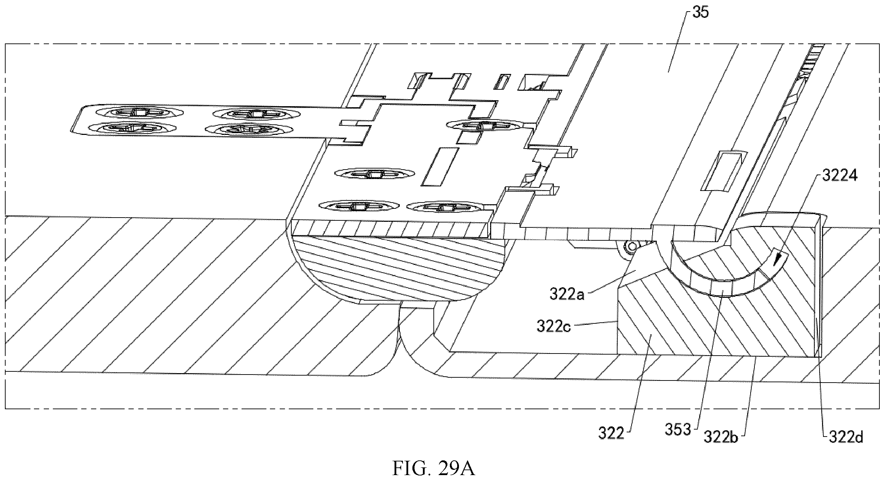

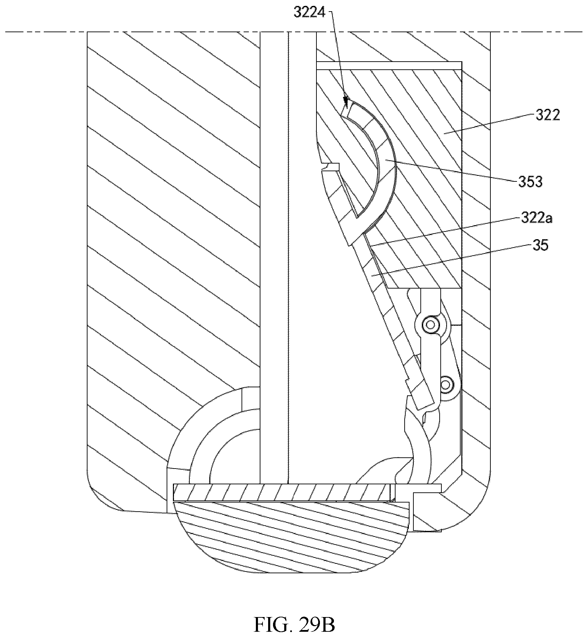

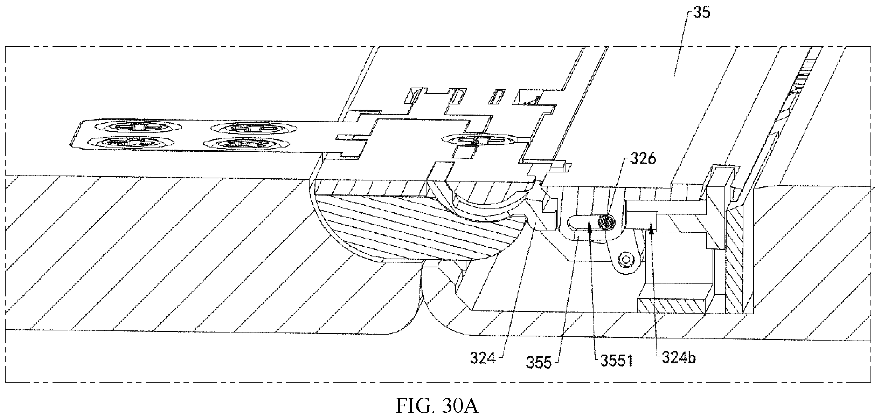

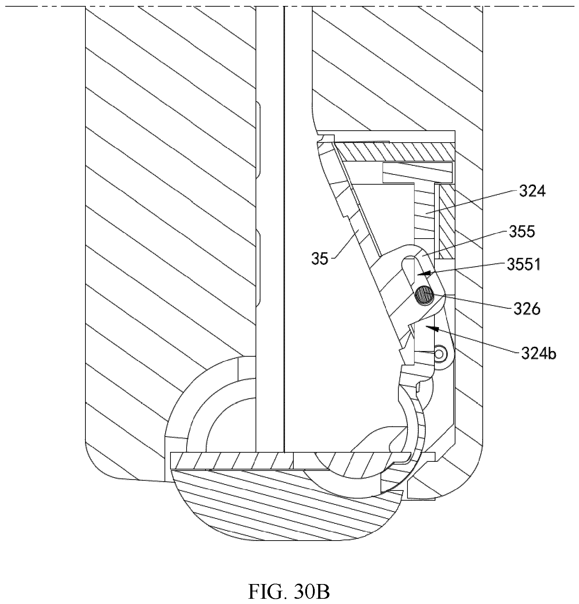

Refer to FIG. 28 to FIG. 30B. FIG. 28 is a diagram of a structure of the foldable apparatus 10 shown in FIG. 3 from another angle. FIG. 29A is a diagram of a cross-sectional structure of the foldable apparatus 10 shown in FIG. 28 cut along H-H. FIG. 29B is a diagram of a cross-sectional structure of the structure shown in FIG. 29A in another use state. FIG. 30A is a diagram of a cross-sectional structure of the foldable apparatus 10 shown in FIG. 28 cut along I-I. FIG. 30B is a diagram of a cross-sectional structure of the structure shown in FIG. 30A in another use state.

In some embodiments, as shown in FIG. 28, when the first housing 1 and the second housing 2 are in the unfolded state, the support plate 35 is located between the main shaft 31 and the second housing 2, and the support plate 35 shields a gap between the main shaft 31 and the second housing 2. The first housing 1, the main shaft 31, the support plate 35, and the second housing 2 may be configured to jointly support the flexible display 20 (referring to FIG. 3).

The compensation block 356 of the support plate 35 may be at least partially located in the second notch 319 of the main shaft 31 (referring to FIG. 7), to increase a support area of the support plate 35. The second end 3242 of the second connection arm 324 may be at least partially located in the avoidance notch 357 of the support plate 35, so that the second end 3242 of the second connection arm 324 has a sufficient movable space and can compensate for the support area of the support plate 35, to increase support for the flexible display 20.

As shown in FIG. 29A and FIG. 29B, the first rotation block 353 of the support plate 35 is mounted in the first rotation groove 3224 of the mounting bracket 322, and the support plate 35 is rotatably connected to the mounting bracket 322. The second rotation block 354 (referring to FIG. 27) of the support plate 35 may be correspondingly mounted in the second rotation groove 3225 (referring to FIG. 20) of the mounting bracket 322, so that a rotation connection relationship between the support plate 35 and the mounting bracket 322 is more stable and reliable.

As shown in FIG. 30A and FIG. 30B, the sliding block 355 of the support plate 35 is at least partially located in the avoidance space 324b of the second connection arm 324, the connection shaft 326 inserted into the second connection arm 324 is inserted into the sliding slot 3551 of the sliding block 355 and can slide in the sliding slot 3551. The support plate 35 is slidably connected to the second connection arm 324. An extension direction of the sliding slot 3551 of the sliding block 355 of the support plate 35 may be a straight line shape, an arc shape, a spline curve shape, or the like. This is not strictly limited in embodiments of this application.

In this embodiment, because the support plate 35 is rotatably connected to the mounting bracket 322 and is slidably connected to the second connection arm 324, in a process in which the first housing 1 and the second housing 2 move relative to each other, the support plate 35 moves under driving of the mounting bracket 322 and the second connection arm 324, and a movement path is accurate, to meet support requirements of the foldable apparatus 10 for the flexible display 20 in different forms.

As shown in FIG. 29A and FIG. 29B, the first surface 322a of the mounting bracket 322 is disposed facing the support plate 35. Because the flexible display 20 is located above the support plate 35, the first surface 322a of the mounting bracket 322 is located between the flexible display 20 and the second surface 322b of the mounting bracket 322. In addition, the third surface 322c of the mounting bracket 322 is located between the main shaft 31 and the fourth surface 322d of the mounting bracket 322.

For example, when the first housing 1 and the second housing 2 are unfolded relative to each other to the unfolded state, a first included angle is formed between the first surface 322a and the support plate 35, and a distance between the support plate 35 and an end that is of the first surface 322a and that is close to the main shaft 31 is greater than a distance between the support plate 35 and an end that is of the first surface 322a and that is away from the main shaft 31. That is, an opening of the first included angle is provided toward the main shaft 31. When the first housing 1 and the second housing 2 are folded relative to each other to the folded state, the support plate 35 rotates relative to the mounting bracket 322 and approaches the first surface 322a, a second included angle is formed between the first surface 322a and the support plate 35, and the second included angle is less than the first included angle. In some embodiments, when the first housing 1 and the second housing 2 are folded relative to each other to the folded state, the first surface 322a may be in contact with the support plate 35, to support the support plate 35.

For example, as shown in FIG. 29A and FIG. 29B, the arc-shaped arm of the first rotation block 353 of the support plate 35 extends from the plate body 352 in a direction away from the main shaft 31. In a process in which the first housing 1 and the second housing 2 are unfolded relative to each other, a part of the arc-shaped arm of the first rotation block 353 rotates out of the first rotation groove 3224. In a process in which the first housing 1 and the second housing 2 are folded relative to each other, a part of the arc-shaped arm of the first rotation block 353 rotates into the first rotation groove 3224.

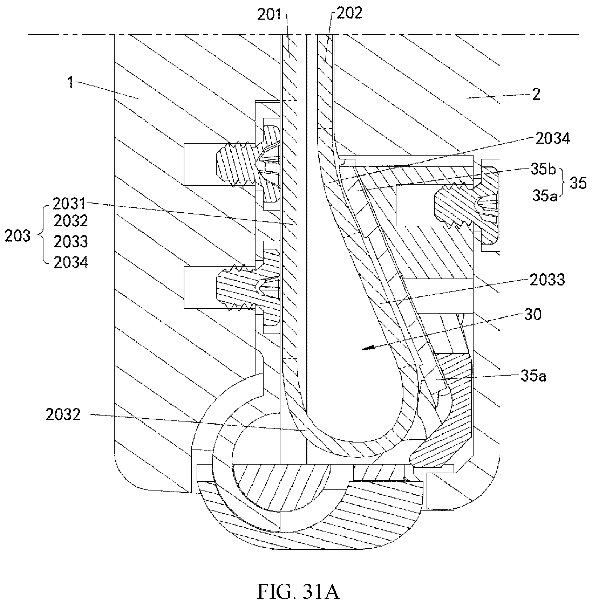

FIG. 31A is a diagram of an internal structure of the electronic device 100 shown in FIG. 2.

In some embodiments, when the first housing 1 and the second housing 2 are folded relative to each other to the folded state, the first part 201 of the flexible display 20 and the second part 202 of the flexible display 20 are disposed opposite to each other, and a middle part of the third part 203 of the flexible display 20 is offset toward a direction toward the second housing 2. In this embodiment, because the accommodation space 30 is offset toward the second housing 2, the flexible display 20 deforms with the accommodation space 30, and the third part 203 of the flexible display 20 is offset toward the second housing 2. In comparison with a symmetric deformation of the conventional flexible display 20, bending positions of the third part 203 of the flexible display 20 in this application are few. This helps reduce a risk of damaging the flexible display 20, improves reliability of the flexible display 20, and prolongs the service life of the flexible display 20.

For example, the support plate 35 includes a first end 35a close to the main shaft 31 and a second end 35b away from the main shaft 31. When the first housing 1 and the second housing 2 are folded relative to each other to the folded state, a distance between the first end 35a of the support plate 35 and the first housing 1 is greater than a distance between the second end 35b of the support plate 35 and the first housing 1, to form the accommodation space 30 between the support plate 35 and the first housing 1. The accommodation space 30 is an upper-narrow lower-wide space that is offset toward the second housing 2, and the third part 203 of the flexible display 20 is at least partially accommodated in the accommodation space 30.

For example, as shown in FIG. 31A, the third part 203 of the flexible display 20 includes a first segment 2031, a second segment 2032, a third segment 2033, and a fourth segment 2034 that are sequentially connected, the first segment 2031 is connected to the first part 201 of the flexible display 20, and the fourth segment 2034 is connected to the second part 202 of the flexible display 20. When the first housing 1 and the second housing 2 are folded relative to each other to the folded state, the second segment 2032 and the fourth segment 2034 are curved segments, and the second segment 2032 and the third segment 2033 are offset in a direction toward the second housing 2. Bending positions of the flexible display 20 are located in the second segment 2032 and the fourth segment 2034. The middle part of the third part 203 of the flexible display 20 may be approximately located in the third segment 2033. When the first housing 1 and the second housing 2 are folded relative to each other to the folded state, the first segment 2031 and the third segment 2033 may be straight segments.

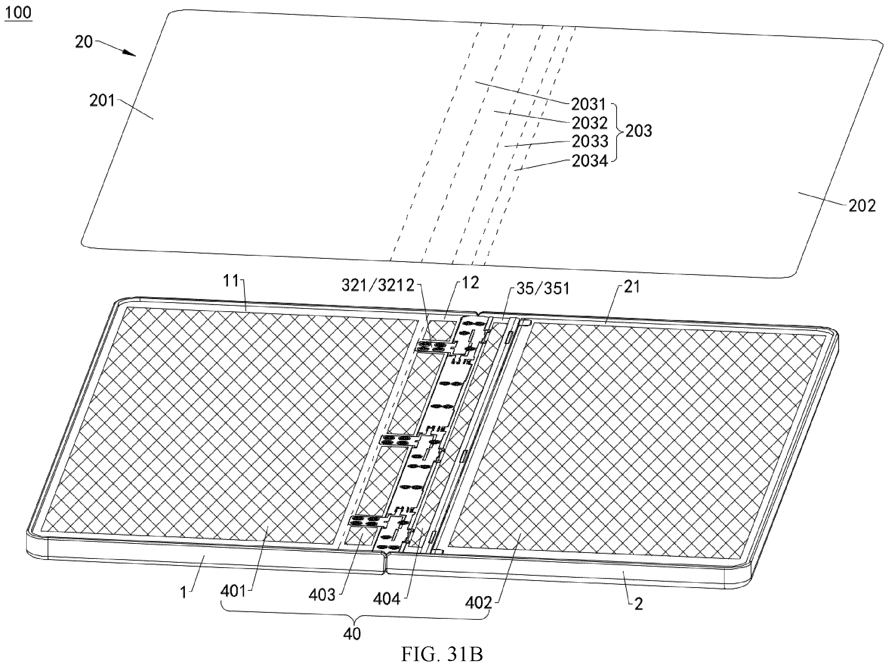

Refer to FIG. 31A and FIG. 31B. FIG. 31B is a diagram of a structure of a fastening solution of the flexible display 20 and the foldable apparatus 10 of the electronic device 100 shown in FIG. 1 in some embodiments.

In some embodiments, the first segment 2031 of the third part 203 of the flexible display 20 is disposed corresponding to the third support surface 12 of the first housing 1 and the second ends 3212 of the rotation arms 321 of the plurality of connection assemblies. The third support surface 12 of the first housing 1 may be a plane or approximately a plane, to provide a flat support environment for the first segment 2031 of the third part 203 of the flexible display 20. The third segment 2033 of the third part 203 of the flexible display 20 is disposed corresponding to the support plate 35. The support surface 351 of the support plate 35 may be a plane or approximately a plane, to provide a flat support environment for the third segment 2033 of the third part 203 of the flexible display 20. The second segment 2032 of the third part 203 of the flexible display 20 is disposed close to the main shaft 31, to form one bending position of the third part 203 of the flexible display 20. The fourth segment 2034 of the third part 203 of the flexible display 20 is disposed corresponding to a joint between the support plate 35 and the second housing 2, to form another bending position of the third part 203 of the flexible display 20.

In this embodiment, when the electronic device 100 is in the folded state, the flexible display 20 forms two bending positions in the third part 203 of the flexible display 20, and the bending positions of the flexible display 20 are few. This helps improve reliability of the flexible display 20.

Refer to FIG. 31B. In some embodiments, the electronic device 100 may further include an adhesive layer assembly 40, and the adhesive layer assembly 40 may include a first adhesive layer to a fourth adhesive layer (401 to 404). The first adhesive layer 401 may be fastened to the first support surface 11 of the first housing 1, and the first adhesive layer 401 is further fastened to the first part 201 of the flexible display 20. The second adhesive layer 402 may be fastened to the second support surface 21 of the second housing 2, and the second adhesive layer 402 is further fastened to the second part 202 of the flexible display 20. The third adhesive layer 403 may be fastened to the third support surface 12 of the first housing 1, and the third adhesive layer 403 may further be fastened to the first segment 2031 of the third part 203 of the flexible display 20. The fourth adhesive layer 404 may be fastened to the support surface 351 of the support plate 35, and the fourth adhesive layer 404 may further be fastened to the third segment 2033 of the third part 203 of the flexible display 20. No adhesive layer is disposed on the support surface 314 of the main shaft 31, and the main shaft 31 is not fastened to the second segment 2032 of the third part 203 of the flexible display 20. No adhesive layer is disposed at the joint between the support plate 35 and the second housing 2, and the joint is not fastened to the fourth segment 2034 of the third part 203 of the flexible display 20.

In this embodiment, the first segment 2031 of the flexible display 20 is fastened to the first housing 1, the second segment 2032 of the flexible display 20 is not fastened to the main shaft 31, and the third segment 2033 of the flexible display 20 is fastened to the support plate 35. In this way, the flexible display 20 can be bent into an expected shape in a process of switching the electronic device 100 from the unfolded state to the folded state. This reduces a risk of arching of the flexible display 20, improves reliability, and prolongs the service life of the flexible display 20.

In some other embodiments, the adhesive layer assembly 40 may not be provided with the fourth adhesive layer 404, and the third segment 2033 of the third part 203 of the flexible display 20 and the support surface 351 of the support plate 35 may not be bonded and fastened, and can move relative to each other.

In the foregoing embodiment, each adhesive layer of the adhesive layer assembly 40 may be a continuous adhesive layer, or may be a disconnected adhesive layer, or may be an adhesive layer with a hollow-out area, for example, may be an entire surface-shaped/mesh-shaped adhesive layer, or includes a plurality of rubber blocks/glue spots, or includes a plurality of rubber strips, or the like. This is not strictly limited in embodiments of this application. Different adhesive layers may have same or different hardness. This is not strictly limited in embodiments of this application.

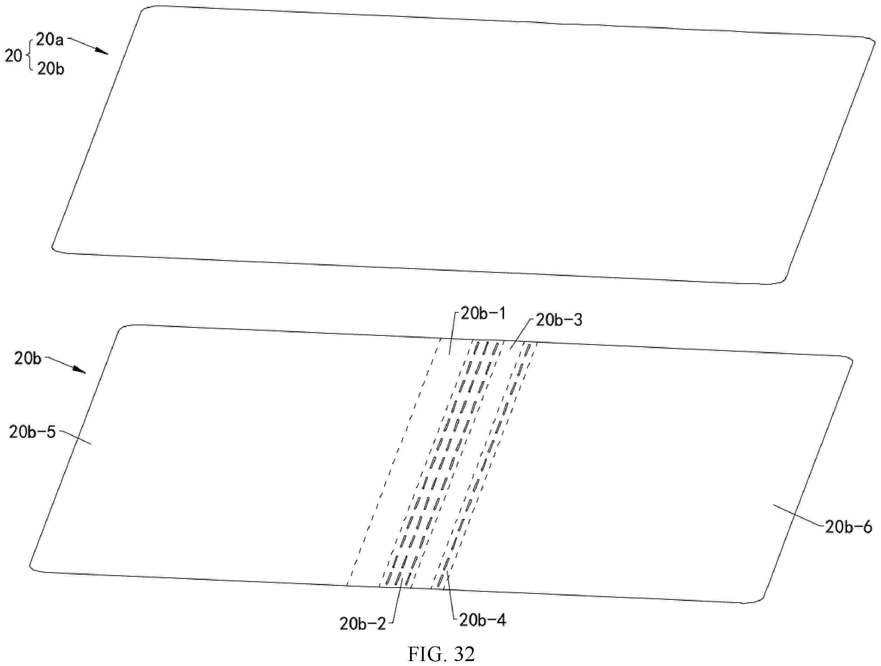

Refer to FIG. 31B and FIG. 32. FIG. 32 is a diagram of an exploded structure of the flexible display 20 shown in FIG. 31B.

In some embodiments, the flexible display 20 may include a flexible display panel 20a and a bearing plate 20b. The bearing plate 20b is fastened to a non-display side of the flexible display panel 20a, and a display side of the flexible display panel 20a is configured to emit light to implement display. Stiffness of the bearing plate 20b is greater than stiffness of the flexible display panel 20a. The bearing plate 20b is configured to provide rigid support for the flexible display panel 20a and can be bent, to improve support strength of the flexible display 20.

The bearing plate 20b is made of a material that has specific strength, hardness, and stiffness and can be bent under external force. For example, the bearing plate 20b may use a material like a stainless steel material, an aluminum alloy, a magnesium alloy, a titanium alloy, or a copper alloy. Alternatively, a material of the bearing plate 20b may alternatively be a metal matrix composite material, for example, may be a particle-reinforced aluminum-based or magnesium-based composite material like silicon carbide, aluminum oxide, boron carbide, a carbon nanotube, graphene, chromium carbide, silicon boride, titanium boride, or titanium carbide.

For example, the bearing plate 20b includes a first plate part 20b-1 located on the first segment 2031, a second plate part 20b-2 located on the second segment 2032, a third plate part 20b-3 located on the third segment 2033, and a fourth plate part 20b-4 located on the fourth segment 2034, and stiffness of the first plate part 20b-1 and the third plate part 20b-3 is greater than stiffness of the second plate part 20b-2 and the fourth plate part 20b-4. In this case, the second plate part 20b-2 and the fourth plate part 20b-4 have weak stiffness, and can be easily bent when supporting the flexible display panel 20a.

For example, the bearing plate 20b may further include a fifth plate part 20b-5 located on the first part 201 and a sixth plate part 20b-6 located on the second part 202. Strength of the fifth plate part 20b-5 and the sixth plate part 20b-6 may be the same as or similar to strength of the first plate part 20b-1.

The bearing plate 20b may be of an integrated structure, and a plurality of plate parts of the bearing plate 20b are connected to each other and are all a part of the bearing plate 20b, so that connection between the plurality of plate parts is more secure. In the accompanying drawings of this application, for example, the plurality of plate parts are distinguished by using dashed lines. In some other implementations, the plurality of plate parts of the bearing plate 20b may alternatively be connected and fastened to each other through welding or clamping.

In some embodiments, the first plate part 20b-1 and the third plate part 20b-3 may use a same or similar design, for example, may both be of a complete board structure. For example, stiffness of the second plate part 20b-2 and the fourth plate part 20b-4 can be reduced by providing a through hole and a groove, reducing a thickness, splicing a soft rubber part, or the like, to achieve good bending performance and tensile performance. For example, the second plate part 20b-2 may be provided with at least one groove or at least one through hole, or a thickness of the second plate part 20b-2 may be less than a thickness of the first plate part 20b-1, or the second plate part 20b-2 may use a spliced structure of a metal plate part and a soft rubber part, or the like. A specific material and structure of the second plate part 20b-2 are not strictly limited in this application. For example, the fourth plate part 20b-4 may be provided with at least one groove or at least one through hole, or a thickness of the fourth plate part 20b-4 may be less than a thickness of the first plate part 20b-1, or the fourth plate part 20b-4 may use a spliced structure of a metal plate part and a soft rubber part, or the like. A specific material and structure of the fourth plate part 20b-4 are not strictly limited in this application.

When the second plate part 20b-2 and the fourth plate part 20b-4 are provided with a plurality of grooves or through holes, the plurality of grooves or through holes may be spaced from the top of the plate part to the bottom of the plate part. A shape of the groove or the through hole may be a diamond shape, a square shape, a dumbbell shape, a waist circle shape, or the like. This is not strictly limited in this application.

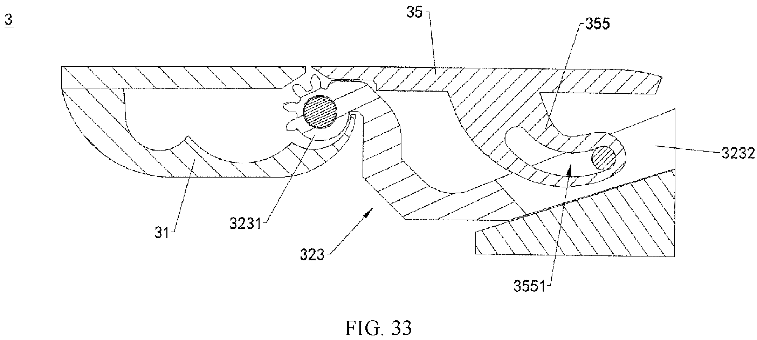

FIG. 33 is a diagram of a brief structure of a partial structure of the foldable assembly 3 shown in FIG. 4 in some other embodiments.

In the foregoing embodiment, the support plate 35 of the foldable assembly 3 is slidably connected to the second connection arm 324 (referring to FIG. 30A). In some other embodiments, as shown in FIG. 33, the foregoing connection relationship may be replaced as follows: The support plate 35 of the foldable assembly 3 is slidably connected to the second end 3232 of the first connection arm 323. The extension direction of the sliding slot 3551 of the sliding block 355 of the support plate 35 may be a straight line shape, an arc shape, a spline curve shape, or the like. In this case, the first end 3231 of the first connection arm 323 is still rotatably connected to the main shaft 31. To implement slidable connection to the support plate 35, a partial structure of the first connection arm 323 may be adaptively adjusted with reference to the structure of the second connection arm 324 in the foregoing embodiments. Details are not described herein again. For another structure of the foldable assembly 3 in embodiments, refer to the foregoing embodiments. Details are not described herein again.

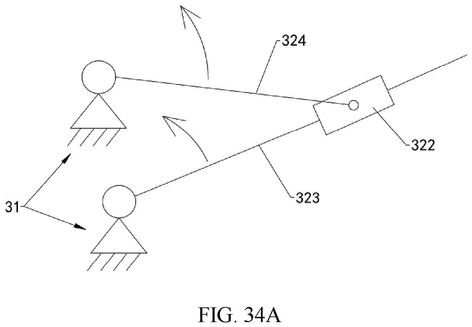

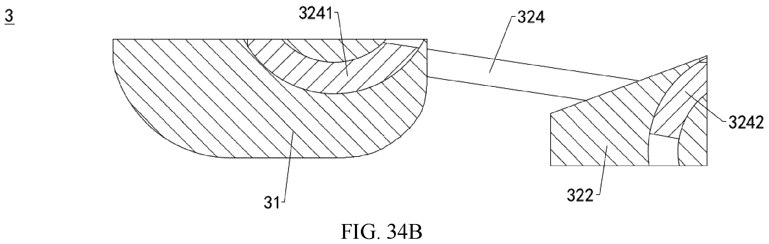

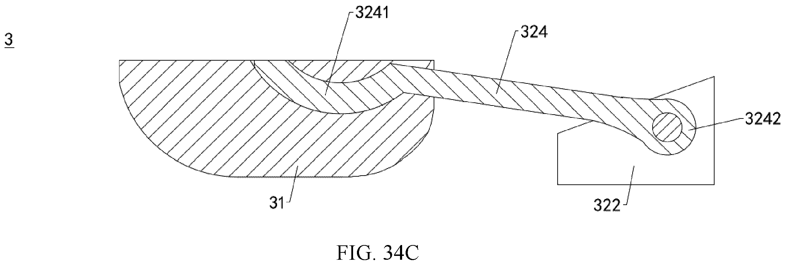

Refer to FIG. 34A to FIG. 34C. FIG. 34A is a diagram of a moving mechanism of a partial structure of the foldable assembly 3 shown in FIG. 4 in some other embodiments. FIG. 34B is a diagram of a brief structure of a partial structure of the moving mechanism shown in FIG. 34A in some implementations. FIG. 34C is a diagram of a brief structure of a partial structure of the moving mechanism shown in FIG. 34A in some other implementations.

In the foregoing embodiments, as shown in FIG. 25, the first connection arm 323 of the foldable assembly 3 is rotatably connected to the main shaft 31 and is slidably connected to the mounting bracket 322, and the second connection arm 324 is rotatably connected to the main shaft 31 and is slidably connected to the mounting bracket 322. In some other embodiments, as shown in FIG. 34A, the foregoing connection relationship may be replaced as follows: The first connection arm 323 of the foldable assembly 3 is rotatably connected to the main shaft 31 and is slidably connected to the mounting bracket 322, and the second connection arm 324 is rotatably connected to the main shaft 31 and is rotatably connected to the mounting bracket 322. As shown in FIG. 34B, the first end 3241 of the second connection arm 324 may be rotatably connected to the main shaft 31 through a virtual shaft, and the second end 3242 of the second connection arm 324 may be rotatably connected to the mounting bracket 322 through a virtual shaft. As shown in FIG. 34C, the first end 3241 of the second connection arm 324 may be rotatably connected to the main shaft 31 through a virtual shaft, and the second end 3242 of the second connection arm 324 may be rotatably connected to the mounting bracket 322 through a solid shaft. In some other embodiments, the first end 3241 of the second connection arm 324 may alternatively be rotatably connected to the main shaft 31 through a solid shaft. For another structure of the foldable assembly 3 in embodiments, refer to the foregoing embodiments. Details are not described herein again.

It may be understood that, in the foregoing embodiments, an example in which the electronic device 100 is of a two-fold structure is used for description. In other words, the electronic device 100 includes two housings that can be bent relative to each other. In some other embodiments, the electronic device 100 may alternatively be of a three-fold structure or a more than three-fold structure. In other words, the electronic device 100 includes three or more housings that may be bent relative to each other, and two adjacent housings are connected via the foldable assembly 3. When the electronic device 100 is of the three-fold structure or the more than three-fold structure, a structure of the electronic device 100 may be adaptively designed with reference to descriptions of the two-fold structure in embodiments.

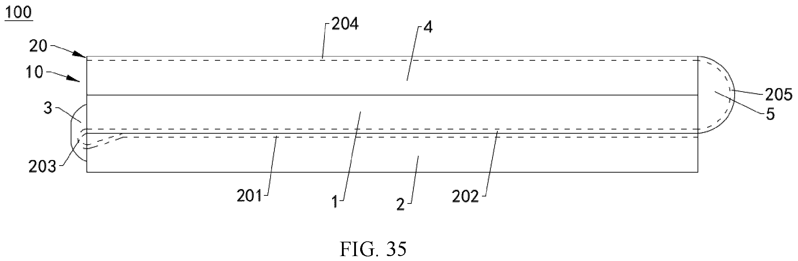

FIG. 35 is a diagram of a structure of the electronic device 100 in some other embodiments according to an embodiment of this application.

In some embodiments, the electronic device 100 may be of a three-fold structure. The foldable apparatus 10 of the electronic device 100 includes the first housing 1, the foldable assembly 3, the second housing 2, a third housing 4, and a second foldable assembly 5. The first housing 1, the foldable assembly 3, and the second housing 2 may use the structures described in the foregoing embodiments. Details are not described herein again. The second foldable assembly 5 is connected to a side that is of the first housing 1 and that is away from the second housing 2, and the second foldable assembly 5 is further connected to the third housing 4. In other words, the first housing 1, the foldable assembly 3, the second housing 2, the third housing 4, and the second foldable assembly 5 of the electronic device 100 are sequentially connected.

When the electronic device 100 is in the folded state, the third housing 4, the first housing 1, and the second housing 2 are folded in an S shape, and the first housing 1 is located between the third housing 4 and the second housing 2. When the electronic device 100 is in a completely unfolded state, the first housing 1, the second housing 2, and the third housing 4 are unfolded. The electronic device 100 may further include a partially unfolded state. In this case, the first housing 1 and the second housing 2 are unfolded relative to each other to the unfolded state, and the first housing 1 and the third housing 4 are folded relative to each other to the folded state.

For example, the first housing 1, the second housing 2, and the third housing 4 may use an equal-thickness design, or may use an unequal-thickness design. For example, the thickness of the first housing 1 may be less than a thickness of a housing of the second housing 2 or the third housing 4.

For example, the flexible display 20 includes the first part 201, the second part 202, the third part 203, a fourth part 204, and a fifth part 205. The first part 201 to the third part 203 of the flexible display 20 may use the structures described in the foregoing embodiments. Details are not described herein again. The fourth part 204 of the flexible display 20 is connected to a side that is of the third part 203 of the flexible display 20 and that is away from the second part 202, and the fourth part 204 of the flexible display 20 is further connected to the fifth part 205 of the flexible display 20. In other words, the first part 201 to the fifth part 205 of the flexible display 20 are sequentially connected.

The fourth part 204 of the flexible display 20 is disposed corresponding to the second foldable assembly 5, and the fifth part 205 of the flexible display 20 is disposed corresponding to the third housing 4. A part that is of the flexible display 20 and that corresponds to the third housing 4 is fastened to the third housing 4. A part that is of the flexible display 20 and that corresponds to the second foldable assembly 5 deforms in a process in which the first housing 1 and the third housing 4 are unfolded relative to each other or folded relative to each other. When the electronic device 100 is in the folded state, the first part 201 to the third part 203 of the flexible display 20 are shielded by the foldable apparatus 10, and the fourth part 204 and the fifth part 205 of the flexible display 20 are exposed, so that a display operation and/or a touch operation can be performed. When the electronic device 100 is in the unfolded state, the flexible display 20 is completely unfolded, so that a full-screen display and/or a touch operation can be performed. The electronic device 100 may further include the partially unfolded state, and a form of the flexible display 20 changes with the foldable apparatus 10.

When the electronic device 100 is in the unfolded state, the flexible display 20 is located on a same side of the first housing 1, the second housing 2, and the third housing 4, and the first housing 1, the second housing 2, and the third housing 4 jointly support the flexible display 20. When the electronic device 100 is in the folded state, in a direction from the third housing 4 to the second housing 2, the part that is of the flexible display 20 and that corresponds to the third housing 4, the third housing 4, the first housing 1, the part that is of the flexible display 20 and that corresponds to the first housing 1, the part that is of the flexible display 20 and that corresponds to the second housing 2, and the second housing 2 are sequentially stacked.

The foregoing embodiments are merely intended for describing some technical solutions of this application other than limiting this application. Although this application is described in detail with reference to the foregoing embodiments, a person of ordinary skill in the art should understand that modifications may still be made to the technical solutions described in the foregoing embodiments or equivalent replacements may still be made to some technical features thereof, without departing from the scope of the technical solutions of embodiments of this application.

## Claims

1. An electronic device (100), comprising a foldable apparatus (10) and a flexible display (20), wherein
the foldable apparatus (10) comprises a first housing (1), a second housing (2), and a foldable assembly (3), wherein the foldable assembly (3) is connected to the first housing (1) and the second housing (2);
a part that is of the flexible display (20) and that corresponds to the first housing (1) is fastened to the first housing (1), a part that is of the flexible display (20) and that corresponds to the second housing (2) is fastened to the second housing (2), and a part that is of the flexible display (20) and that corresponds to the foldable assembly (3) deforms in a process in which the first housing (1) and the second housing (2) are unfolded relative to each other or folded relative to each other;
the foldable assembly (3) comprises a main shaft (31), a mounting bracket (322), a rotation arm (321), a first connection arm (323), and a second connection arm (324);
a first end (3211) of the rotation arm (321) is rotatably connected to the main shaft (31), and a second end (3212) of the rotation arm (321) is fastened to the first housing (1);
the mounting bracket (322) is fastened to the second housing (2);
a first end (3231) of the first connection arm (323) is rotatably connected to the main shaft (31), and a second end (3232) of the first connection arm (323) is slidably connected to the mounting bracket (322); and
a first end (3241) of the second connection arm (324) is rotatably connected to the main shaft (31), a rotation center of the first end (3241) of the second connection arm (324) does not coincide with a rotation center of the first end (3231) of the first connection arm (323), and a second end (3242) of the second connection arm (324) is slidably connected to or rotatably connected to the mounting bracket (322).

2. The electronic device (100) according to claim 1, wherein the foldable assembly (3) further comprises a synchronization assembly (327), and the synchronization assembly (327) is engaged with the first end (3211) of the rotation arm (321) and is engaged with the first end (3231) of the first connection arm (323).

3. The electronic device (100) according to claim 2, wherein the first end (3211) of the rotation arm (321) is provided with a connection gear (321a), the synchronization assembly (327) comprises a first synchronization gear (3271) and a second synchronization gear (3272), the first synchronization gear (3271) is engaged with the connection gear (321a), in a thickness direction of the main shaft (31), the first synchronization gear (3271) is located on a side that is of the connection gear (321a) and that is opposite to the flexible display (20), and the second synchronization gear (3272) is engaged with the first synchronization gear (3271) and the first end (3231) of the first connection arm (323).

4. The electronic device (100) according to claim 3, wherein the connection gear (321a) is an incomplete gear, and the connection gear (321a) comprises a support surface (321f) and a tooth part (321e) that are disposed opposite to each other;
when the first housing (1) and the second housing (2) are unfolded relative to each other to an unfolded state, the tooth part (321e) of the connection gear (321a) faces the first synchronization gear (3271) and is located in the main shaft (31), and the support surface (321f) of the connection gear (321a) is flush with a support surface (314) of the main shaft (31); and
when the first housing (1) and the second housing (2) are folded relative to each other to a folded state, the connection gear (321a) rotates relative to the main shaft (31), a part of the tooth part (321e) of the connection gear (321a) rotates out of the main shaft (31), and the support surface (321f) of the connection gear (321a) faces the flexible display (20).

5. The electronic device (100) according to claim 4, wherein in a width direction of the main shaft (31), a rotation center of the first synchronization gear (3271) is away from the second synchronization gear (3272) relative to a rotation center of the connection gear (321a), and the width direction of the main shaft (31) is perpendicular to the thickness direction of the main shaft (31) and is perpendicular to an extension direction of the main shaft (31).

6. The electronic device (100) according to any one of claims 3 to 5, wherein the first end (3211) of the rotation arm (321) is further provided with an arc-shaped arm (321c), the arc-shaped arm (321c) is fastened to a side of the connection gear (321a), a central axis of the arc-shaped arm (321c) is collinear with a central axis of the connection gear (321a), and the arc-shaped arm (321c) is mounted in an arc-shaped groove of the main shaft (31), to rotatably connect the main shaft (31).

7. The electronic device (100) according to any one of claims 1 to 6, wherein the rotation center of the first end (3241) of the second connection arm (324) is closer to the flexible display (20) than the rotation center of the first end (3231) of the first connection arm (323).

8. The electronic device (100) according to any one of claims 1 to 7, wherein when the second end (3242) of the second connection arm (324) is slidably connected to the mounting bracket (322), a direction in which the second end (3242) of the second connection arm (324) slides relative to the mounting bracket (322) is not parallel to a direction in which the second end (3232) of the first connection arm (323) slides relative to the mounting bracket (322).

9. The electronic device (100) according to claim 8, wherein the mounting bracket (322) has a first surface (322a), a second surface (322b), a third surface (322c), and a fourth surface (322d), the first surface (322a) and the second surface (322b) are disposed opposite to each other, the first surface (322a) is located between the flexible display (20) and the second surface (322b), the third surface (322c) and the fourth surface (322d) are disposed opposite to each other, and the third surface (322c) is located between the main shaft (31) and the fourth surface (322d);
the mounting bracket (322) comprises a first sliding slot (3221) and a second sliding slot (3222), an extension direction of the second sliding slot (3222) is not parallel to an extension direction of the first sliding slot (3221), openings at two ends of the first sliding slot (3221) are respectively located on the first surface (322a) and the second surface (322b), and openings at two ends of the second sliding slot (3222) are respectively located on the third surface (322c) and the fourth surface (322d);
a sliding block at the second end (3232) of the first connection arm (323) is mounted in the first sliding slot (3221) and is capable of sliding relative to the mounting bracket (322) in the extension direction of the first sliding slot (3221); and
a sliding block at the second end (3242) of the second connection arm (324) is mounted in the second sliding slot (3222) and is capable of sliding relative to the mounting bracket (322) in the extension direction of the second sliding slot (3222).

10. The electronic device (100) according to claim 8 or 9, wherein the foldable assembly (3) further comprises a connection rod (325), one end of the connection rod (325) is rotatably connected to the first connection arm (323), and the other end of the connection rod (325) is rotatably connected to the second connection arm (324).

11. The electronic device (100) according to any one of claims 1 to 8, wherein the foldable assembly (3) further comprises a support plate (35), the support plate (35) is connected to the mounting bracket (322), and the support plate (35) is further connected to the first connection arm (323) or the second connection arm (324);
when the first housing (1) and the second housing (2) are unfolded relative to each other to the unfolded state, the first housing (1), the main shaft (31), the support plate (35), and the second housing (2) jointly support the flexible display (20); and
the support plate (35) comprises a first end (35a) close to the main shaft (31) and a second end (35b) away from the main shaft (31), when the first housing (1) and the second housing (2) are folded relative to each other to the folded state, a distance between the first end (35a) of the support plate (35) and the first housing (1) is greater than a distance between the second end (35b) of the support plate (35) and the first housing (1), to form an accommodation space (30) between the support plate (35) and the first housing (1), and the flexible display (20) is at least partially accommodated in the accommodation space (30).

12. The electronic device (100) according to claim 11, wherein the mounting bracket (322) has a first surface (322a), and the first surface (322a) is disposed facing the support plate (35);
when the first housing (1) and the second housing (2) are unfolded relative to each other to the unfolded state, a first included angle is formed between the first surface (322a) and the support plate (35), and a distance between the support plate (35) and an end that is of the first surface (322a) and that is close to the main shaft (31) is greater than a distance between the support plate (35) and an end that is of the first surface (322a) and that is away from the main shaft (31); and
when the first housing (1) and the second housing (2) are folded relative to each other to the folded state, the support plate (35) rotates relative to the mounting bracket (322) and approaches the first surface (322a), a second included angle is formed between the first surface (322a) and the support plate (35), and the second included angle is less than the first included angle.

13. The electronic device (100) according to claim 12, wherein the mounting bracket (322) further has a first rotation groove (3224), and the first rotation groove (3224) is an arc-shaped groove and extends from the first surface (322a) into the mounting bracket (322);
the support plate (35) comprises a plate body (352) and a first rotation block (353), the plate body (352) is configured to support the flexible display (20) when the first housing (1) and the second housing (2) are unfolded relative to each other to the unfolded state, the first rotation block (353) is fastened to a side that is of the plate body (352) and that is opposite to the flexible display (20), and an arc-shaped arm of the first rotation block (353) extends from the plate body (352) in a direction away from the main shaft (31); and
the arc-shaped arm of the first rotation block (353) is mounted in the first rotation groove (3224), in a process in which the first housing (1) and the second housing (2) are unfolded relative to each other, a part of the arc-shaped arm of the first rotation block (353) rotates out of the first rotation groove (3224), and in a process in which the first housing (1) and the second housing (2) are folded relative to each other, a part of the arc-shaped arm of the first rotation block (353) rotates into the first rotation groove (3224).

14. The electronic device (100) according to claim 11, wherein the flexible display (20) comprises a first part (201), a second part (202), and a third part (203), the third part (203) is connected between the first part (201) and the second part (202), the first part (201) is fastened to the first housing (1), and the second part (202) is fastened to the second housing (2); and
when the first housing (1) and the second housing (2) are folded relative to each other to the folded state, the third part (203) is at least partially accommodated in the accommodation space (30), and a middle part of the third part (203) is offset in a direction toward the second housing (2).

15. The electronic device (100) according to claim 14, wherein the third part (203) comprises a first segment (2031), a second segment (2032), a third segment (2033), and a fourth segment (2034) that are sequentially connected, the first segment (2031) is connected to the first part (201), and the fourth segment (2034) is connected to the second part (202); and
when the first housing (1) and the second housing (2) are folded relative to each other to the folded state, the second segment (2032) and the fourth segment (2034) are curved segments, and the second segment (2032) and the third segment (2033) are offset in a direction toward the second housing (2).

16. The electronic device (100) according to claim 15, wherein the flexible display (20) comprises a flexible display panel (20a) and a bearing plate (20b), the bearing plate (20b) is fastened to a non-display side of the flexible display panel (20a), and stiffness of the bearing plate (20b) is greater than stiffness of the flexible display panel (20a); and
the bearing plate (20b) comprises a first plate part (20b-1) located on the first segment (2031), a second plate part (20b-2) located on the second segment (2032), a third plate part (20b-3) located on the third segment (2033), and a fourth plate part (20b-4) located on the fourth segment (2034), and stiffness of the first plate part (20b-1) and the third plate part (20b-3) is greater than stiffness of the second plate part (20b-2) and the fourth plate part (20b-4).

17. The electronic device (100) according to claim 16, wherein the second plate part (20b-2) is provided with at least one groove or at least one through hole; or
a thickness of the second plate part (20b-2) is less than a thickness of the first plate part (20b-1).

18. The electronic device (100) according to any one of claims 15 to 17, wherein the first segment (2031) is fastened to the first housing (1), the second segment (2032) is not fastened to the main shaft (31), and the third segment (2033) is fastened to the support plate (35).

19. The electronic device (100) according to any one of claims 1 to 18, wherein the main shaft (31) comprises an outer surface (3140) opposite to the flexible display (20);
when the first housing (1) and the second housing (2) are unfolded relative to each other to the unfolded state, the first housing (1) and the second housing (2) are spliced and jointly shield the outer surface (3140) of the main shaft (31); and
when the first housing (1) and the second housing (2) are folded relative to each other to the folded state, a part of the outer surface (3140) of the main shaft (31) is exposed relative to the first housing (1) and the second housing (2), and edges on two sides of the outer surface (3140) of the main shaft (31) are shielded by the first housing (1) and the second housing (2).

20. The electronic device (100) according to claim 19, wherein the first housing (1) comprises a first end surface (13) close to the main shaft (31), and the second housing (2) comprises a second end surface (23) close to the main shaft (31);
when the first housing (1) and the second housing (2) are unfolded relative to each other to the unfolded state, the first end surface (13) faces the second end surface (23); and
when the first housing (1) and the second housing (2) are folded relative to each other to the folded state, orientations of the first end surface (13) and the second end surface (23) are the same, and in the thickness direction of the main shaft (31), a distance between the first end surface (13) and the outer surface (3140) of the main shaft (31) is greater than a distance between the second end surface (23) and the outer surface (3140) of the main shaft (31).

21. The electronic device (100) according to any one of claims 1 to 20, wherein the electronic device (100) further comprises a third housing (4) and a second foldable assembly (5), the second foldable assembly (5) is connected to a side that is of the first housing (1) and that is away from the second housing (2), the second foldable assembly (5) is further connected to the third housing (4), and when the electronic device (100) is in the folded state, the first housing (1) is located between the third housing (4) and the second housing (2);
a part that is of the flexible display (20) and that corresponds to the third housing (4) is fastened to the third housing (4), and a part that is of the flexible display (20) and that corresponds to the second foldable assembly (5) deforms in a process in which the first housing (1) and the third housing (4) are unfolded relative to each other or folded relative to each other;
when the electronic device (100) is in the unfolded state, the flexible display (20) is located on a same side of the first housing (1), the second housing (2), and the third housing (4), and the first housing (1), the second housing (2), and the third housing (4) jointly support the flexible display (20); and
when the electronic device (100) is in the folded state, in a direction from the third housing (4) to the second housing (2), the part that is of the flexible display (20) and that corresponds to the third housing (4), the third housing (4), the first housing (1), the part that is of the flexible display (20) and that corresponds to the first housing (1), the part that is of the flexible display (20) and that corresponds to the second housing (2), and the second housing (2) are sequentially stacked.

22. A foldable assembly (3), wherein the foldable assembly (3) is used in a foldable electronic device (100), and the foldable assembly (3) is configured to connect a first housing (1) and a second housing (2) of the electronic device (100), to jointly bear a flexible display (20) of the electronic device (100);
the foldable assembly (3) comprises a main shaft (31), a mounting bracket (322), a rotation arm (321), a first connection arm (323), and a second connection arm (324);
a first end (3211) of the rotation arm (321) is rotatably connected to the main shaft (31), and a second end (3212) of the rotation arm (321) is fastened to the first housing (1);
the mounting bracket (322) is configured to be fastened to the second housing (2);
a first end (3231) of the first connection arm (323) is rotatably connected to the main shaft (31) around a first axis, and a second end (3232) of the first connection arm (323) is slidably connected to the mounting bracket (322); and
a first end (3241) of the second connection arm (324) is rotatably connected to the main shaft (31) around a second axis, a second end (3242) of the second connection arm (324) is slidably connected to or rotatably connected to the mounting bracket (322), and the second axis does not coincide with the first axis.

23. The foldable assembly (3) according to claim 22, wherein the foldable assembly (3) further comprises a synchronization assembly (327), and the synchronization assembly (327) is engaged with the first end (3211) of the rotation arm (321) and is engaged with the first end (3231) of the first connection arm (323).

24. The foldable assembly (3) according to claim 23, wherein the first end (3211) of the rotation arm (321) is provided with a connection gear (321a), the synchronization assembly (327) comprises a first synchronization gear (3271) and a second synchronization gear (3272), the first synchronization gear (3271) is engaged with the connection gear (321a), in a thickness direction of the main shaft (31), the first synchronization gear (3271) is located on a side that is of the connection gear (321a) and that is opposite to a support surface (314) of the main shaft (31), and the second synchronization gear (3272) is engaged with the first synchronization gear (3271) and the first end (3231) of the first connection arm (323).

25. The foldable assembly (3) according to claim 24, wherein the connection gear (321a) is an incomplete gear, and the connection gear (321a) comprises a support surface (321f) and a tooth part (321e) that are disposed opposite to each other;
when the first housing (1) and the second housing (2) are unfolded relative to each other to an unfolded state, the tooth part (321e) of the connection gear (321a) faces the first synchronization gear (3271) and is located in the main shaft (31), and the support surface (321f) of the connection gear (321a) is flush with the support surface (314) of the main shaft (31); and
when the first housing (1) and the second housing (2) are folded relative to each other to a folded state, the connection gear (321a) rotates relative to the main shaft (31), and a part of the tooth part (321e) of the connection gear (321a) rotates out of the main shaft (31).

26. The foldable assembly (3) according to claim 25, wherein in a width direction of the main shaft (31), a rotation center of the first synchronization gear (3271) is away from the second synchronization gear (3272) relative to a rotation center of the connection gear (321a), and the width direction of the main shaft (31) is perpendicular to the thickness direction of the main shaft (31) and is perpendicular to an extension direction of the main shaft (31).

27. The foldable assembly (3) according to any one of claims 24 to 26, wherein the first end (3211) of the rotation arm (321) is further provided with an arc-shaped arm (321c), the arc-shaped arm (321c) is fastened to a side of the connection gear (321a), a central axis of the arc-shaped arm (321c) is collinear with a central axis of the connection gear (321a), and the arc-shaped arm (321c) is mounted in an arc-shaped groove of the main shaft (31), to rotatably connect the main shaft (31).

28. The foldable assembly (3) according to any one of claims 22 to 27, wherein a rotation center of the first end (3241) of the second connection arm (324) is closer to the flexible display (20) of the electronic device (100) than a rotation center of the first end (3231) of the first connection arm (323).

29. The foldable assembly (3) according to any one of claims 22 to 28, wherein when the second end (3242) of the second connection arm (324) is slidably connected to the mounting bracket (322), a direction in which the second end (3242) of the second connection arm (324) slides relative to the mounting bracket (322) is not parallel to a direction in which the second end (3232) of the first connection arm (323) slides relative to the mounting bracket (322).

30. The foldable assembly (3) according to claim 29, wherein the mounting bracket (322) has a first surface (322a), a second surface (322b), a third surface (322c), and a fourth surface (322d), the first surface (322a) and the second surface (322b) are disposed opposite to each other, the first surface (322a) is located between the flexible display (20) of the electronic device (100) and the second surface (322b), the third surface (322c) and the fourth surface (322d) are disposed opposite to each other, and the third surface (322c) is located between the main shaft (31) and the fourth surface (322d);
the mounting bracket (322) comprises a first sliding slot (3221) and a second sliding slot (3222), an extension direction of the second sliding slot (3222) is not parallel to an extension direction of the first sliding slot (3221), openings at two ends of the first sliding slot (3221) are respectively located on the first surface (322a) and the second surface (322b), and openings at two ends of the second sliding slot (3222) are respectively located on the third surface (322c) and the fourth surface (322d);
a sliding block at the second end (3232) of the first connection arm (323) is mounted in the first sliding slot (3221) and is capable of sliding relative to the mounting bracket (322) in the extension direction of the first sliding slot (3221); and
a sliding block at the second end (3242) of the second connection arm (324) is mounted in the second sliding slot (3222) and is capable of sliding relative to the mounting bracket (322) in the extension direction of the second sliding slot (3222).

31. The foldable assembly (3) according to claim 29 or 30, wherein the foldable assembly (3) further comprises a connection rod (325), one end of the connection rod (325) is rotatably connected to the first connection arm (323), and the other end of the connection rod (325) is rotatably connected to the second connection arm (324).

32. The foldable assembly (3) according to any one of claims 22 to 29, wherein the foldable assembly (3) further comprises a support plate (35), the support plate (35) is connected to the mounting bracket (322), and the support plate (35) is further connected to the first connection arm (323) or the second connection arm (324);
when the first housing (1) and the second housing (2) are unfolded relative to each other to the unfolded state, the first housing (1), the main shaft (31), the support plate (35), and the second housing (2) jointly support the flexible display (20) of the electronic device (100); and
the support plate (35) comprises a first end (35a) close to the main shaft (31) and a second end (35b) away from the main shaft (31), when the first housing (1) and the second housing (2) are folded relative to each other to the folded state, a distance between the first end (35a) of the support plate (35) and the first housing (1) is greater than a distance between the second end (35b) of the support plate (35) and the first housing (1), to form an accommodation space (30) between the support plate (35) and the first housing (1), and the flexible display (20) of the electronic device (100) is at least partially accommodated in the accommodation space (30).

33. The foldable assembly (3) according to claim 32, wherein the mounting bracket (322) has a first surface (322a), and the first surface (322a) is disposed facing the support plate (35);
when the first housing (1) and the second housing (2) are unfolded relative to each other to the unfolded state, a first included angle is formed between the first surface (322a) and the support plate (35), and a distance between the support plate (35) and an end that is of the first surface (322a) and that is close to the main shaft (31) is greater than a distance between the support plate (35) and an end that is of the first surface (322a) and that is away from the main shaft (31); and
when the first housing (1) and the second housing (2) are folded relative to each other to the folded state, the support plate (35) rotates relative to the mounting bracket (322) and approaches the first surface (322a), a second included angle is formed between the first surface (322a) and the support plate (35), and the second included angle is less than the first included angle.

34. The foldable assembly (3) according to claim 33, wherein the mounting bracket (322) further has a first rotation groove (3224), and the first rotation groove (3224) is an arc-shaped groove and extends from the first surface (322a) into the mounting bracket (322);
the support plate (35) comprises a plate body (352) and a first rotation block (353), the plate body (352) is configured to support the flexible display (20) when the first housing (1) and the second housing (2) are unfolded relative to each other to the unfolded state, the first rotation block (353) is fastened to a side that is of the plate body (352) and that is opposite to the flexible display (20), and an arc-shaped arm of the first rotation block (353) extends from the plate body (352) in a direction away from the main shaft (31); and
the arc-shaped arm of the first rotation block (353) is mounted in the first rotation groove (3224), in a process in which the first housing (1) and the second housing (2) are unfolded relative to each other, a part of the arc-shaped arm of the first rotation block (353) rotates out of the first rotation groove (3224), and in a process in which the first housing (1) and the second housing (2) are folded relative to each other, a part of the arc-shaped arm of the first rotation block (353) rotates into the first rotation groove (3224).
